# EUROPÄISCHE PATENTSCHRIFT

(11) **EP 3 078 089 B1**
(45) Veröffentlichungstag und Bekanntmachung des Hinweises auf die Patenterteilung: **03.07.2019**
(21) Anmeldenummer: 14805628.6
(22) Anmeldetag: 02.12.2014
(51) Int. Cl.: H01S 5/022, H01L 33/58, C03B 23/20, C03B 23/02, H01L 33/00, H01L 23/00, H01S 5/40, H01L 33/56

(54) **VERFAHREN ZUR HERSTELLUNG EINES DECKELSUBSTRATS UND GEHÄUSTES STRAHLUNGSEMITTIERENDES BAUELEMENT**
METHODS FOR PRODUCING A COVER SUBSTRATE, AND HOUSED RADIATION-EMITTING COMPONENT
PROCÉDÉ DE FABRICATION D'UN SUBSTRAT DE COUVERCLE ET COMPOSANT ÉMETTEUR DE RAYONNEMENT ENCAPSULÉ

(30) Priorität: 03.12.2013 DE 102013113364; 06.02.2014 DE 102014202220
(43) Veröffentlichungstag der Anmeldung: 12.10.2016
(73) Patentinhaber: Fraunhofer-Gesellschaft zur Förderung der angewandten Forschung e.V., 80686 München (DE)
(72) Erfinder: REINERT, Wolfgang, 24594 Nindorf (DE); QUENZER, Hans Joachim, 25524 Itzehoe (DE)
(74) Vertreter: Hersina, Günter
(86) Internationale Anmeldenummer: PCT/EP2014/076271
(87) Internationale Veröffentlichungsnummer: WO 2015/082477

(56) Entgegenhaltungen:
- WO-A1-01/38240
- WO-A1-2008/087022
- DE-A1-102007 046 348
- JP-A- H05 129 712
- US-A1- 2009 294 789
- US-A1- 2011 317 397

## Beschreibung

Die vorliegende Erfindung bezieht sich auf Verfahren zur Herstellung eines Deckelsubstrats, ein Verfahren zur Herstellung eines gehäusten strahlungsemittierenden Bauelementes auf Waferebene und auf ein gehäustes strahlungsemittierendes Bauelement, das nach einem solchen Verfahren hergestellt ist. Beispielsweise soll ein Verkappungskonzept für Laserdioden und Herstellungsverfahren auf Waferebene mit integriertem vertikalem optischen Fenster geschaffen werden.

Blaue und grüne Laserdioden finden immer breitere Einsatzfelder. Etabliert und weitverbreitet ist die Verwendung blauer Laserdioden als entscheidende Komponente beim Auslesen hochdichter optischer Speichermedien (Blue Ray). Inzwischen zeichnen sich vielfältige weitere Anwendungen leistungsstarker blauer und grüner Laserdioden ab, wie etwa als RGB-Quellen in mobilen Bild- und Videoprojektionen.

Sowohl grüne als auch blaue Laserdioden sollten immer hermetisch dicht in einem Gehäuse verpackt werden. Möglich ist, derartige Laserdioden mit einer Verkappungstechnologie mit speziellen TO-Headern (TO 38) mit integriertem optischem Fenster und Kupferwärmesenke zu verkappen.

Neben den genannten Consumer-Anwendungen gibt es im Feld der Industriebeleuchtungen und dort speziell bei UV-Aushärteleuchten ebenfalls einen Bedarf an hermetisch verkapselten UV-Leuchtdioden (keine Laserdioden) mit besonders guter Wärmeabfuhr und organik-freiem Gehäuse, um die erforderlichen hohen Lebensdauern zu garantieren.

Die DE 10 2007 046348 A1 bezieht sich auf ein strahlungsemittierendes Bauelement mit Glasabdeckung und ein Verfahren zu dessen Herstellung (siehe Zusammenfassung).

Die WO 2008/087022 A1 bezieht sich auf Gehäuse für in mobilen Anwendungen eingesetzte mikromechanische und mikrooptische Bauelemente (DE-Zusammenfassung).

Die US 2009/294789 A1 bezieht sich auf ein lichtemittierendes Bauelement und ein Verfahren zum Herstellen des lichtemittierenden Bauelements. Das lichtemittierende Bauelement umfasst ein lichtemittierendes Element, das Licht emittiert, ein erstes Substrat, auf dem das lichtemittierende Element befestigt ist, ein zweites Substrat, das einen abgedichteten Zwischenraum für das lichtemittierende Element zwischen dem ersten Substrat und dem zweiten Substrat bildet, und ein Lichtaustrittsfenster, das einen Lichtaustritt, das von dem lichtemittierenden Element emittiert wird, ermöglicht.

Die Erfindung offenbart Verfahren zur Herstellung von strukturierten Deckelsubstraten gemäß den Patentansprüchen 1, 5, 8, 10 und 11, sowie ein gehäustes strahlungsemittierendes Bauelement gemäß Patentanspruch 13. Besondere Ausführungsformen der Erfindung sind in den abhängigen Patentansprüchen angegeben. Gegenstand in der Beschreibung der nicht Teil der Ansprüche ist, ist kein Teil der vorliegenden Erfindung und dient nur der unterstützenden Darstellung.

Die Aufgabe der vorliegenden Erfindung besteht deshalb darin, verbesserte Verfahren zur Herstellung eines Deckelsubstrats zur Verkappung von strahlungsemittierenden Bauelementen bereitzustellen, und dementsprechend gehäuste strahlungsemittierende Bauelemente, die verbesserte Eigenschaften aufweisen, zu schaffen.

So soll erreicht werden, dass die gehäusten strahlungsemittierenden Bauelemente eine lange Lebensdauer bei gleichbleibend guter Strahl- und Leistungsqualität aufweisen. Insbesondere soll eine Beschädigung der Laserfassetten bei Einwirkung von Wasserdampf und flüchtiger organischer Komponenten unter Einwirkung der extrem intensiven und energiereichen Laserstrahlung verringert oder verhindert werden. Zudem sollen die Herstellungskosten gesenkt und die Wärmeabfuhr aus dem Gehäuse verbessert werden.

Die Aufgabe wird durch den Gegenstand der unabhängigen Ansprüche gelöst. Vorteilhafte Ausgestaltungen der vorliegenden Anmeldung sind Gegenstand der abhängigen Patentansprüche.

Der vorliegenden Erfindung basiert auf der Erkenntnis, dass ein verbessertes gehäustes strahlungsemittierendes Bauelement besonders vorteilhaft auf Waferebene hergestellt werden kann. Nutzt man ein Formsubstrat zum Ausformen von Deckelsubstraten mittels Glasfließverfahren, können Fensterbauelemente in ein Deckelsubstrat integriert werden, womit man empfindliche Strahlungsquellen anschließend hermetisch dicht verkappen kann.

Entsprechend verbesserte Herstellungsverfahren können erzielt werden, indem in einem Verfahren zur Herstellung eines Deckelsubstrats erste Inselbereiche und jeweils zugeordnete, benachbarte zweite Inselbereiche aus einem Formsubstrat gebildet werden, wobei zwischen den ersten Inselbereichen und den jeweils zugeordneten, benachbarten zweiten Inselbereichen eine Vertiefung vorgesehen ist und ein Fensterbauelement jeweils in der Vertiefung zwischen dem ersten Inselbereichen und dem zugeordneten, benachbarten zweiten Inselbereich angeordnet wird.

So wird ein erstes Verfahren zur Herstellung eines Deckelsubstrats mit den folgenden Schritten geschaffen: Bereitstellen eines Formsubstrats mit einem strukturierten Oberflächenbereich, Anordnen eines Abdeckungssubstrats auf dem strukturierten Oberflächenbereich des Formsubstrats, wobei das Abdeckungssubstrat ein Glasmaterial aufweist, und Verbinden des Abdeckungssubstrats mit dem Formsubstrat, wobei die strukturierte Oberfläche des Formsubstrats mit einer Oberfläche des Abdeckungssubstrats mindestens teilweise überdeckend zusammengeführt wird, Bilden von ersten Inselbereichen und jeweils zugeordneten, benachbarten zweiten Inselbereichen aus dem Formsubstrat, wobei zwischen den ersten Inselbereichen und den jeweils zugeordneten, benachbarten zweiten Inselbereichen eine Vertiefung vorgesehen ist, Anordnen eines Fensterbauelements jeweils in der Vertiefung zwischen dem ersten Inselbereich und dem zugeordneten, benachbarten zweiten Inselbereich, Anordnen eines Trägersubstrats auf den ersten Inselbereichen und den zweiten Inselbereichen, die aus dem Formsubstrat gebildet sind, sodass die ersten Inselbereiche und die zweiten Inselbereiche sich zwischen dem Trägersubstrat und dem Abdeckungssubstrat befinden, Tempern der verbundenen Substrate derart, dass ein Hineinfließen des Glasmaterials des Abdeckungssubstrats in die verbleibenden Vertiefungen zwischen den Inselbereichen bewirkt wird, und Entfernen des Abdeckungssubstrats von dem Formsubstrat und dem Trägersubstrat, um das strukturierte Deckelsubstrat zu erhalten.

Ein dazu alternatives Verfahren zur Herstellung eines Deckelsubstrats umfasst folgende Schritte: Bereitstellen eines Form-Substrats mit einem strukturierten Oberflächenbereich; Anordnen eines Trägersubstrats auf dem strukturierten Oberflächenbereich des Form-Substrats, und Verbinden des Trägersubstrats mit dem Form-Substrat, wobei die strukturierte Oberfläche des Form-Substrats mit einer Oberfläche des Trägersubstrats mindestens teilweise überdeckend zusammengeführt wird; Bilden von ersten Inselbereichen und jeweils zugeordneten, benachbarten zweiten Inselbereichen aus dem Form-Substrat, wobei zwischen den ersten Inselbereichen und den jeweils zugeordneten, benachbarten zweiten Inselbereichen eine Vertiefung vorgesehen ist; Anordnen eines Fensterbauelements in der Vertiefung zwischen einem ersten Inselbereich und dem zugeordneten, benachbarten zweiten Inselbereich; Anordnen eines Abdeckungssubstrats auf den ersten Inselbereichen und den zweiten Inselbereichen, die aus dem Form-Substrat gebildet sind, so dass die ersten Inselbereiche und die zweiten Inselbereiche sich zwischen dem Trägersubstrat und dem Abdeckungssubstrat befinden, wobei das Abdeckungssubstrat ein Glasmaterial aufweist; Tempern der verbundenen Substrate derart, dass ein Hineinfließen des Glasmaterials des Abdeckungssubstrats in die verbleibenden Vertiefungen zwischen den Inselbereichen bewirkt wird; und Entfernen des Abdeckungssubstrats von dem Form-Substrat und dem Trägersubstrat, um das strukturierte Deckelsubstrat zu erhalten.

Unter Entfernen versteht man im Sinne der Erfindung das (mechanische) Trennen oder das selektive Ab- bzw. Wegätzen des Halbleitermaterials, beispielsweise des Siliziums, von dem Formsubstrat.

Ferner wird ein zweites Verfahren zur Herstellung eines Deckelsubstrats mit folgenden Schritten geschaffen: Bereitstellen eines wiederverwendbaren Werkzeugs als Formsubstrat, Bilden von ersten Inselbereichen und jeweils zugeordneten, benachbarten zweiten Inselbereichen an einer Oberfläche des wiederverwendbaren Werkzeugs, das als Negativstruktur für eine Deckelstruktur wirksam ist, wobei zwischen den ersten Inselbereichen und den jeweils zugeordneten, benachbarten zweiten Inselbereichen eine Vertiefung in dem wiederverwendbaren Werkzeug vorgesehen ist, Anordnen eines Fensterbauelements auf dem wiederverwendbaren Werkzeug jeweils in der Vertiefung zwischen dem ersten Inselbereich und dem zugeordneten, benachbarten zweiten Inselbereich, Anordnen eines Abdeckungssubstrats auf den Inselbereichen des wiederverwendbaren Werkzeugs, wobei das Abdeckungssubstrat ein Glasmaterial aufweist, wobei die Oberfläche des wiederverwendbaren Werkzeugs mit einer Oberfläche des Abdeckungssubstrats mindestens teilweise überdeckend zusammengeführt wird, Tempern der verbundenen Substrate derart, dass ein Hineinfließen des Glasmaterials des Abdeckungssubstrats in die Vertiefungen zwischen den Inselbereichen bewirkt wird, und Trennen des Abdeckungssubstrats von dem Formsubstrat, um das strukturierte Deckelsubstrat zu erhalten.

Zudem wird ein drittes Verfahren zur Herstellung eines Deckelsubstrats mit folgenden Schritten geschaffen: Bereitstellen eines Form-Substrats mit einem strukturierten Oberflächenbereich, Anordnen eines Abdeckungssubstrats auf dem strukturierten Oberflächenbereich des Form-Substrats, wobei das Abdeckungssubstrat ein Glasmaterial aufweist, und Verbinden des Abdeckungssubstrats mit dem Form-Substrat, wobei die strukturierte Oberfläche des Form-Substrats mit einer Oberfläche des Abdeckungssubstrats mindestens teilweise überdeckend zusammengeführt wird, Bilden von ersten Inselbereichen und jeweils zugeordneten, benachbarten zweiten Inselbereichen aus dem Form-Substrat, wobei zwischen den ersten Inselbereichen und den jeweils zugeordneten, benachbarten zweiten Inselbereichen eine Vertiefung vorgesehen ist, Anordnen von Halbleiterstreifen jeweils in der Vertiefung zwischen einem ersten Inselbereich und dem zugeordneten, benachbarten zweiten Inselbereich, so dass die Halbleiterstreifen mit einer ihrer Oberflächen jeweils seitliche Oberflächen der Inselbereiche senkrecht zum Abdeckungssubstrat mindestens teilweise abdecken, und Halbleiterstreifen sich hinsichtlich der Vertiefung gegenüberliegen und zwischen den Halbleiterstreifen ein Abstand ausgebildet ist, der einer verbleibenden Vertiefung entspricht, Anordnen eines Trägersubstrats auf den ersten Inselbereichen und den zweiten Inselbereichen, die aus dem Form-Substrat gebildet sind, so dass die ersten Inselbereiche und die zweiten Inselbereiche sich zwischen dem Trägersubstrat und dem Abdeckungssubstrat befinden, Tempern der verbundenen Substrate derart, dass ein Hineinfließen des Glasmaterials des Abdeckungssubstrats in die verbleibenden Vertiefungen zwischen den Inselbereichen bewirkt wird, und Entfernen des Abdeckungssubstrats von dem Form-Substrat und dem Trägersubstrat, um das strukturierte Deckelsubstrat zu erhalten.

Ein gehäustes strahlungsemittierendes Bauelement kann dementsprechend nach einem Verfahren zur Herstellung eines gehäusten strahlungsemittierenden Bauelements auf Waferebene mit folgenden Schritten geschaffen werden: Herstellen eines Deckelsubstrats, Bereitstellen eines Bauelementesubstrats in Form eines Wafers mit einer Vielzahl von strahlungsemittierenden Bauelementen, Anordnen der Substrate aufeinander, sodass die Substrate entlang eines zwischengeschalteten Verbindungsrahmens verbunden werden, und Vereinzeln der gehäusten strahlungsemittierenden Bauelemente.

Im Sinne der Erfindung wird ein Form-Substrat mit einem topographisch strukturierten Oberflächenbereich bereitgestellt. Das bedeutet, dass ein Oberflächenbereich des Formsubstrats einen oder mehrere Vorsprünge aufweist, so dass der Oberflächenbereich über seine gesamte Ausdehnung betrachtet uneben ist, also eine Topographie aufweist. Das Form-Substrat kann somit als Negativ-3D-Maske für das Deckelsubstrats dienen.

Im Sinne der Erfindung sind Inselbereiche Erhöhungen auf dem Oberflächenbereich, also Vorsprünge. Erste Inselbereiche sind dafür eingerichtet, Vorsprünge für Kavitäten für ein strahlungsemittierendes Bauelement in dem Deckelsubstrat auszubilden, während der benachbarte zweite Inselbereich dafür eingerichtet ist, einen Hohlraum für eine Vereinzelungsstraße zu bilden, bzw. dazu dient, später die elektrischen Anschlusspads im Gehäuse freilegen zu können. Eine Vertiefung im Sinne der Erfindung ist ein Zwischenbereich zwischen einem ersten Inselbereich und einem benachbarten, zugeordneten zweiten Inselbereich.

Unter Tempern versteht man im Sinne der Erfindung ein Temperaturbehandeln, beispielsweise ein Erhitzen. Ein Glasmaterial im Sinne der Erfindung ist ein amorpher anorganischer Werkstoff, bei dem sich die Viskosität bei steigender Temperatur kontinuierlich verringert. Ein niedrigschmelzendes Glasmaterial hat somit im Sinne dieser Erfindung bei gleicher Temperatur eine niedrigere Viskosität als ein höherschmelzendes Glas.

Entsprechend beschreibt die Erfindung ein Verfahren einer Aufbau- und Verbindungstechnik für das hermetisch dichte Verpacken von strahlungsemittierenden Bauelementen, also beispielsweise Laserdioden oder LEDs, das mit WLP-IVA (wafer level packages - with integrated vertical optical apertures) bezeichnet werden kann. Vorteilhaft kann dabei insbesondere das optische Fenster sein, das integraler Bestandteil der Kappe ist und eine laterale Strahlauskopplung erlaubt. Die Montage der Laserdioden kann beispielsweise auf einem Halbleiterwafer, beispielsweise einem Siliziumwafer, erfolgen und der Verkappungsprozess kann für alle montierten Bauelemente zusammen durch Aufbonden eines weiteren Glas- oder Halbleiterwafers mit Glaselementen erfolgen. Erst danach erfolgt das Trennen bzw. Vereinzeln in einzelne Chips, genauer in einzelne Gehäuse.

Die Herstellung des Kappen- oder Deckelwafers, auch als Deckelsubstrat bezeichnet, der die vertikalen optischen Fensterflächen aus Glas für eine Vielzahl von Gehäusen beinhaltet, stellt ein völlig neuartiges Herstellungsverfahren dar. Das Verfahren basiert wesentlich auf Techniken des sogenannten Glasfließens (vgl. [1] bis [7]). In Ausführungsformen handelt es sich bei dem Glasmaterial des Abdeckungssubstrats um Borofloat®-Glas oder ein anderes niedrigschmelzendes Glas. Der thermische Ausdehnungskoeffizient (CTE = coefficient of thermal expansion) der Glasmaterialien sollte zum verwendeten Halbleitermaterial passen, da sowohl die Herstellung des Deckelwafers als auch das Bonden des Deckelwafers auf einem Halbleitermaterial, beispielsweise auf einem Siliziumsubstrat, erfolgen, was ansonsten zu sehr großen thermomechanischen Spannungen oder zur Zerstörung der beteiligten Elemente führen würde, wenn der CTE nicht an das Halbleitermaterial angepasst ist. Angepasst bedeutet dabei, dass das CTE des Glasmaterials in Ausführungsformen nicht um mehr als 1 - 2 ppm/C° von dem CTE des Halbleitermaterials abweicht. In Ausführungsformen weicht das CTE des Glasmaterials um weniger als 0,5 ppm/C° von dem CTE des Halbleitermaterials ab. Eine mögliche Prozessabfolge bei der Herstellung dieser Deckelwafer mit integrierten vertikalen optischen Fensterflächen wird später anhand der Figuren beschrieben. Als Fensterelemente mit vertikalen optischen Fensterflächen werden beispielsweise solche Fensterelemente angesehen, deren (optisch wirksamen) Seitenflächen eine vertikales Seitenfenster einer Deckelanordnung für ein Strahlungs- bzw. Lichtemittierendes Bauelement bilden bzw. die sich i.W. senkrecht zu einer Mittelachse einer lateralen Strahlauskopplung erstrecken.

Der oben beschriebene Prozess nach dem ersten und dem dritten Verfahren nutzt letztlich Halbleiterstrukturen, beispielsweise Siliziumstrukturen, als verlorene Form, um das Glas zu formen. Grundsätzlich lassen sich jedoch auch Formen (wiederverwendbare Werkzeuge) so herstellen, die viele Male genutzt werden können, um den Deckelwafer zu prozessieren. Hierzu kommen natürlich lediglich Materialien oder Beschichtungen in Frage, die nicht mit dem Glas eine innige Verbindung eingehen und die sich leicht wieder vom Glas trennen lassen. Dazu kann eine Grundform aus einem wiederverwendbaren Werkzeug hergestellt werden, wie es gemäß dem zweiten Verfahren vorgeschlagen ist. Es wird auch als WLP-ILOW I bezeichnet. Ganz analog zum ersten Verfahren können dabei Glasstreifen, also streifenförmige Fensterbauelemente, in die Strukturen eingelegt werden, beispielsweise indem sie um 90° um ihre Längsachse gedreht werden, so dass Oberflächen der Fensterbauelemente, die als Oberflächen von optischen Auskoppelfenstern vorgesehen sind, Oberflächen der Inselbereiche, die aus dem Formsubstrat gebildet sind, gegenüberliegen. Anschließend wird ein Glaswafer aufgelegt, der ganze Aufbau erhitzt und schließlich mittels Druck, beispielsweise Unterdruck, in die wiederverwendbare Form gezogen. Dazu werden in der wiederverwendbaren Form zuvor geeignete Zugänge und Kanäle geschaffen, die ein vollständiges Entfernen der Luft zwischen Glaswafer und Form sicherstellen. Anschließend wird der Glaswafer mit den eingebetteten Glasstreifen von der Form abgehoben und getrennt. Beispielsweise kann das wiederverwendbare Werkzeug aus Graphit bestehen. Alternativ zu einer Form, die vollständig aus Graphit besteht, kommen auch andere Materialien für die Herstellung einer solchen Form prinzipiell in Frage, unter anderem temperaturfeste Stähle und Keramiken (SIC, Glaskohlenstoff), insbesondere dann, wenn diese Formen zusätzlich mit einer Beschichtung versehen werden, die ein Ankleben der Glasmasse verhindert (z.B. Graphit oder besser noch Bornitrid (BN)). Durch Aufbringen einer solchen glasabweisenden Schutzschicht kann grundsätzlich auch eine solche wiederverwendbare Form aus Silizium gefertigt werden.

In Ausführungsformen der Erfindung nach dem zweiten Verfahren ist vorgesehen, dass das Tempern folgenden Schritt umfasst: Anlegen eines Unterdrucks an die verbundenen Substrate, um das Glasmaterial in die verbleibenden Vertiefungen zwischen den Inselbereichen hineinzuziehen. Alternativ ist das Anlegen eines pneumatischen oder mechanischen Drucks aufseiten der aufliegenden Glasplatte, respektive des Glaswafers, möglich. Idealerweise sollten die Vakuumanschlüsse und Kanäle so angeordnet werden, dass sie das Glas, das sicherlich, wenn auch oberflächlich, in diese Strukturen hineinfließt, nicht beeinträchtigen. So sollte insbesondere vermieden werden, dass sich Erhebungen im Bereich des Bondrahmens bilden. Deswegen bietet es sich an, die Vakuumzuführungen in die Inselstrukturen des wiederverwendbaren Werkzeugs zu integrieren und um eine bessere Absaugung der verbliebenen Gaseinschlüsse zu erleichtern, zusätzlich schmale Kanäle in die Oberfläche dieser Inselstrukturen einzubringen.

Die Erfindung stellt zudem ein gehäustes strahlungsemittierendes Bauelement, mit folgenden Merkmalen bereit: Einem an einem Bauelementesubstrat angeordneten strahlungsemittierendes Bauelement und einem Deckelsubstrat, das eine hermetisch abgedichtete Kavität für das strahlungsemittierende Bauelement bereitstellt, innerhalb welchem das strahlungsemittierende Bauelement gehäust ist, wobei das Deckelsubstrat in einer Seitenfläche ein optisches Auskoppelfenster aus einem für die Strahlung des strahlungsemittierenden Bauelements durchlässigen Material aufweist, wobei das optische Auskoppelfenster des Deckelsubstrats und das strahlungsemittierende Bauelement derart zueinander angeordnet sind, dass die im Betrieb des strahlungsemittierenden Bauelements emittierte Strahlung das Gehäuse in einer Abstrahlrichtung parallel zur Oberfläche des Bauelementesubstrats und/oder senkrecht zu der Seitenfläche des Deckelsubstrats verlässt.

Die Erfindung stellt weiterhin eine Waferanordnung mit einer Vielzahl von gehäusten strahlungsemittierenden Bauelementen mit folgenden Merkmalen bereit: Einem Bauelementesubstrat in Form eines Wafers, der als gemeinsames Bauelementesubstrat für die daran angeordneten strahlungsemittierenden Bauelemente ausbildet ist und einem gemeinsamen Deckelsubstrat, das die Deckelsubstrate für die strahlungsemittierende Bauelement aufweist, wobei die Substrate so aneinander geordnet sind, dass das Deckelsubstrat und das Bauelementesubstrat entlang eines dazwischenliegenden Bondrahmens verbunden sind.

Gemäß einem Ausführungsbeispiel umfasst das erste Verfahren hinsichtlich des Bereitstellens des Formsubstrats folgende Schritte: Bereitstellen eines Halbleiterwafers mit einer Passivierungsschicht auf einer Oberfläche, Lithographieren der Passivierungsschicht, sodass die Passivierungsschicht dort auf der Oberfläche verbleibt, wo die ersten Inselbereiche und die zweiten Inselbereiche vorgesehen sind, Ätzen der Oberfläche des Halbleiterwafers hinsichtlich der lithographierten Bereiche, sodass eine Dicke des Halbleiterwafers senkrecht zu den lithographierten Bereichen der Oberfläche verringert wird, um den Oberflächenbereich zu strukturieren und somit Positionen für die ersten Inselbereiche und die zweiten Inselbereiche vorzugeben und vollständiges Entfernen der Passivierungssicht. Das kann den Vorteil haben, dass ein Formsubstrat mit einem zweckmäßig strukturierten Oberflächenbereich auf einfache Weise bereitgestellt werden kann. Beispielsweise ist der Halbleiterwafer ein Siliziumwafer. Der Halbleiterwafer kann mit einer KOH-festen Passivierung beschichtet werden, beispielsweise aus LP-Nitrid. Anschließend wird die Lithographie durchgeführt, wobei lediglich die ersten und zweiten Inselbereiche ungeätzt bleiben. Die Passivierung wird durch Plasmaätzen geöffnet. Die lithographierten Bereiche können durch anisotropes nasschemisches Ätzen, beispielsweise mit KOH bearbeitet werden, sodass die Oberfläche des Halbleiterwafers hinsichtlich der lithographierten Bereiche geätzt wird. Schließlich wird die Passivierungsschicht beispielsweise dadurch vollständig entfernt, dass sie abgeätzt wird.

Gemäß einem Ausführungsbeispiel des ersten Verfahrens ist vorgesehen, dass das Verfahren bei dem Anordnen und Verbinden des Abdeckungssubstrats folgenden Schritt umfasst: Bereichsweises anodisches Bonden des strukturierten Oberflächenbereichs des Formsubstrats mit einem Oberflächenbereich des Abdeckungssubstrats. Ein Glaswafer, der als Abdeckungssubstrat geeignet ist, kann beispielsweise aus Pyrex oder aus Borofloat® 33 bestehen oder diese Glasmaterialien zumindest umfassen. Derartige Glasmaterialien können den Vorteil haben, dass sie besonders gut in Glasfließprozessen verwendet werden können.

Das Einsägen der Strukturen kann beispielsweise durch das so genannte Cap-Dicing erfolgen. Gemäß einem Ausführungsbeispiel des ersten Verfahrens kann dementsprechend zudem vorgesehen sein, dass das Bilden von Inselbereichen aus dem Formsubstrat zusätzlich die Schritte umfasst: Einsägen der ersten und zweiten Inselbereiche in dem Formsubstrat nach dem bereichsweisen anodischen Bonden und Entfernen jener Abschnitte des Formsubstrats, die nach dem Sägen von den gebondeten Bereichen getrennt sind. Anschließend werden dann die Streifen zwischen den Inseln entfernt. Dies ist dann sehr einfach möglich, da die Oberflächenbereiche des Formsubstrats, die mit dem Abdeckungssubstrat fest verbunden sind, gegenüber den herausgesägten Streifen freibeweglich sind.

Unabhängig davon, ob es sich um ein Ausführungsbeispiel der Erfindung gemäß des ersten Verfahrens oder des zweiten Verfahrens handelt, kann vorgesehen sein, dass das Anordnen jeweils des Fensterbauelements zusätzlich folgende Schritte umfasst: Bereitstellen mehrerer streifenförmiger Fensterbauelemente und Einlegen der streifenförmigen Fensterbauelemente in die Vertiefungen zwischen den ersten Inselbereichen und den zweiten Inselbereichen, sodass Oberflächen der Fensterbauelemente, die als Oberflächen von optischen Auskoppelfenstern vorgesehen sind, Oberflächen der Inselbereiche, die aus dem Formsubstrat gebildet sind, gegenüberliegen. Dies entspricht einer Nutzung der Halbleiter- oder Graphitstrukturen wie ein Steckbrett, sodass die Fensterflächen genau in die Strukturen, die die Inselbereiche bilden, passen. Die seitlichen Inseln dienen also als Anschläge.

Gemäß der Erfindung ist in Ausführungsformen vorgesehen, dass das Bereitstellen von streifenförmigen Fensterbauelementen zusätzlich folgende Schritte umfasst: Bereitstellen eines Fensterbauelementwafers und Zuschneiden der streifenförmigen Fensterbauelemente aus dem Fensterbauelementwafer. Beispielsweise kann das bedeuten, Streifen des eigentlichen Fenstermaterials zuzuschneiden, beispielsweise zu sägen. Bei dem Fenstermaterial, also den Fensterbauelementen, handelt es sich in Ausführungsformen um höher schmelzendes Glas, beispielsweise solches mit im Vergleich zum Abdeckungswafer identischem thermischem Ausdehnungskoeffizient wie "AF 32"® (Schott) oder "Eagle XG"® (Corning®). Das Fensterbauelement kann um 90° zur Seite um seine Längsachse gedreht werden. Anschließend kann das Bestücken mit den Fensterbauelementen erfolgen. Anstelle eines höher schmelzenden Glases bzw. Glasmaterials kann auch Borofloat®-Glas (niedrigschmelzendes Glas) eingesetzt werden, das durch zwei Siliziumauflagen in dessen Form gehalten wird. Statt Siliziumauflagen können auch ganz allgemein Halbleiterauflagen verwendet werden.

Entsprechend sind Ausführungsformen für Verfahren gemäß der Erfindung vorgesehen, dass das Anordnen des jeweiligen Fensterbauelements folgenden Schritt umfasst: Einlegen von Siliziumstreifen in die Vertiefungen vor dem Einlegen der streifenförmigen Fensterbauelemente in die Vertiefungen, sodass die Siliziumstreifen zwischen Oberflächen der Fensterbauelemente, die als Oberflächen von optischen Auskoppelfenstern vorgesehen sind, und Flächen der Inselbereiche, die aus dem Formsubstrat gebildet sind, angeordnet sind. Ebenfalls kann vorgesehen sein, dass das Anordnen des jeweiligen Fensterbauelements den Schritt umfasst: Bereitstellen von einem oder mehreren mit Halbleitermaterial beschichteten streifenförmigen Fensterelementen. Bei dem Bereitstellen von einem mit Halbleitermaterial beschichteten Fensterelement kann der Schritt vorgesehen sein: Beschichten von Oberflächen des Fensterbauelements durch Aufbonden von Siliziumstreifen. Statt Siliziumstreifen können allgemein Halbleiterstreifen verwendet werden. Dementsprechend gibt es unterschiedliche Möglichkeiten, geeignete Fensterbauelemente für die erfindungsgemäßen Verfahren bereitzustellen. Bei der Verwendung von strukturierten SI-Glas-SI-Elementen aus Borofloat®-Glas, also wenn Siliziumglasstrukturen zum Einsatz kommen, ist es besonders zweckmäßig, den Siliziuminsel- (= spätere Kavität) SI-Streifen so zu strukturieren, dass das Silizium lediglich in diesem Bereich verbleibt. Anderenfalls, also bei der Verwendung von unstrukturiertem SI-Glas-SI-Elementen aus Borofloat®-Glas durchschneidet dieser unstrukturierte Siliziumstreifen auch die Seitenflächen des Glasgehäuses. Diese Siliziumstrukturen, sofern als Halbleitermaterial Silizium verwendet wird, würden beim Ätzen der anderen Siliziumstrukturen ebenfalls geätzt und ebenfalls entweder komplett oder teilweise entfernt. In jenem Fall wäre mit dem ersten Verfahren die Herstellung eines Glasdeckelwafers für den Aufbau unversehrter Glasgehäuse nicht möglich.

Allerdings ist vorstellbar, dass durch zusätzliche Bearbeitungsschritte nach dem Tempern der verbundenen Substrate diese kritischen Bereiche gegenüber dem Ätzen geschützt werden könnten. Dazu sollte die Dicke des Siliziumstreifens, oder allgemein Halbleiterstreifens, dünn gewählt werden (beispielsweise ca. 200 µm, zum Beispiel zwischen 150 µm und 250 µm) und das untere Halbleitersubstrat, also das Trägersubstrat, das beispielsweise ebenfalls aus Silizium bestehen oder Silizium umfassen kann, zunächst durch Grinden bis auf die Ebene der Glas- und Halbleiteransätze mechanisch entfernt werden. Anschließend könnten die besonders kritischen Areale im Bereich des Bondrahmens durch eine geeignete Passivierung geschützt werden. Anschließend würde das Halbleitermaterial, beispielsweise das Silizium, im Bereich der Kavitäten, Pads und sonstigen Stützstrukturen weggeätzt, und das Halbleitermaterial, zum Beispiel das Silizium, das die Seitenwände durchschneiden könnte, trotzdem erhalten bleiben. Da dennoch das Halbleitermaterial, beispielsweise Silizium, in der Seitenwand angegriffen wird, empfiehlt es sich die Dicke des Halbleiterstreifens so dünn wie möglich zu halten, um ein Durchätzen durch die Seitenwand zu verhindern.

Eine mögliche Alternative zu dieser Passivierungsvariante ist es, die aufgebondeten Halbleiterstrukturen, beispielsweise Siliziumstrukturen so zu strukturieren (Kammform), dass diese während des Temperprozesses, in Bereiche außerhalb der Kavitäten (gleich den optischen Fensterflächen) nicht mit der Oberfläche des aufgelegten Halbleiterwafers, also des Trägersubstrats, in Kontakt kommen. Damit kann erreicht werden, dass der Bodenbereich des eigentlichen Glasgehäuses komplett aus Glas besteht. Gemäß dem oben Beschriebenen können auch zwei parallele Siliziumstreifen, oder allgemeiner Halbleiterstreifen, zur Definition der Fensterflächen verwendet werden. Auch dies ist in den Figuren gezeigt.

Gemäß einem Ausführungsbeispiel der Erfindung ist vorgesehen, dass das Anordnen des Fensterbauelements folgenden Schritt umfasst: Zuschneiden jeweils von streifenförmigen Fensterbauelementen aus einem Linsenarray. Auf diese Weise kann anstelle eines ebenen Fensters der Einbau optischer Linsen aus Glas erlaubt werden. Grundsätzlich lässt sich anstelle eines einfachen ebenen Fensters auch ein Linsenelement in das Glas des Gehäuses einbetten. Diese Linsenfunktion könnte entweder aus einer Reihe von Linsen (d.h. lineares Linsenarray) oder einer einzelnen Zylinderlinse bestehen, wenn diese parallel zur Ausrichtung des Glasstreifens orientiert ist. Im Unterschied zu den ebenen Glaselementen, die für die Herstellung der ebenen Glasfenster eingesetzt werden, ist es allerdings erforderlich, zusätzlich die nicht planen Seiten der Linsen durch ein zusätzliches Schutzelement aus einem Halbleitermaterial, beispielsweise Silizium, gegen den direkten Kontakt mit der Glasmasse zu schützen. Diese Schutzstruktur überbrückt auf der einen Seite die Linsenoberfläche und sorgt auf der anderen Seite für eine möglichst gute Passung mit den auf dem Glaswafer platzierten Halbleiterstrukturen, zum Beispiel Siliziumstrukturen, um auch hier ein unkontrolliertes Hineinfließen des Glases in diesen Spalt zu vermeiden.

Am einfachsten lassen sich solche Linsenarray-Halbleiterelemente durch die Technik des Glasfließens ausformen, wenn ein höher schmelzendes Glas (z.B. "AF 32"®, "Eagle XG"®) mit einem an Silizium bzw. Borofloat®-Glas angepassten thermischen Ausdehnungskoeffizienten verwendet wird. Grundsätzlich ist diese Technik auch unter der Verwendung von bikonvexen oder bikonkaven Linsen möglich. In diesem Fall werden beide Seiten der Linsen durch entsprechende Halbleiterstrukturen gegen den direkten Kontakt mit dem Glas geschützt. Wie dies im Einzelnen ausgeführt werden kann, ist in den Figuren gezeigt und wird später beschrieben.

Bei einem Verfahren zur Herstellung eines gehäusten strahlungsemittierenden Bauelements auf Waferebene ist gemäß einem Ausführungsbeispiel vorgesehen, dass das Verfahren zusätzlich folgende Schritte umfasst: Herstellen des Deckelsubstrats gemäß dem ersten Verfahren und Vereinzeln der gehäusten strahlungsemittierenden Bauelemente, wobei durch die zweiten Inseln in dem Deckelsubstrat eine Vereinzelungsstraße gebildet worden ist. Durch paralleles Einsägen in die Vereinzelungsstraße können die Bereiche über Anschlusspads freigelegt werden, die in Ausführungsformen auf einem Bauelementesubstrat bereitgestellt sind. Dabei werden auch die Bereiche der äußeren Fensterflächen zugänglich gemacht. Die Streifen, die durch das Einsägen zwischen den beiden Sägeschnitten entstehen, lösen sich während des Sägens vollständig ab. In diesem Stadium können noch auf Waferebene elektrische Tests auf einem Waferprober durchgeführt werden. Anschließend und abschließend erfolgt das Vereinzeln des Trägersubstrats, also des Bauelementesubstrats, durch Sägen entlang der Vereinzelungsstraße. Es wird also die gleiche Vereinzelungsstraße zum Durchsägen der Deckelwafer verwendet, die auch zum Durchsägen des Bauelementesubstrats verwendet wird.

Bei einem Verfahren zur Herstellung eines gehäusten strahlungsemittierenden Bauelementes auf Waferebene ist gemäß einem Ausführungsbeispiel ebenfalls vorgesehen, dass das Anordnen der Substrate unter einer vorgegebenen Atmosphäre erfolgt. So kann sichergestellt werden, dass das Gehäuse völlig frei von organischen Substanzen ist, sodass die Lebensdauer der Leuchtdioden, beispielsweise der Laserdioden, nicht beeinträchtigt wird. In der Kavität befindet sich vorzugsweise trockene Luft, Stickstoff oder eine andere Art inerte Atmosphäre, aber auch ein Unterdruck oder gar ein vollständiges Vakuum kann prinzipiell eingestellt werden und zusätzlich durch Einbringung besonderer Getterschichten auch über lange Zeiträume erhalten werden.

In einigen Ausführungsformen ist das gehäuste strahlungsemittierende Bauelement derart ausgeführt, dass das Bauelementesubstrat als ein Gehäusesockel und als eine Lagerfläche für das strahlungsemittierende Bauelement dient, wobei das Deckelsubstrat mit dem Gehäusesockel zusammenwirkt, um die Kavität des Gehäuses hermetisch abzudichten.

In einigen Ausführungsformen ist das gehäuste strahlungsemittierende Bauelement derart ausgeführt, dass der Gehäusesockel aus einem Sockelwafer, der mehrere Gehäusesockel umfasst, gebildet wurde und/oder das Deckelsubstrat aus einem Deckelwafer, der mehrere Deckelsubstrate umfasst, gebildet wurde.

In einigen Ausführungsformen ist das gehäuste strahlungsemittierende Bauelement derart ausgeführt, dass das Deckelsubstrat einen oder mehrere ebene Wandabschnitte als Seitenfläche aufweist, so dass entweder ein ebener Wandabschnitt das optische Auskoppelfenster aufweist oder aber das optische Auskoppelfenster einen ebenen Wandabschnitt des Deckelsubstrats bildet.

In einigen Ausführungsformen ist das gehäuste strahlungsemittierende Bauelement derart ausgeführt, dass das optische Auskoppelfenster mit dem Deckelsubstrat stoffschlüssig oder einstückig verbunden ist.

In einigen Ausführungsformen ist das gehäuste strahlungsemittierende Bauelement derart ausgeführt, dass zwischen dem Bauelementesubstrat und dem strahlungsemittierenden Bauelement ein Zwischenträger für das strahlungsemittierende Bauelement angeordnet ist, so dass das Bauelementesubstrat das strahlungsemittierende Bauelement mittelbar trägt.

In einigen Ausführungsformen ist das gehäuste strahlungsemittierende Bauelement derart ausgeführt, dass das Bauelementesubstrat und das Deckelsubstrat mittels eines Bondrahmens, der ein metallisches Lotmaterial aufweist, aneinander befestigt sind.

In einigen Ausführungsformen ist das gehäuste strahlungsemittierende Bauelement derart ausgeführt, dass das optische Auskoppelfenster aus einem ersten Glasmaterial gebildet ist und das Deckelsubstrat aus einem zweiten Glasmaterial gebildet ist, und wobei das zweite Glasmaterial eine niedrigere Viskosität aufweist als das erste Glasmaterial.

In einigen Ausführungsformen ist das gehäuste strahlungsemittierende Bauelement derart ausgeführt, dass eine Leiterbahn zum elektrischen Anbinden des strahlungsemittierenden Bauelements seitens des Bauelementesubstrats angeordnet ist und die Leiterbahn zwischen dem Deckelsubstrat und dem Bauelementesubstrat aus der Kavität herausgeführt ist.

In einigen Ausführungsformen ist das gehäuste strahlungsemittierende Bauelement derart ausgeführt, dass dem optischen Auskoppelfenster seitens des Bauelementesubstrats eine optische Bank vorgelagert ist, so dass das optische Auskoppelfenster zwischen der optischen Bank und dem strahlungsemittierendem Bauelement angeordnet ist.

In einigen Ausführungsformen ist das gehäuste strahlungsemittierende Bauelement derart ausgeführt, dass die optische Bank auf dem Bauelementesubstrat angeordnet ist und sich in der Abstrahlrichtung des strahlungsemittierenden Bauelements befindet.

In einigen Ausführungsformen ist das gehäuste strahlungsemittierende Bauelement derart ausgeführt, dass das optische Auskoppelfenster eine optische Linse umfasst.

In einigen Ausführungsformen ist das gehäuste strahlungsemittierende Bauelement derart ausgeführt, dass es ferner ein für eine Lichtfarbenumwandlung des emittierten Lichts wirksames Element aufweist, so dass das optische Auskoppelfenster zwischen dem wirksamen Element und dem strahlungsemittierende Bauelement angeordnet ist.

In einigen Ausführungsformen ist das gehäuste strahlungsemittierende Bauelement derart ausgeführt, dass die Kavität eine inerte Atmosphäre aufweist und/oder die Kavität ausschließlich anorganische Substanzen enthält.

In einigen Ausführungsformen ist das gehäuste strahlungsemittierende Bauelement derart ausgeführt, dass in der Kavität eine elektronische Treiberschaltung angeordnet ist.

Bevorzugte Ausführungsbeispiele der vorliegenden Anmeldung werden nachfolgend Bezug nehmend auf die beiliegenden Zeichnungen näher erläutert. Es zeigen:
- Fig. 1 a - d: ein erstes Verfahren zur Herstellung eines Deckelsubstrats;
- Fig. 2 a - b: ein zweites Verfahren zur Herstellung eines Deckelsubstrats;
- Fig. 3 a - f: mögliche Teilschritte und Alternativen des ersten Verfahrens zur Herstellung eines Deckelsubstrats anhand von Skizzen;
- Fig. 4: einen beispielhaften Glasdeckelwafer, der mit einem Form-Substrat verbunden ist, wobei der Glasdeckelwafer eingelassene Fensterbauelemente aufweist;
- Fig. 5 a - b: Detailausschnitte eines beispielhaften Glasdeckelwafers zeigen;
- Fig. 6: einen beispielhaften Glasdeckelwafer mit Siliziumkämmen zeigt;
- Fig. 7: eine Prozessvariante veranschaulicht, bei der Siliziumstrukturen in einer Gehäusewand des Deckelsubstrats verbleiben;
- Fig. 8 a - c: eine Prozessvariante gemäß einem dritten Verfahren zeigt, bei der zwei parallele Siliziumstreifen zur Definition von Fensterflächen verwendet werden;
- Fig. 9: eine Prozessvariante zeigt, bei der optische Linsen aus Glas anstelle eines ebenen Fensterbauelements eingebaut werden;
- Fig. 10: mögliche Teilschritte eines zweiten Verfahrens zur Herstellung eines Deckelsubstrats anhand von Skizzen veranschaulicht;
- Fig. 11: unter anderem ein beispielhaftes wiederverwendbares Form-Substrat, das Vakuumkanäle aufweist, für das zweite Verfahren;
- Fig. 12: eine Skizze, die einen Teilschritt aus einem Verfahren zur Herstellung eines gehäusten strahlungsemittierenden Bauelements auf Waferebene veranschaulicht;
- Fig. 13: einen beispielhaften Wafer mit einer Vielzahl von gehäusten strahlungsemittierenden Bauelementen;
- Fig. 14: einen Ausschnitt des Wafers aus Fig. 13;
- Fig. 15 a - c: ein beispielhaftes Vereinzelungsverfahren für einen Wafer gemäß Fig. 13;
- Fig. 16 a - b: beispielhafte erste und zweite Ausführungsformen für gehäuste strahlungsemittierende Bauelemente, die mit einem erfindungsgemäßen Verfahren hergestellt worden sind;
- Fig. 17: eine dritte beispielhafte Ausführungsform für gehäuste strahlungsemittierende Bauelemente, die mit einem erfindungsgemäßen Verfahren hergestellt worden ist;
- Fig. 18 a - e: weitere beispielhafte Ausführungsformen für gehäuste strahlungsemittierende Bauelemente, die mit einem erfindungsgemäßen Verfahren hergestellt worden sind und eine optische Bank aufweisen;
- Fig. 19: eine beispielhafte Ausführungsform mit besonders vorteilhafter elektrische Kontaktierung; und
- Fig. 20: eine beispielhafte Ausführungsform mit mehreren strahlungsemittierenden Bauelementen im selben Gehäuse.

Gleiche Bezugszeichen bezeichnen gleiche oder vergleichbare Elemente auch in unterschiedlichen Ausführungsformen der Erfindung.

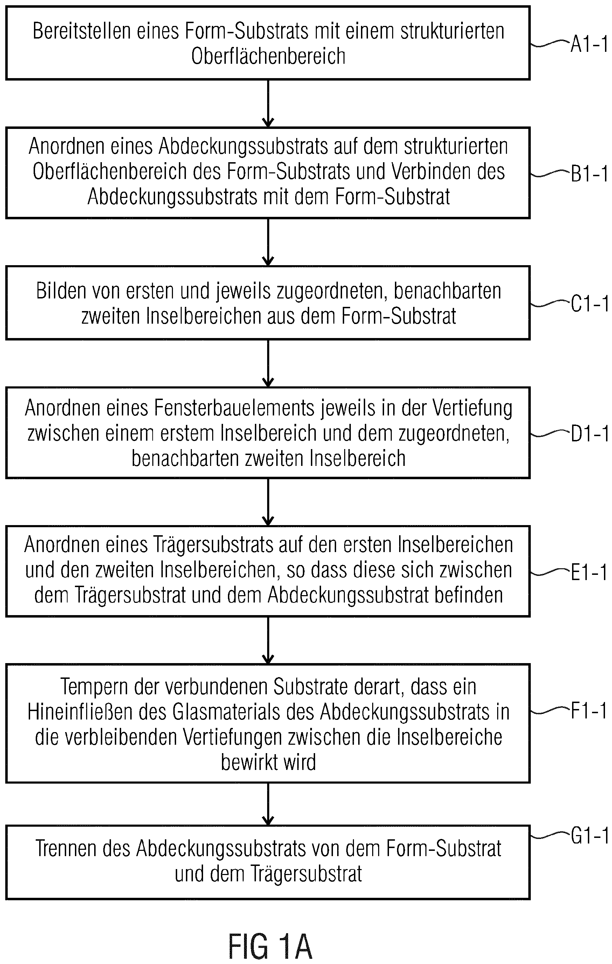

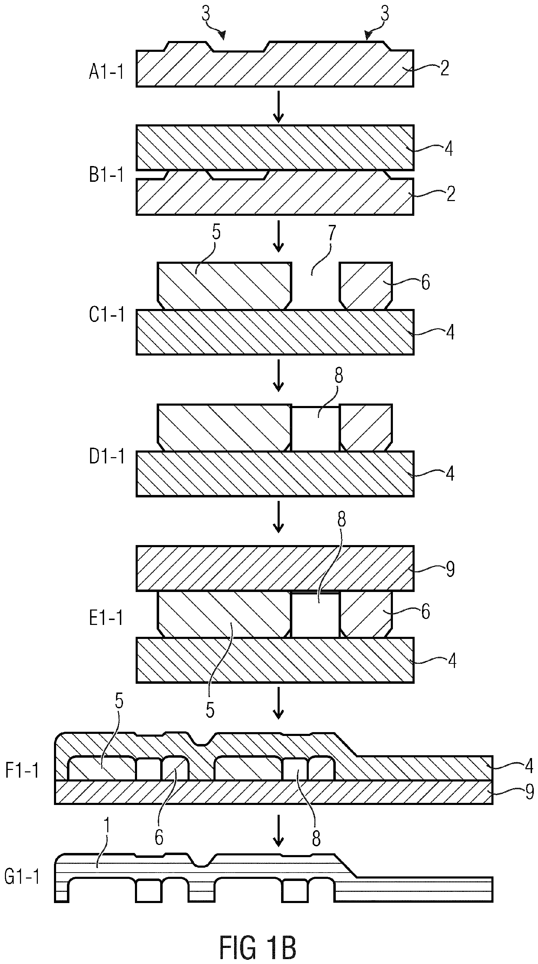

Fig. 1a zeigt ein Flussdiagramm, das anhand von Fig. 1b veranschaulicht ist, für ein erstes Verfahren zur Herstellung eines Deckelsubstrats 1. Das Deckelsubstrat 1 weist beispielsweise ein optisches Seitenfenster auf, das integraler Bestandteil der Kappe ist und eine laterale Strahlauskopplung erlaubt. Beispielsweise können auch mehrere optische Seitenfenster vorgesehen sein, die integraler Bestandteil der Kappe sind und eine laterale Strahlauskopplung in unterschiedlichen Richtungen erlauben.

Das erste Verfahren umfasst als Schritt (A1-1) das Bereitstellen eines Form-Substrats 2 mit einem strukturierten Oberflächenbereich 3. Das Form-Substrat 2 weist bei diesem Ausführungsbeispiel ein Halbleitermaterial, wie z.B. Silizium, auf. Es folgt das Anordnen eines Abdeckungssubstrats 4 auf dem strukturierten Oberflächenbereich 3 des Form-Substrats 2 (B1-1). Das Abdeckungssubstrat 4 wird im Zuge dessen mit dem Form-Substrat 2 verbunden. Dabei ist vorgesehen, dass das Abdeckungssubstrat 4 ein Glasmaterial aufweist. Im Schritt des Anordnens wird die strukturierte Oberfläche 3 des Form-Substrats 2 mit einer Oberfläche des Abdeckungssubstrats 4 mindestens teilweise überdeckend zusammengeführt. In einem weiteren Schritt (C1-1) ist das Bilden von ersten Inselbereichen 5 und jeweils zugeordneten, benachbarten zweiten Inselbereichen 6 aus dem Form-Substrat 2 vorgesehen, wobei zwischen den ersten Inselbereichen 5 und den jeweils zugeordneten, benachbarten zweiten Inselbereichen 6 eine Vertiefung bzw. Ausnehmung 7 vorgesehen ist. Dann folgt ein Anordnen eines Fensterbauelements 8 jeweils in der Vertiefung 7 zwischen erstem Inselbereich 5 und dem zugeordneten, benachbarten zweiten Inselbereich 6 (D1-1). In einem weiteren Schritt (E1-1) erfolgt ein Anordnen eines Trägersubstrats 9 auf den ersten Inselbereichen 5 und den zweiten Inselbereichen 6, die aus dem Form-Substrat 2 gebildet sind, so dass die ersten Inselbereiche 5 und die zweiten Inselbereiche 6 sich zwischen dem Trägersubstrat 9 und dem Abdeckungssubstrat 4 befinden. Es erfolgt in einem darauffolgenden Schritt (F1-1) das Tempern der verbundenen Substrate derart, dass ein Hineinfließen des Glasmaterials des Abdeckungssubstrats 4 in die verbleibenden Vertiefungen 7 zwischen den Inselbereichen 5, 6 bewirkt wird. Die Temperaturen werden dabei so gewählt, dass das höherschmelzende Glasmaterial der Fensterbauelemente 8 nicht (bzw. vernachlässigbar) beeinflusst wird, also beispielsweise eben bleibt, aber das niedriger schmelzende Glasmaterial in die Strukturen fließen kann. Um das zu unterstützen, sollte eine Druckdifferenz zwischen den Innenräumen zwischen den Substraten 4, 9 und der Umgebungsatmosphäre vorliegen. Ein Vakuum in den Innenräumen kann vorliegen, um eventuelle Lufteinschlüsse vermeiden zu können. Besonders vorteilhaft kann es sein, wenn das Hineinfließen des Glasmaterials durch eine Druckdifferenz unterstützt wird. Dazu kann der Vorgang in zwei Temperschritten ausgeführt werden, wobei im ersten Schritt der Rand des Glases des Abdeckungssubstrats 4 auf das Trägersubstrat 9 durch ein geeignetes Belastungswerkzeug während des Temperns unter Vakuum herniedergedrückt wird. Dadurch kann ein Vakuum in den Innenräumen zwischen den Substraten 4, 9 geschaffen werden. Im zweiten Temperschritt, der anschließend unter normaler Atmosphäre im Ofen erfolgen kann, wird dann die heiße Glasmasse in die Innenräume gepresst. Die vorliegende Druckdifferenz zwischen dem Vakuum in den Innenräumen und der Ofenatmosphäre unterstützt den ganzen Fließvorgang.

Neben dem oben dargestellten zweistufigen Tempervorgang, ist es auch möglich, dass eine ausreichende Erwärmung des Glasmaterials zu einer sogenannten "Kapillarbildung" an den Vertiefungen 7 führt, so dass ein Hineinfließen des Glasmaterials in die Vertiefungen 7 zwischen den Inselbereichen 5, 6 bewirkt bzw. unterstützt wird. Somit kann auch ein einstufiger Tempervorgang realisiert werden.

Schließlich wird ein Entfernen des Abdeckungssubstrats 4 von dem Form-Substrat 2 und dem Trägersubstrat 9 vorgenommen, um das strukturierte Deckelsubstrat 1 zu erhalten (G1-1). Das Entfernen kann ein Trennen oder ein selektives Abätzen des Halbleitermaterials bedeuten, z.B. in heißer Kalilauge. Auf diese Weise ist ein verbessertes Verfahren zur Herstellung eines Deckelsubstrats 1 zur Verkappung von strahlungsemittierenden Bauelementen bereitgestellt, denn das Deckelsubstrat 1, was man durch das Verfahren, wie es in Figur 1b schematisch beschrieben ist, erhält, umfasst ein optisches Auskoppelfenster, gebildet mittels des Fensterbauelements 8. In einigen Ausführungsformen sind das Abdeckungssubstrat 4 und das Fensterbauelement 8 aus unterschiedlichen Glasmaterialien gefertigt. So kann beispielsweise ein besonders geeignetes Fensterglasmaterial für das Fensterbauelement 8 gewählt werden, während das Abdeckungssubstrat 4 aus einem anderen Glasmaterial besteht, das beispielsweise mechanisch robuster sein kann. Das Glasmaterial des Abdeckungssubstrats 4 hat in einigen Ausführungsformen bei gleicher Temperatur eine deutlich niedrigere Viskosität als das Glasmaterial des Fensterbauelements 8. Das Abdeckungssubstrat 4 kann beispielsweise so als wirksame, stabile Gehäuseverkappung einen relativ größeren Gesamtglasanteil, der vorzugsweise mehr als 50% beträgt, des verfahrensgemäß strukturierten Deckelsubstrats 1 darstellen. In diesem Ausführungsbeispiel ist das Abdeckungssubstrat aus Borofloat®-Glas gefertigt. Das Fensterbauelement ist hingegen aus "Eagle XG"®-Glas gefertigt.

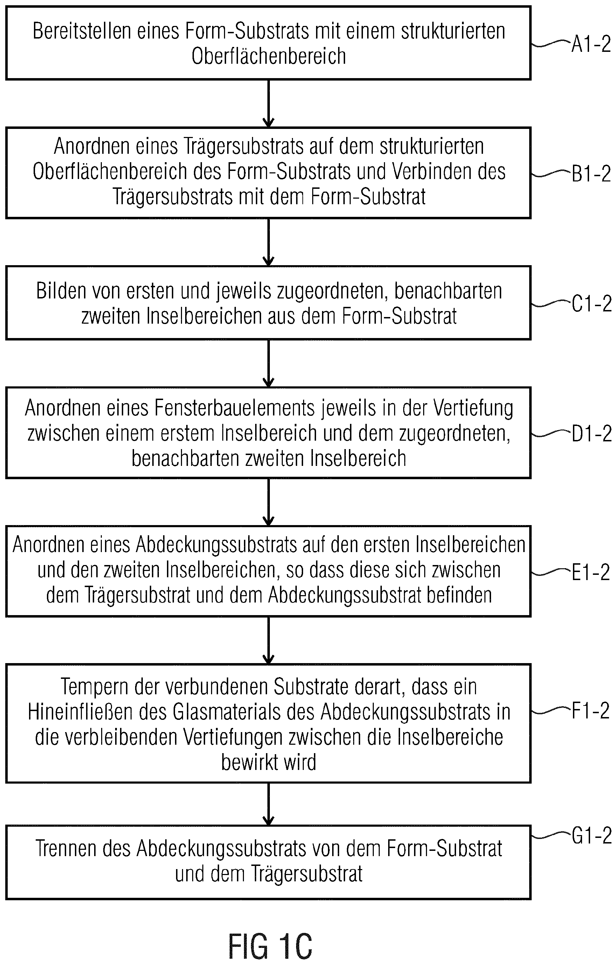

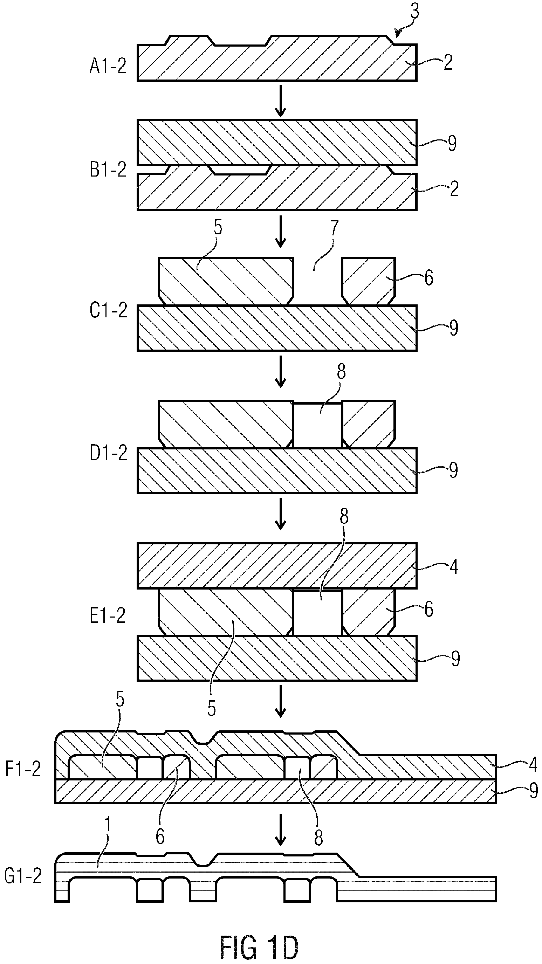

Fig. 1c zeigt ein Flussdiagramm, das anhand von Fig. 1d veranschaulicht ist, für ein alternatives Verfahren zur Herstellung eines Deckelsubstrats 1. Das Deckelsubstrat 1 weist beispielsweise ein optisches Seitenfenster auf, das integraler Bestandteil der Kappe ist und eine laterale Strahlauskopplung erlaubt. Beispielsweise können auch mehrere optische Seitenfenster vorgesehen sein, die integraler Bestandteil der Kappe sind und eine laterale Strahlauskopplung in unterschiedlichen Richtungen erlauben.

Bei dem weiteren alternativen Verfahren von Fig. 1d wird gegenüber dem in Fig. 1b dargestellten ersten Verfahren die Prozessabfolge dahin gehend umgestellt, dass zunächst das Trägersubstrat 9 an dem strukturierten Oberflächenbereich des Formsubstrats 2 angebracht bzw. mit dem verbunden wird. Dabei wird beispielsweise ein Waferbonding-Prozess verwendet, wenn sowohl das Trägersubstrat 9 als auch das Formsubstrat 2 als Halbleiterwafer (z.B. Siliziumwafer) ausgebildet ist. Nachdem dann nachfolgend die Inselbereiche 5, 6 mit den dazwischen liegenden Vertiefungen 7 gebildet sind, wird das Abdeckungssubstrat auf die an dem Trägersubstrat 9 fest angeordneten Inselbereiche 5, 6 aufgebracht.

Das weitere (alternative) Verfahren von Fig. 1d umfasst als Schritt (A1-2) das Bereitstellen eines Form-Substrats 2 mit einem strukturierten Oberflächenbereich 3. Das Form-Substrat 2 weist bei diesem Ausführungsbeispiel ein Halbleitermaterial, wie z.B. Silizium, auf. Es folgt das Anordnen eines Trägersubstrats 9 auf dem strukturierten Oberflächenbereich 3 des Form-Substrats 2 (B1-2). Das Trägersubstrat 9 wird im Zuge dessen mit dem Form-Substrat 2 verbunden. Dabei ist vorgesehen, dass das Trägersubstrat 9 ein Halbleitermaterial, wie z.B. Silizium, aufweist. Im Schritt des Anordnens wird die strukturierte Oberfläche 3 des Form-Substrats 2 mit einer Oberfläche des Trägersubstrats 9 mindestens teilweise überdeckend zusammengeführt, wobei das Form-Substrat 2 und das Trägersubstrat 9 als Halbleiterwafer (z.B. Siliziumwafer) ausgebildet sein können und bei dem Anordnen bzw. Verbinden des Form-Substrats 2 und des Trägersubstrats 9 ein sog. Waferbonding-Prozess durchgeführt werden kann.

In einem weiteren Schritt (C1-2) ist das Bilden von ersten Inselbereichen 5 und jeweils zugeordneten, benachbarten zweiten Inselbereichen 6 aus dem Form-Substrat 2 vorgesehen, wobei zwischen den ersten Inselbereichen 5 und den jeweils zugeordneten, benachbarten zweiten Inselbereichen 6 eine Vertiefung bzw. Ausnehmung 7 vorgesehen ist. Dann folgt ein Anordnen eines Fensterbauelements 8 jeweils in der Vertiefung 7 zwischen erstem Inselbereich 5 und dem zugeordneten, benachbarten zweiten Inselbereich 6 (D1-2).

In einem weiteren Schritt (E1-2) erfolgt ein Anordnen eines Abdeckungssubstrats 4 auf den ersten Inselbereichen 5 und den zweiten Inselbereichen 6, die aus dem Form-Substrat 2 gebildet sind, so dass die ersten Inselbereiche 5 und die zweiten Inselbereiche 6 sich zwischen dem Trägersubstrat 9 und dem Abdeckungssubstrat 4 befinden. Das Abdeckungssubstrat 4 weist ein Glasmaterial auf. Es erfolgt in einem darauffolgenden Schritt (F1-2) das Tempern der verbundenen Substrate derart, dass ein Hineinfließen des Glasmaterials des Abdeckungssubstrats 4 in die verbleibenden Vertiefungen bzw. Ausnehmungen 7 zwischen den Inselbereichen 5, 6 bewirkt wird. Die Temperaturen werden dabei so gewählt, dass das höherschmelzende Glasmaterial der Fensterbauelemente 8 nicht (bzw. vernachlässigbar) beeinflusst wird, also beispielsweise eben bleibt, aber das niedriger schmelzende Glasmaterial in die Strukturen "fließen" kann. Um das zu unterstützen, sollte eine Druckdifferenz zwischen den Innenräumen zwischen den Substraten 4, 9 und der Umgebungsatmosphäre vorliegen. Ein Vakuum in den Innenräumen kann vorliegen, um eventuelle Lufteinschlüsse vermeiden zu können. Besonders vorteilhaft kann es sein, wenn das Hineinfließen des Glasmaterials durch eine Druckdifferenz unterstützt wird. Dazu kann der Vorgang in zwei Temperschritten ausgeführt werden, wobei im ersten Schritt der Rand des Glases des Abdeckungssubstrats 4 auf das Trägersubstrat 9 durch ein geeignetes Belastungswerkzeug während des Temperns unter Vakuum herniedergedrückt wird. Dadurch kann ein Vakuum in den Innenräumen zwischen den Substraten 4 und 9 geschaffen werden. Im zweiten Temperschritt, der anschließend unter normaler Atmosphäre im Ofen erfolgen kann, wird dann die heiße Glasmasse in die Innenräume gepresst. Die vorliegende Druckdifferenz zwischen dem Vakuum in den Innenräumen und der Ofenatmosphäre unterstützt den ganzen Fließvorgang.

Neben dem oben dargestellten zweistufigen Tempervorgang, ist es auch möglich, dass eine ausreichende Erwärmung des Glasmaterials zu einer sogenannten "Kapillarbildung" an den Vertiefungen 7 führt, so dass ein Hineinfließen des Glasmaterials in die Vertiefungen 7 zwischen den Inselbereichen 5, 6 bewirkt bzw. unterstützt wird. Somit kann auch ein einstufiger Tempervorgang realisiert werden.

Schließlich wird ein Entfernen des Abdeckungssubstrats 4 von dem Form-Substrat 2 und dem Trägersubstrat 9 vorgenommen, um das strukturierte Deckelsubstrat 1 zu erhalten (G1-2). Das Entfernen kann ein Trennen oder ein selektives Abätzen des Halbleitermaterials bedeuten, z.B. in heißer Kalilauge. Auf diese Weise ist ein verbessertes Verfahren zur Herstellung eines Deckelsubstrats 1 zur Verkappung von strahlungsemittierenden Bauelementen bereitgestellt, denn das Deckelsubstrat 1, was man durch das Verfahren, wie es in Figur 1d schematisch beschrieben ist, erhält, umfasst ein optisches Auskoppelfenster, gebildet mittels des Fensterbauelements 8. In einigen Ausführungsformen sind das Abdeckungssubstrat 4 und das Fensterbauelement 8 aus unterschiedlichen Glasmaterialien gefertigt. So kann beispielsweise ein besonders geeignetes Fensterglasmaterial für das Fensterbauelement 8 gewählt werden, während das Abdeckungssubstrat 4 aus einem anderen Glasmaterial besteht, das beispielsweise mechanisch robuster sein kann. Das Glasmaterial des Abdeckungssubstrats 4 hat in einigen Ausführungsformen bei gleieher Temperatur eine deutlich niedrigere Viskosität als das Glasmaterial des Fensterbauelements 8. Das Abdeckungssubstrat 4 kann beispielsweise so als wirksame, stabile Gehäuseverkappung einen relativ größeren Gesamtglasanteil, der vorzugsweise mehr als 50% beträgt, des verfahrensgemäß strukturierten Deckelsubstrats 1 darstellen. In diesem Ausführungsbeispiel ist das Abdeckungssubstrat aus Borofloat®-Glas gefertigt. Das Fensterbauelement ist hingegen aus "Eagle XG"®-Glas gefertigt.

Aufgrund der festen Verbindung des Formsubstrats 2 und des Trägersubstrats 9, z.B. mittels Waferbonding, wird erreicht, dass auch die resultierenden Inselbereiche 5, 6 fest mit dem Trägersubstrat 9 verbunden sind, so dass während der weiteren Verfahrensschritte und insbesondere während des Temperns (Temperaturbehandlung) der verbundenen Substrate verhindert werden kann, dass sich die aus dem Formsubstrat 2 gebildeten Inselbereiche 5, 6 hinsichtlich des Abdeckungssubstrats 4 bzw. des Trägersubstrats 9 lateral bewegen bzw. leicht verschieben können. Damit können die resultierenden Fensterbauelemente mit äußerst hoher Präzision und damit sehr geringen Herstellungstoleranzen gefertigt werden.

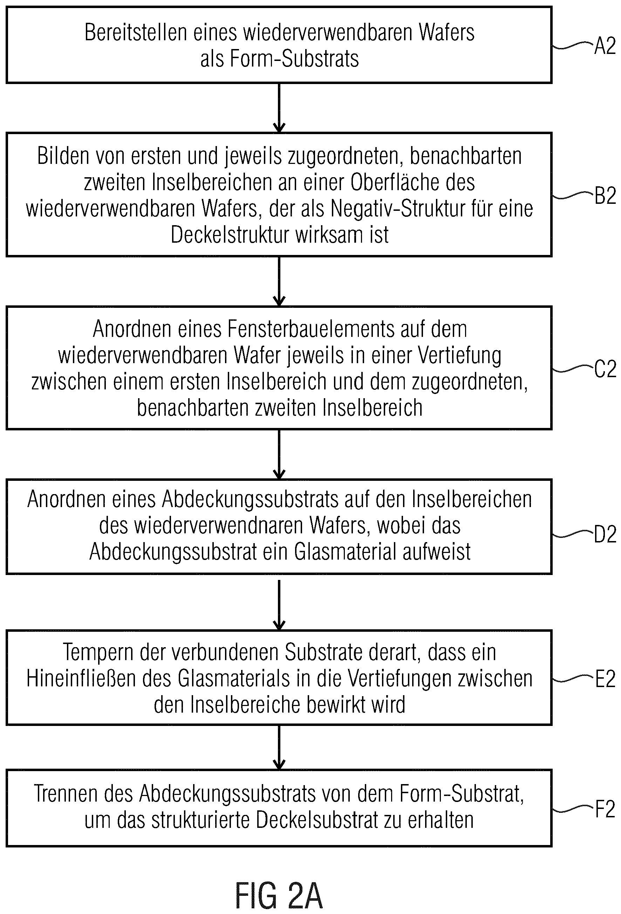

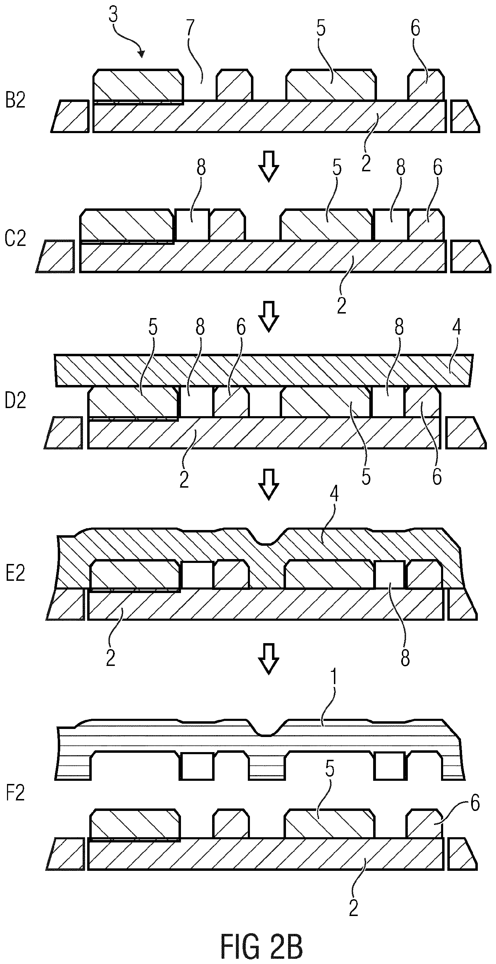

Fig. 2a zeigt ein Flussdiagramm, das anhand von Fig. 2b veranschaulicht ist, für ein zweites Verfahren zur Herstellung eines Deckelsubstrats 1. Das Deckelsubstrat 1 weist beispielsweise ein "laterales" optisches Fenster auf, das integraler Bestandteil der Kappe ist und eine laterale Strahlauskopplung erlaubt. Beispielsweise können auch mehrere "laterale" optische Fenster vorgesehen sein, die integraler Bestandteil der Kappe sind und eine laterale Strahlauskopplung in unterschiedlichen Richtungen erlauben.

Das Verfahren umfasst in einem Schritt (B2) das Bereitstellen eines wiederverwendbaren Werkzeugs als Form-Substrat 2, wobei erste Inselbereiche 5 und jeweils zugeordnete, benachbarte zweite Inselbereiche 6 an einer Oberfläche des wiederverwendbaren Werkzeugs gebildet sind/werden, das als Negativ-Struktur für eine Deckelstruktur wirksam ist (B2). Dabei ist zwischen den ersten Inselbereichen 5 und den jeweils zugeordneten, benachbarten zweiten Inselbereichen 6 eine Vertiefung 7 in dem wiederverwendbaren Werkzeug vorgesehen. Diese werden in einem weiteren Schritt genutzt. Dieser weitere Schritt (C2) umfasst nämlich das Anordnen eines Fensterbauelements 8 auf dem wiederverwendbaren Werkzeug jeweils in der Vertiefung 7 zwischen erstem Inselbereich 5 und dem zugeordneten, benachbarten zweiten Inselbereich 6. Ein weiterer Schritt (D2) ist dann das Anordnen eines Abdeckungssubstrats 4 auf den Inselbereichen 5, 6 des wiederverwendbaren Werkzeugs, wobei das Abdeckungssubstrat 4 ein Glasmaterial aufweist. In diesem Schritt wird die Oberfläche des wiederverwendbaren Wafers mit einer Oberfläche des Abdeckungssubstrats mindestens teilweise überdeckend zusammengeführt.

Es folgt mit einem weiteren Schritt (E2) ein Tempern der verbundenen Substrate derart, dass ein Hineinfließen des Glasmaterials des Abdeckungssubstrats 4 in die Vertiefungen 7 zwischen den Inselbereichen 5, 6 bewirkt wird. Schließlich erfolgt ein Trennen des Abdeckungssubstrats 4 von dem Form-Substrat 2, um das strukturierte Deckelsubstrat 1 zu erhalten (F2). Auf diese Weise ist ebenfalls ein verbessertes Verfahren zur Herstellung eines Deckelsubstrats 1 zur Verkappung von strahlungsemittierenden Bauelementen bereitgestellt, denn das Deckelsubstrat 1, was man durch das zweite Verfahren, wie es in Figur 2a und 2b schematisch beschrieben ist, erhält, umfasst ein optisches Auskoppelfenster, gebildet mittels des Fensterbauelements 8. In einigen Ausführungsformen sind das Abdeckungssubstrat 4 und das Fensterbauelement 8 aus unterschiedlichen Glasmaterialien gefertigt. So kann beispielsweise ein besonders geeignetes Fensterglasmaterial für das Fensterbauelement gewählt werden, während das Abdeckungssubstrat aus einem anderen Glasmaterial besteht, das beispielsweise mechanisch robuster sein kann. Das Abdeckungssubstrat kann beispielsweise so als wirksame, stabile Gehäuseverkappung einen relativ größeren Gesamtglasanteil, der vorzugsweise mehr als 50% beträgt, des strukturierten Deckelsubstrats darstellen. In diesem Ausführungsbeispiel ist das Abdeckungssubstrat aus Borofloat®-Glas gefertigt. Das Fensterbauelement ist hingegen aus "Eagle XG"®-Glas gefertigt.

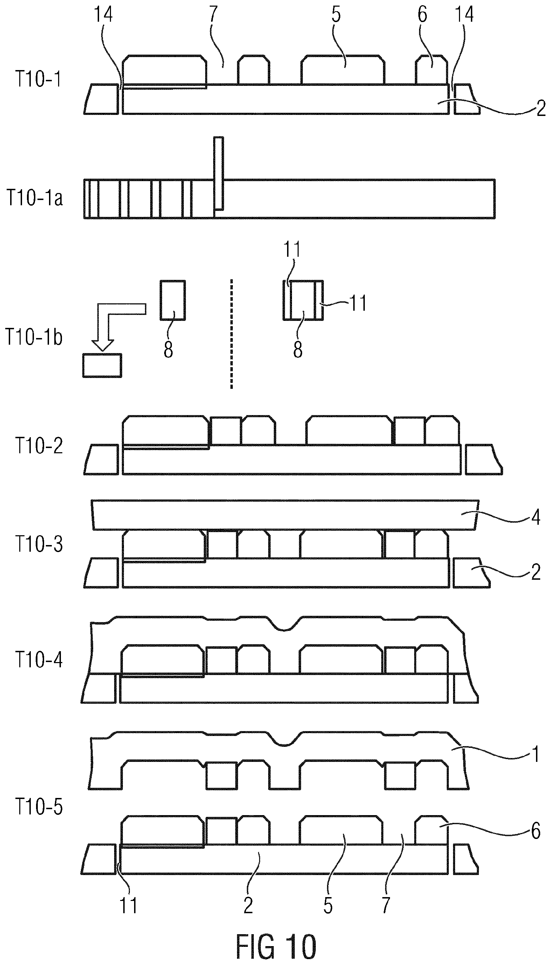

In Ausführungsformen des zweiten Verfahrens, wie es in den Figuren 2a und 2b gezeigt ist, ist als wiederverwendbares Werkzeug ein Graphitwafer vorgesehen, wie auch im vorliegenden Fall. Alternativ zu einer Form, die vollständig aus Graphit besteht, kommen auch andere Materialien für die Herstellung einer solchen Form prinzipiell in Frage, unter anderem temperaturfeste Stähle und Keramiken (beispielsweise SiC, Glaskohlenstoff oder andere), insbesondere dann, wenn diese Formen zusätzlich mit einer Beschichtung versehen werden, die ein Ankleben der Glasmasse verhindert (z.B. Graphit oder Bornitrid (BN)). Durch Aufbringen einer solchen Glas abweisenden Schutzschicht kann für ein Verfahren gemäß den Figuren 2a und 2b auch eine solche Form aus Silizium gefertigt werden. Fig. 10 zeigt Teilschritte des zweiten Verfahrens.

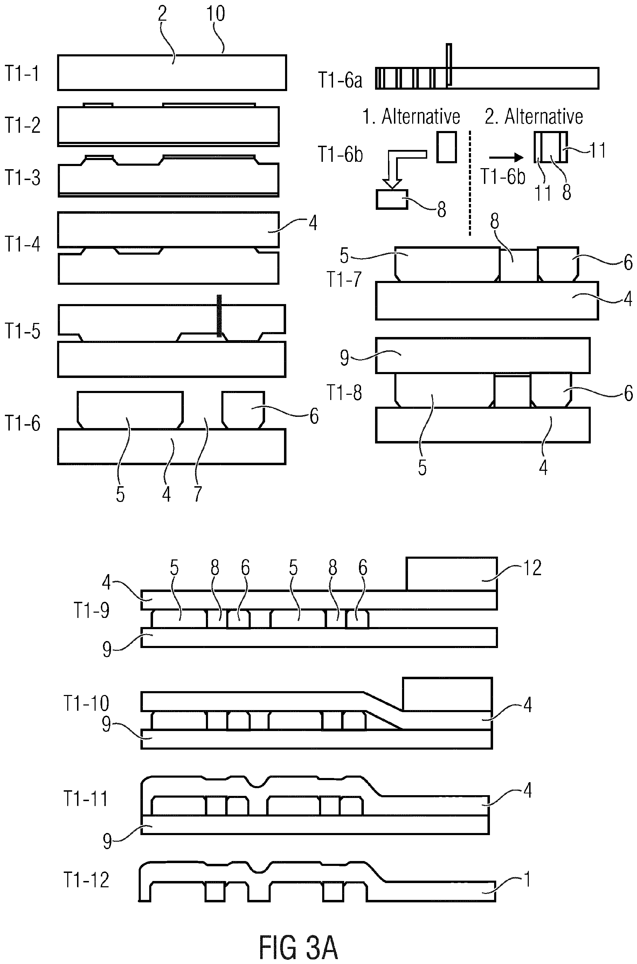

Fig. 3a-f veranschaulichen weitere mögliche und optionale Teilschritte eines ersten Verfahrens zur Herstellung eines Deckelsubstrats, wie es anhand der Fig. 1a-d beschrieben wurde, beispielhaft anhand von Skizzen.

Die in Fig. 3a dargestellten Teilschritte sind nur als beispielhaft zu sehen und können in anderen Ausführungen Variationen aufweisen. Es ist eine mögliche Prozessabfolge dargestellt, wie die Herstellung dieser Deckelwafer, also der Deckelsubstrate, mit integrierten vertikalen optischen Fensterflächen ablaufen kann. Das Verfahren basiert wesentlich auf Techniken des so genannten Glasfließens. In einem Teilschritt T1-1 erfolgt ein Beschichten eines Siliziumwafers, also eines Form-Substrats 2, mit KOH-festen Passivierung 10, in diesem Fall z.B. LP-Nitrid. In einem Teilschritt T1-2 erfolgt eine Lithographie, so dass lediglich Inseln ungeätzt bleiben, und ein Öffnen der Passivierung durch Plasmaätzen. In einem Teilschritt T1-3 erfolgt ein anisotropes nasschemisches Ätzen, in diesem Fall mit KOH, und ein Abätzen der Passivierung. In einem Teilschritt T1-4 erfolgt ein anodisches Bonden eines Glaswafers, also eines Abdeckungssubstrats 4, mit dem Siliziumwafer. Das Abdeckungssubstrat 4 ist in diesem Fall aus dem Glasmaterial Pyrex gebildet. Es kann aber auch beispielsweise aus dem Glasmaterial Borofloat® 33 gebildet sein. In einem Teilschritt T1-5 erfolgt ein Einsägen der Strukturen, hier mittels Cap-Dicing. In einem Teilschritt T1-6 erfolgt ein Entfernen der Streifen zwischen den Inseln.

In einem Teilschritt T1-6a erfolgt ein Zuschneiden, hier Zusägen, von Streifen des eigentlichen Fenstermaterials, also der Fensterbauelemente 8. Dabei handelt es sich in diesem Ausführungsbeispiel um höher-schmelzendes Glas, verglichen mit dem Glasmaterial des Abdeckungssubstrats, das jedoch ähnliche, am besten identische thermische Ausdehnungskoeffizienten aufweist. Geeignete Glasmaterialein sind beispielsweise "AF 32"® (Schott), oder, wie in diesem Beispiel, "Eagle XG"® (Corning®). In einem Schritt T1-6b erfolgt ein Drehen zur Seite, beispielsweise um 90°, damit die optisch geeigneten Flächen im Hinblick auf Ebenheit und Rauheit des Fensterbauelements 8 in eine zum Abdeckungssubtrat 4 günstige Lage kommen.

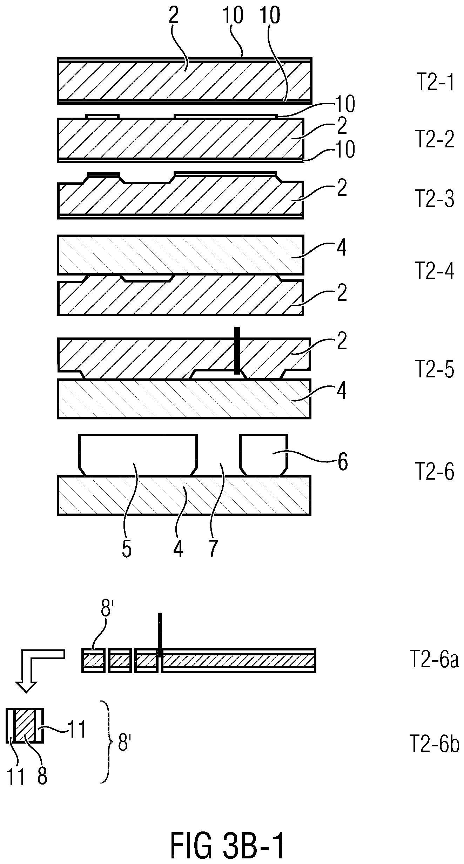

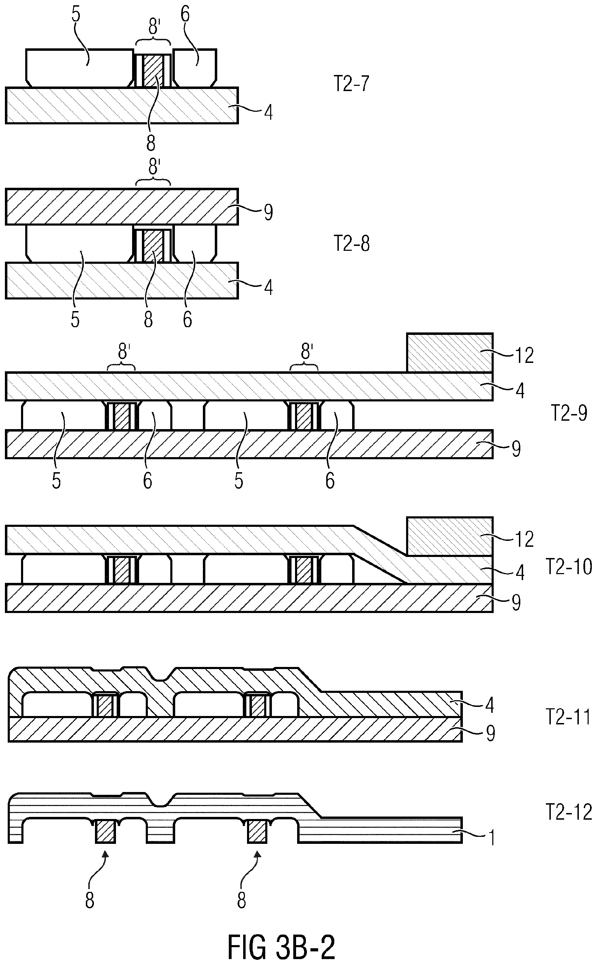

Wird statt einem höher-schmelzenden Glas für das Fensterbauelement 8 ein niedrigschmelzendes Glasmaterial, wie beispielsweise Borofloat®-Glas eingesetzt, so kann dieses mit Siliziumauflagen 11 versehen werden, damit es beim Schritt des Temperns in dessen Form gehalten wird, wie es anhand von T1-6b "Alternative 2" veranschaulicht ist und ausführlich nachfolgend anhand von Fig. 3b erläutert wird.

Die Siliziumauflagen 11 können in Ausführungsformen aufgebondet sein. Anschließend erfolgt in beiden Fällen das Bestücken des Abdeckungssubstrats 4. Dieses ist in dem Teilschritt T1-7 veranschaulicht, das das Einlegen der Glasstreifen aus 6b zeigt, wobei eine Nutzung der Siliziumstrukturen, also der Inselbereiche 5, 6, wie ein Steckbrett erfolgt, so dass die Fensterflächen, also die Fensterbauelemente 8, genau in die Strukturen passen. Die seitlichen Inselbereiche 5, 6 dienen also als "Anschläge" für die Fensterbauelemente 8. Die Fensterbauelemente 8 liegen also in manchen Ausführungsformen der Erfindung nahezu bündig (bzw. nicht vollständig spaltfrei) an den Inselbereichen 5, 6 an. Zwischen den Glaseinlagen, also den Fensterbauelementen 8, und den Halbleiterstrukturen, also den ersten und zweiten Inselbereichen 5, 6, sollte nur ein kleiner Spalt verbleien, im Größenbereich von ca. 5 µm bis 50 µm. Die heiße Glasmasse ist nach wie vor sehr viskos und kann nur in geringem Maße in diese Spalten eindringen. Dennoch erleichtert ein gewisser Abstand das Einbringen der Fensterbauelemente 8 in die Halbleiterstrukturen.

In einem Schritt T1-8 erfolgt gemäß Fig. 3a ein Auflegen eines weiteren Siliziumwafers, in anderen Worten ein Auflegen eines Trägersubstrats 9. In einem Schritt T1-9 erfolgt das Umdrehen des Waferstacks, also des Stapels aus Abdeckungssubstrat 4, Trägersubstrat 9 und zwischengeordneten ersten Inselbereichen 5 und zweiten Inselbereichen 6 des Form-Substrats 2, in diesem Fall um 180°, das Auflegen eines Belastungsrings 12 auf das Abdeckungssubstrat 4, in diesem Fall auf einen Randbereich des Abdeckungssubstrats 4, und ein Evakuieren der Vertiefungen 7 zwischen dem Abdeckungssubstrat 4 und dem Trägersubstrat 9. Der Belastungsring 12 ist beschichtet, um ein Ankleben an dem Abdeckungssubstrat 4 zu vermeiden. In einem Schritt T1-10 erfolgt eine Vakuumtemperung, wobei der Wafer hermetisch dicht verschlossen wird und dann die Druckauflage, also der Belastungsring 12, entfernt wird. In einem Schritt T1-11 erfolgt eine Temperung unter Atmosphärendruck. Dabei wird die Glasmasse, also das Glasmaterial des Abdeckungssubstrats 4, in die großen Zwischenräume, die Vertiefungen 7, gepresst, nicht jedoch in schmale, wie zum Beispiel zwischen den Fensterbauelementen 8 und den ersten Inselbereichen 5 und zweiten Inselbereichen 6, die die Fensterflächen beim Glasfließen umgeben und vor Kontakt mit der Glasmasse des Glaswafers schützen. In einem Schritt T1-12 erfolgt dann das Abätzen der Siliziumstrukturen selektiv zu den Glasstrukturen, in diesem Fall mittels KOH. Bei dem Deckelsubstrat 1, das man auf diese Weise erhält, sind somit Glasmaterial des Abdeckungssubstrats 4 und Glasmaterial der Fensterbauelemente 8 einstückig verbunden, obwohl sie in der beschriebenen Ausführungsform chemisch unterschiedliche Glasmassen sind. Das verbesserte Deckelsubstrat 1 ist eine Voraussetzung für das Herstellen verbesserter gehäuster strahlungsemittierender Bauelemente.

In anderen Worten bedeutet dies, dass das obige Verfahren von Fig. 3a gemäß dem Verfahren von Fig. 1a-b in Ausführungsformen bei dem Bereitstellen des Form-Substrats 2 (zusätzlich) folgende Schritte umfasst: Bereitstellen eines Halbleiterwafers 2 mit einer Passivierungsschicht 10 auf einer Oberfläche; Lithografieren der Passivierungsschicht 10, so dass die Passivierungsschicht 10 dort auf der Oberfläche verbleibt, wo die ersten Inselbereiche 5 und die zweiten Inselbereiche 6 vorgesehen sind; Ätzen der Oberfläche des Halbleiterwafers 2 hinsichtlich der lithographierten Bereiche, so dass eine Dicke des Halbleiterwafers 2 senkrecht zu den lithographierten Bereichen der Oberfläche verringert wird, um den Oberflächenbereich 3 zu strukturieren und somit Positionen für die ersten Inselbereiche 5 und die zweiten Inselbereiche 6 vorzugeben; und vollständiges Entfernen der Passivierungsschicht 10. Zudem umfasst das Verfahren nach Fig. 1a-b oder Fig. 3a in Ausführungsformen bei dem Anordnen und Verbinden des Abdeckungssubstrats 4 also den Schritt eines bereichsweisen anodischen Bondens des strukturierten Oberflächenbereichs 3 des Form-Substrats 2 mit einem Oberflächenbereich des Abdeckungssubstrats 4. Weiterhin umfasst das Bilden von Inselbereichen 5, 6 aus dem Form-Substrat 2 somit in Ausführungsformen die Schritte: Einsägen der ersten und zweiten Inselbereiche 5, 6 in dem Form-Substrat 2 nach dem bereichsweisen anodischen Bonden; und Entfernen jener Abschnitte des Form-Substrats 2, die nach dem Sägen von den gebondeten Bereichen getrennt sind.

Zudem kann, wie gezeigt, das Anordnen jeweils des Fensterbauelements 8 folgende Schritte umfassen: Bereitstellen mehrerer streifenförmiger Fensterbauelemente 8; und Einlegen der streifenförmigen Fensterbauelemente 8 in die Vertiefungen 7 zwischen den ersten Inselbereichen 5 und den zweiten Inselbereichen 6, so dass Oberflächen der Fensterbauelemente 8, die als Oberflächen von optischen Auskoppelfenstern vorgesehen sind, Oberflächen der Inselbereiche 5, 6, die aus dem Form-Substrat 2 gebildet sind, gegenüberliegen. Außerdem kann, wie gezeigt, vorgesehen sein, dass das Bereitstellen von streifenförmigen Fensterbauelementen 8 zusätzlich folgende Schritte umfasst: Bereitstellen eines Fensterbauelementwafers und Zuschneiden der streifenförmigen Fensterbauelemente 8 aus dem Fensterbauelementwafer. Es kann auch, wie gezeigt ist, das Anordnen des jeweiligen Fensterbauelements 8 folgenden Schritt umfassen: Einlegen von Halbleiterstreifen 11 in die Vertiefungen vor dem Einlegen der streifenförmigen Fensterbauelemente 8 in die Vertiefungen 7, so dass die Halbleiterstreifen 11 zwischen Oberflächen der Fensterbauelemente 8, die als Oberflächen von optischen Auskoppelfenstern vorgesehen sind, und Flächen der Inselbereiche 5, 6, die aus dem Form-Substrat 2 gebildet sind, angeordnet sind. Weiterhin kann, wie gezeigt, das Anordnen des jeweiligen Fensterbauelements 8 folgenden Schritt umfassen: Bereitstellen von einem oder mehreren mit Halbleitermaterial 11 beschichteten streifenförmigen Fensterbauelementen 8. Ebenfalls kann vorgesehen sein, dass das Bereitstellen von einem mit Halbleitermaterial 11 beschichteten Fensterbauelement 8 folgenden Schritt umfasst: Beschichten von Oberflächen des Fensterbauelements 8 durch Aufbonden von Halbleiterstreifen 11.

Auf die unter Bezugnahme auf Figur 3a erläuterte Weise erhält man also beispielhaft teilschrittweise ein Deckelsubstrat 1 gemäß des Verfahrens nach Figur 1a-b. Wesentliche Merkmale dieses Verfahrens sind, wie sich aus Fig. 3a und den Erläuterungen ergibt:
1. Die Verwendung von inselartigen Siliziumstrukturen, oder auch allgemein Halbleiterstrukturen, die als Steckbrett dienen.
2. Das Einsetzen streifenförmig angeordneter Glasstrukturen in diese Strukturen.
3. Das Drehen dieser Glasstrukturen um 90° beim Einsetzen, um die guten optische Flächen vertikal auszurichten.
4. Realisierung kleiner Spaltmaße zwischen den Fensterbauelementen und den ersten Inselbereichen bzw. zweiten Inselbereichen (ca. 50 µm oder kleiner, beispielsweise 20 µm bis 50 µm, streng genommen sind die Aspektverhältnisse ausschlaggebend, denn die Glasmasse braucht sehr lange, um sehr kleine Spalten füllen zu können. Erfahrungsgemäß lassen sich Kanäle mit nur einigen wenigen 10 µm Breite nicht mehr auffüllen. Abstände von 10 µm sollten daher nur in sehr geringem Maß durch das Glas erreicht werden können.)
5. Vakuumverschluss in Schritt T1-10 auf einem lose untergelegten Siliziumwafer.

Fig. 3b veranschaulicht Teilschritte eines weiteren Verfahrens zur Herstellung eines Deckelsubstrats anhand von Skizzen. Diese Teilschritte sind nur als beispielhaft zu sehen und können in anderen Ausführungen Variationen aufweisen. Es ist eine mögliche Prozessabfolge dargestellt, wie die Herstellung dieser Deckelwafer, also der Deckelsubstrate, mit integrierten vertikalen optischen Fensterflächen ablaufen kann. Bei dem hier dargestellten Verfahren werden Si-Glas-Si-Strukturen (d.h. zweiseitig beschichtete Glasstreifen bzw. Stacks) als Fensterstreifen eingesetzt, um die Fensterelemente bzw. Fensterflächen zu bilden.

Das Verfahren basiert wesentlich auf Techniken des so genannten Glasfließens. In einem Teilschritt T2-1 erfolgt ein Beschichten eines Siliziumwafers, also eines Form-Substrats 2, mit KOH-festen Passivierung 10, in diesem Fall z.B. LP-Nitrid. In einem Teilschritt T2-2 erfolgt eine Lithographie, so dass lediglich Inseln ungeätzt bleiben, und ein Öffnen der Passivierung durch Plasmaätzen. In einem Teilschritt T2-3 erfolgt ein anisotropes nasschemisches Ätzen, in diesem Fall mit KOH, und ein Abätzen der Passivierung. In einem Teilschritt T2-4 erfolgt ein anodisches Bonden eines Glaswafers, also eines Abdeckungssubstrats 4, mit dem Siliziumwafer 2. Das Abdeckungssubstrat 4 ist in diesem Fall aus dem Glasmaterial Pyrex gebildet. Es kann aber auch beispielsweise aus dem Glasmaterial Borofloat® 33 gebildet sein. In einem Teilschritt T2-5 erfolgt ein Einsägen der Strukturen, hier mittels Cap-Dicing. In einem Teilschritt T2-6 erfolgt ein Entfernen der Streifen zwischen den Inseln 5, 6, um die Vertiefungen (Ausnehmungen) 7 zu erhalten.

In einem Teilschritt T2-6a erfolgt ein Zuschneiden, z.B. Zusägen, von Streifen des eigentlichen Fenstermaterials, also der beschichteten Fensterbauelemente 8'. Ein Substrat aus dem Fenstermaterial kann beispielsweise zweiseitig mit einer Schicht 11 aus einem Halbleitermaterial, z.B. Silizium, versehen sein. Durch das Zuschneiden, z.B. Sägen, werden dann die (zweiseitig) beschichteten Streifen 8' des eigentlichen Fenstermaterials erhalten, die an zwei gegenüberliegenden Seitenflächen mit der Schicht 11 aus dem Halbleitermaterial, z.B. Silizium, versehen sind.

Wird also statt einem höher-schmelzenden Glas für das Fensterbauelement 8 (vgl. Fig. 3a) beispielsweise ein niedrigschmelzendes Glasmaterial, wie beispielsweise Borofloat®-Glas, oder ein anders Fenstermaterial eingesetzt, so kann dieses mit Siliziumauflagen 11 versehen werden, damit es beim Schritt des Temperns in dessen Form gehalten wird, wie es anhand von T2-6b veranschaulicht ist. Die Siliziumauflagen 11 können in Ausführungsformen aufgebondet sein.

In einem Schritt T2-6b erfolgt ein Drehen der beschichteten Fensterbauelemente 8' zur Seite, beispielsweise um 90°, damit die optisch geeigneten Flächen im Hinblick auf Ebenheit und Rauheit des Fensterbauelements 8 in eine zum Abdeckungssubtrat 4 günstige Lage kommen. Ferner werden die beschichteten Fensterbauelemente 8' so ausgerichtet, dass die beidseitig auf den Fensterbauelementen 8' vorgesehenen Halbleiterschichten 11 parallel zu den Seitenflächen der seitlichen Inselbereiche 5, 6 ausgerichtet sind. Anschließend erfolgt das Bestücken des Abdeckungssubstrats 4. Dieses ist in dem Teilschritt T2-7 veranschaulicht, das das Einlegen der beschichteten Glasstreifen 8' aus 6b zeigt, wobei eine Nutzung der Siliziumstrukturen, also der Inselbereiche 5, 6, wie ein Steckbrett erfolgt, so dass die Fensterflächen, also die beschichteten Fensterbauelemente 8', genau in die Strukturen passen. Die seitlichen Inselbereiche 5, 6 dienen also als "Anschläge" für die Fensterbauelemente 8'. Die beschichteten Fensterbauelemente 8' liegen also in manchen Ausführungsformen der Erfindung nahezu bündig (bzw. nicht vollständig spaltfrei) an den Inselbereichen 5, 6 an. Zwischen den beschichteten Glaseinlagen, also den beschichteten Fensterbauelementen 8', und den Halbleiterstrukturen, also den ersten und zweiten Inselbereichen 5, 6, sollte nur ein kleiner Spalt verbleien, im Größenbereich von ca. 5 µm bis 50 µm. Die heiße Glasmasse ist nach wie vor sehr viskos und kann nur in geringem Maße in diese Spalten eindringen. Dennoch erleichtert ein gewisser Abstand das Einbringen der Fensterbauelemente 8' in die Halbleiterstrukturen.

In einem Schritt T2-8 erfolgt gemäß Fig. 3b ein Auflegen eines weiteren Halbleiterwafers (z.B. Siliziumwafers), in anderen Worten ein Auflegen eines Trägersubstrats 9. In einem Schritt T2-9 erfolgt das Umdrehen des Waferstacks, also des Stapels aus Abdeckungssubstrat 4, Trägersubstrat 9 und zwischengeordneten ersten Inselbereichen 5 und zweiten Inselbereichen 6 des Form-Substrats 2, in diesem Fall um 180°, das Auflegen eines Belastungsrings 12 auf das Abdeckungssubstrat 4, in diesem Fall auf einen Randbereich des Abdeckungssubstrats 4, und ein Evakuieren der Vertiefungen 7 zwischen dem Abdeckungssubstrat 4 und dem Trägersubstrat 9. Der Belastungsring 12 ist beschichtet, um ein Ankleben an dem Abdeckungssubstrat 4 zu vermeiden. In einem Schritt T2-10 erfolgt eine Vakuumtemperung, wobei der Wafer hermetisch dicht verschlossen wird und dann die Druckauflage, also der Belastungsring 12, entfernt wird. In einem Schritt T2-11 erfolgt eine Temperung unter Atmosphärendruck. Dabei wird die Glasmasse, also das Glasmaterial des Abdeckungssubstrats 4, in die großen Zwischenräume, die Vertiefungen bzw. Ausnehmungen 7, gepresst, nicht jedoch in schmale, wie zum Beispiel zwischen den beschichteten Fensterbauelementen 8' und den ersten Inselbereichen 5 und zweiten Inselbereichen 6, die die beschichteten Fensterflächen 8' beim Glasfließen umgeben und vor Kontakt mit der Glasmasse des Glaswafers schützen. In einem Schritt T2-12 erfolgt dann das Abätzen der Siliziumstrukturen (d.h. des Trägersubstrats 9 und der Seitenflächen 11 der Fensterelemente 8) selektiv zu den Glasstrukturen, in diesem Fall z.B. mittels KOH. Bei dem Deckelsubstrat 1, das man auf diese Weise erhält, sind somit Glasmaterial des Abdeckungssubstrats 4 und Glasmaterial der Fensterbauelemente 8 einstückig verbunden, obwohl sie in der beschriebenen Ausführungsform chemisch unterschiedliche Glasmassen sind. Die freigelegten Oberflächen bzw. Seitenflächen der Fensterbauelemente 8' sind als optische Auskoppelfenster wirksam bzw. vorgesehen. Das verbesserte Deckelsubstrat 1 ist eine Voraussetzung für das Herstellen verbesserter gehäuster strahlungsemittierender Bauelemente.

In anderen Worten bedeutet dies, dass das obige Verfahren von Fig. 3b gemäß dem Verfahren von Fig. 1a-b in Ausführungsformen bei dem Bereitstellen des Form-Substrats 2 (zusätzlich) folgende Schritte umfasst: Bereitstellen eines Halbleiterwafers 2 mit einer Passivierungsschicht 10 auf einer Oberfläche; Lithografieren der Passivierungsschicht 10, so dass die Passivierungsschicht 10 dort auf der Oberfläche verbleibt, wo die ersten Inselbereiche 5 und die zweiten Inselbereiche 6 vorgesehen sind; Ätzen der Oberfläche des Halbleiterwafers 2 hinsichtlich der lithographierten Bereiche, so dass eine Dicke des Halbleiterwafers 2 senkrecht zu den lithographierten Bereichen der Oberfläche verringert wird, um den Oberflächenbereich 3 zu strukturieren und somit Positionen für die ersten Inselbereiche 5 und die zweiten Inselbereiche 6 vorzugeben; und vollständiges Entfernen der Passivierungsschicht 10. Zudem umfasst das Verfahren nach Fig. 1a-b oder Fig. 3b in Ausführungsformen bei dem Anordnen und Verbinden des Abdeckungssubstrats 4 also den Schritt eines bereichsweisen anodischen Bondens des strukturierten Oberflächenbereichs 3 des Form-Substrats 2 mit einem Oberflächenbereich des Abdeckungssubstrats 4. Weiterhin umfasst das Bilden von Inselbereichen 5, 6 aus dem Form-Substrat 2 somit in Ausführungsformen die Schritte: Einsägen der ersten und zweiten Inselbereiche 5, 6 in dem Form-Substrat 2 nach dem bereichsweisen anodischen Bonden; und Entfernen jener Abschnitte des Form-Substrats 2, die nach dem Sägen von den gebondeten Bereichen getrennt sind.

Zudem kann, wie gezeigt, das Anordnen jeweils des beschichteten Fensterbauelements 8' folgende Schritte umfassen: Bereitstellen mehrerer streifenförmiger beschichteter Fensterbauelemente 8'; und Einlegen der streifenförmigen beschichteten Fensterbauelemente 8' in die Vertiefungen 7 zwischen den ersten Inselbereichen 5 und den zweiten Inselbereichen 6, so dass beschichteten Oberflächen der Fensterbauelemente 8' den seitlichen Oberflächen der Inselbereiche 5, 6, die aus dem Form-Substrat 2 gebildet sind, gegenüberliegen.

Außerdem kann, wie gezeigt, vorgesehen sein, dass das Bereitstellen von streifenförmigen beschichteten Fensterbauelementen 8' zusätzlich folgende Schritte umfasst: Bereitstellen eines beschichteten Fensterbauelementwafers und Zuschneiden der streifenförmigen beschichteten Fensterbauelemente 8' aus dem Fensterbauelementwafer. Es kann auch, wie gezeigt ist, das Anordnen des jeweiligen Fensterbauelements 8' folgenden Schritt umfassen: Einlegen von Halbleiterstreifen 11 in die Vertiefungen vor dem Einlegen der streifenförmigen Fensterbauelemente 8 in die Vertiefungen 7, so dass die Halbleiterstreifen 11 zwischen Oberflächen der Fensterbauelemente 8, die als Oberflächen von optischen Auskoppelfenstern vorgesehen sind, und Flächen der Inselbereiche 5, 6, die aus dem Form-Substrat 2 gebildet sind, angeordnet sind. Weiterhin kann, wie gezeigt, das Anordnen des jeweiligen Fensterbauelements 8' folgenden Schritt umfassen: Bereitstellen von einem oder mehreren mit Halbleitermaterial 11 beschichteten streifenförmigen Fensterbauelementen 8'. Ebenfalls kann vorgesehen sein, dass das Bereitstellen von einem mit Halbleitermaterial 11 beschichteten Fensterbauelement 8' folgenden Schritt umfasst: Beschichten von Oberflächen des Fensterbauelements 8 durch Aufbonden von Halbleiterstreifen 11, um das beschichtete Fensterbauelement 8' zu erhalten.

Auf die unter Bezugnahme auf Figur 3b erläuterte Weise erhält man also beispielhaft teilschrittweise ein Deckelsubstrat 1 gemäß des Verfahrens nach Figur 1a-b. Wesentliche Merkmale dieses Verfahrens sind, wie sich aus Fig. 3b und den Erläuterungen ergibt:
1. Die Verwendung von inselartigen Siliziumstrukturen, oder auch allgemein Halbleiterstrukturen, die als Steckbrett dienen.
2. Das Einsetzen streifenförmig angeordneter Glas-Siliziumstrukturen, oder allgemein Glas-Halbleiterstrukturen, (siehe T2-6b) in diese Strukturen.
3. Das Drehen dieser Glas-Siliziumstrukturen um 90° beim Einsetzen, um die guten optische Flächen vertikal auszurichten.
4. Die Verwendung dieser Siliziumstrukturen als Schutzstrukturen, um einen direkten Kontakt an den optischen Flächen mit der Glasmasse des Glaswafers zu vermeiden, was entsprechend kleine Spaltmaße voraussetzt, also kleine Spaltmaße zwischen den Fensterbauelementen und den ersten Inselbereichen bzw. zweiten Inselbereichen (ca. 50 µm oder kleiner, beispielsweise 20 µm bis 50 µm, streng genommen sind die Aspektverhältnisse ausschlaggebend, denn die Glasmasse braucht sehr lange, um sehr kleine Spalten füllen zu können. Erfahrungsgemäß lassen sich Kanäle mit nur einigen wenigen 10 µm Breite nicht mehr auffüllen. Abstände von 10 µm sollten daher nur in sehr geringem Maß durch das Glas erreicht werden können.)
5. Vakuumverschluss in Schritt T2-10 auf einem lose untergelegten Siliziumwafer.

Die anhand der Fig. 3a und 3b dargestellten Herstellungsverfahren können entsprechend den in Fig. 1c und d dargestellten alternativen Verfahren gleichermaßen angepasst werden, indem im Prozessablauf zunächst das Formsubstrat 2 (Halbleiterwafer) mit dem Trägersubstrat 9 (Halbleiterwafer) mittels Waferbonding verbunden wird, während dann bei einem späteren Herstellungsschritt der Abdeckungswafer 4 auf die aus dem Formsubstrat 2 gebildeten Inselstrukturen 5, 6, die fest mit dem Trägersubstrat 9 verbunden sind, aufgebracht wird. Die anhand der Fig. 3a-b dargestellten Herstellungsverfahren können entsprechend angepasst bzw. umgestellt werden, um die dort dargestellte Prozessabfolge entsprechend der Vorgehensweise der Fig. 1c und d anzuwenden. Die restlichen Prozessschritte des Prozessablaufs können im Wesentlichen unverändert beibehalten werden.

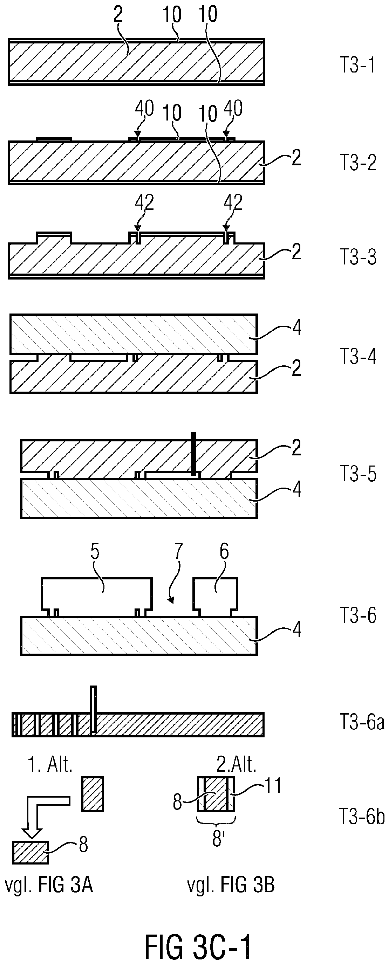

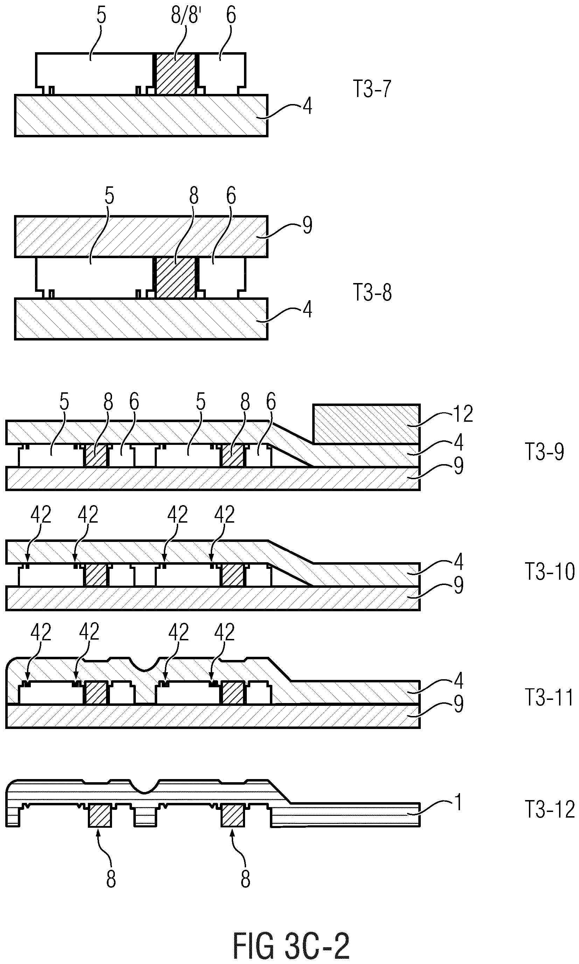

Fig. 3c veranschaulicht Teilschritte eines weiteren Verfahrens zur Herstellung eines Deckelsubstrats anhand von Skizzen. Diese Teilschritte sind nur als beispielhaft zu sehen und können in anderen Ausführungen Variationen aufweisen. Es ist eine mögliche Prozessabfolge dargestellt, wie die Herstellung dieser Deckelwafer, also der Deckelsubstrate, mit integrierten vertikalen optischen Fensterflächen ablaufen kann. Das Verfahren basiert wesentlich auf Techniken des so genannten Glasfließens. Bei dem hier dargestellten Verfahren werden zusätzliche Kanalstrukturen beispielweise in den Halbleiter-Strukturen (Si-Strukturen) vorgesehen, wobei diese zusätzlichen Kanalstrukturen das abschließende Entfernen des Siliziums aus den Kavitäten mit anisotrope nasschemischen Ätzen erleichtern.

In einem Teilschritt T3-1 erfolgt ein Beschichten eines Siliziumwafers, also eines Form-Substrats 2, mit KOH-festen Passivierung 10, in diesem Fall z.B. LP-Nitrid. In einem Teilschritt T3-2 erfolgt eine Lithographie, so dass lediglich Inseln ungeätzt bleiben, und ein Öffnen der Passivierung durch Plasmaätzen. Dabei werden ferner zusätzliche "kleine" Kanalstrukturen 40 innerhalb der Inseln 10 definiert.

In einem Teilschritt T3-3 erfolgt ein anisotroper Ätzvorgang, z.B. ein anisotroper trockenchemischer Ätzvorgang (DRIE - Deep Reactive Ion Etching). Bei diesem Ätzvorgang entstehen neben den Strukturierungen der Oberfläche 3 des Formsubstrats 2 ferner die Kanäle 42 in dem Formsubstrat, wobei die Kanäle z.B. dort an Positionen in dem Formsubstrat 2 angeordnet sind, an denen später (vgl. Schritte T3-5 und T3-6) die Inselbereiche 5, 6, die die dazwischenliegenden Vertiefungen bzw. Ausnehmungen 7 definieren, gebildet werden.

Die Breite und Tiefe der Kanäle 42 wird dabei so dimensioniert, dass bei den nachfolgend durchgeführten Temperschritten (vgl. Schritte T3-9 bis T3-12) die Kanäle 42 in den Inselbereichen 5, 6 nicht bzw. nicht vollständig mit dem Glasmaterial des Abdeckungssubstrats 4, das auch in die verbleibenden Vertiefungen 7 zwischen den Inselbereichen 5, 6 hineinfließt, aufgefüllt wird bzw. aufgefüllt werden kann. Schließlich wird noch die Passivierung 10 an dem Formsubstrat 2, z.B. mittels Abätzen, entfernt.

Bezüglich der weiteren in Fig. 3c dargestellten Prozess- bzw. Verfahrensschritte T3-4 bis T3-12 wird darauf hingewiesen, dass diese Teilschritte im Wesentlichen gleichermaßen wie die anhand der Fig. 3a-b beschriebenen Teilschritte T1-4 bis T1-12 bzw. T2-4 bis T3-12 durchgeführt werden können, wobei diesbezüglich auf die obige Beschreibung der Fig. 3a-b hinsichtlich weiterer technischer Details verwiesen wird. Bei dem anhand von Fig. 3c dargestellten Herstellungsverfahren wird lediglich darauf hingewiesen, dass bei den dargestellten Herstellungsschritten T3-4 bis T3-11 weiterhin die Kanäle 42 in den Inselbereichen 5, 6 enthalten sind. Bei dem Schritt T3-12 erfolgt dann das Abätzen der Siliziumstrukturen selektiv zu den Glasstrukturen, das beispielsweise mittels eines nasschemischen Verfahrens (z.B. mit KOH - Kaliumhydroxid) durchgeführt wird. Bei dem Deckelsubtrat 1, das man auf diese Weise erhält, sind somit das Glasmaterial des Abdeckungssubstrats 4 und das Glasmaterial der Fensterbauelemente 8 einstückig verbunden, obwohl diese in der beschriebenen Ausführungsform chemisch unterschiedliche Glasmassen sind.

Bei dem in Schritt T3-12 durchgeführten Ätzvorgang wirken sich die vorgesehenen Kanäle 42 dahin gehend vorteilhaft aus, dass das Halbleitermaterial (Si-Material) deutlich beschleunigt herausgeätzt werden kann, da über die Kanäle 42 das Ätzmittel, z.B. KOH, umfangreicher dem wegzuätzenden Siliziummaterial zugeführt werden kann. Damit kann der Ätzvorgang des Halbleiter- bzw. Siliziummaterials sehr unterstützt und damit zeitlich reduziert werden. Durch das Vorsehen der Kanäle 42 bei dem erfindungsgemäßen Herstellungsverfahren kann somit das Herausätzen des Si-Materials deutlich beschleunigt werden, während die Kanäle 42 beispielsweise mit einer Breite von wenigen 10 µm (einer Breite von ≤ 50 µm) dimensioniert werden können, so dass bei dem Tempervorgang die Kanäle 42 nicht mit dem Glasmaterial des Abdeckungssubstrats gefüllt wird.

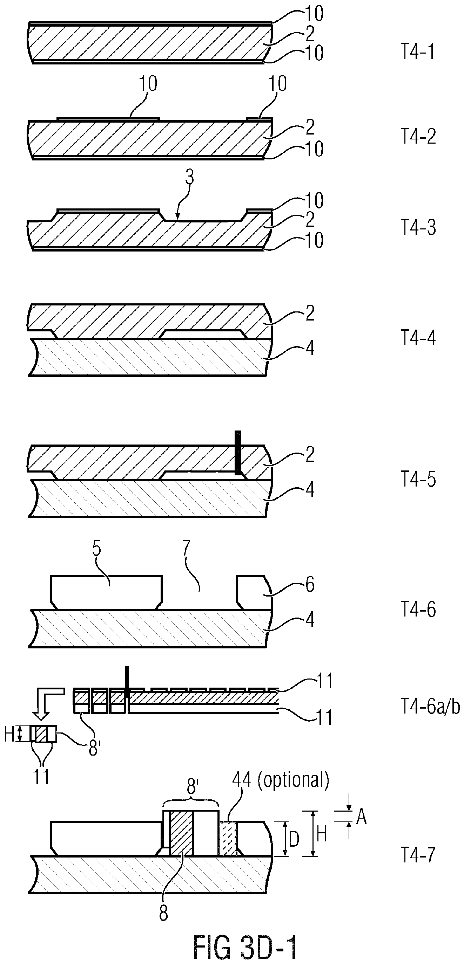

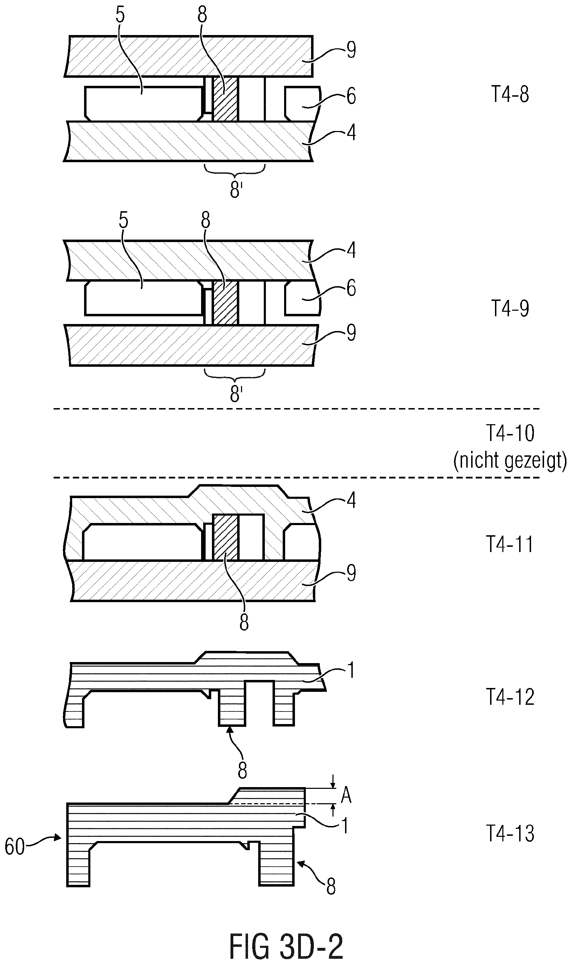

Die in Fig. 3d veranschaulichten Teilschritte T4-1 bis T4-13 stellen ein weiteres Verfahren zur Herstellung eines Deckelsubstrats anhand von Skizzen dar. Diese Teilschritte sind nur als beispielhaft zu sehen und können in anderen Ausführungen Variationen aufweisen. Es ist eine mögliche Prozessabfolge dargestellt, wie die Herstellung dieser Deckelwafer, also der Deckelsubstrate, mit integrierten vertikalen optischen Fensterelementen mit vergrößerten (äußeren) Fensterflächen ablaufen kann. Damit lassen sich letztendlich größere äußere optische Flächen realisieren, ohne dass die Kavität erhöht werden muss. Das Verfahren basiert wiederum wesentlich auf Techniken des so genannten Glasfließens.

In einem Teilschritt T4-1 erfolgt ein Beschichten eines Siliziumwafers, also eines Form-Substrats 2, mit KOH-festen Passivierung 10, in diesem Fall z.B. LP-Nitrid. In einem Teilschritt T4-2 erfolgt eine Lithographie, so dass lediglich Inseln ungeätzt bleiben, und ein Öffnen der Passivierung durch Plasmaätzen. In einem Teilschritt T4-3 erfolgt ein anisotropes nasschemisches Ätzen, in diesem Fall mit KOH, und ein Abätzen der Passivierung. In einem Teilschritt T4-4 erfolgt ein anodisches Bonden eines Glaswafers, also eines Abdeckungssubstrats 4, mit dem Siliziumwafer 2. Das Abdeckungssubstrat 4 ist in diesem Fall aus dem Glasmaterial Pyrex gebildet. Es kann aber auch beispielsweise aus dem Glasmaterial Borofloat® 33 gebildet sein. In einem Teilschritt T4-5 erfolgt ein Einsägen der Strukturen, hier mittels Cap-Dicing. In einem Teilschritt T4-6 erfolgt ein Entfernen der Streifen zwischen den Inseln 5, 6, um die Vertiefungen (Ausnehmungen) 7 zu erhalten.

Hinsichtlich des in Fig. 3d dargestellten Herstellungsverfahrens wird darauf hingewiesen, dass die dargestellten Teilschritte T4-1 bis T4-12 im Wesentlichen den Teilschritten T1-1 bis T1-12 von Fig. 3a bzw. den Teilschritten T2-1 bis T2-12 der Fig. 3b als auch den Teilschritten T3-1 bis T3-12 der Fig. 3d entsprechen, wobei die dortige Beschreibung gleichermaßen auf die anhand von Fig. 3d dargestellten Teilschritte T4-1 bis T4-12 anwendbar sind.

Im Folgenden wird nun lediglich auf die Änderungen bzw. Abwandlungen zu den im Vorhergehenden anhand der Fig. 3a, b und c dargestellten Herstellungsverfahren eingegangen, wobei, wie oben angegeben, die restlichen technischen Details der Fig. 3a-c gleichermaßen bei dem Verfahren von Fig. 3d anwendbar sind.

In einem Teilschritt T4-6a/b erfolgt ein Zuschneiden, hier Zusägen, von Streifen des eigentlichen Fenstermaterials, also der Fensterbauelemente 8 (nicht gezeigt in T4-6a von Fig. 3d) bzw. der beschichteten Fensterbauelemente 8'. Ein Substrat aus dem Fenstermaterial kann beispielsweise zweiseitig mit einer Schicht 11 aus einem Halbleitermaterial, z.B. Silizium, versehen sein. Durch das Zuschneiden, z.B. Sägen, werden dann die (zweiseitig) beschichteten Streifen 8' des eigentlichen Fenstermaterials erhalten, die an zwei gegenüberliegenden Seitenflächen mit der Schicht 11 aus dem Halbleitermaterial, z.B. Silizium, versehen sind und so einen sog. Fensterstack (Fensterstapel) bilden.

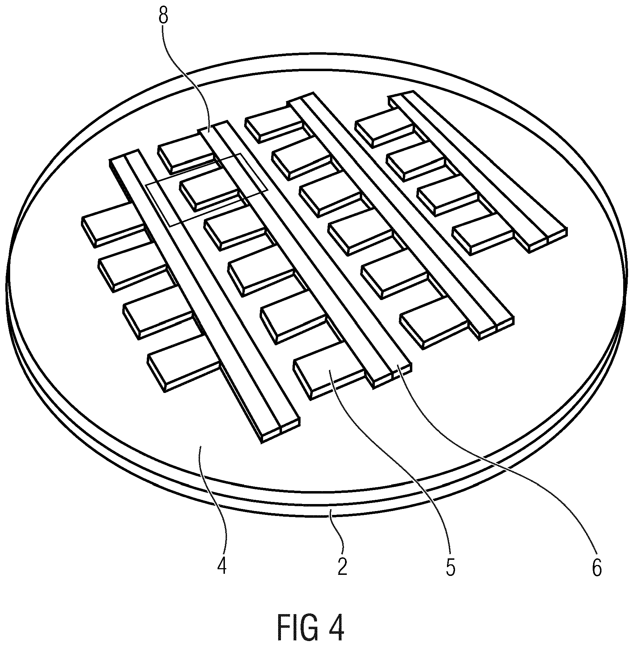

Wie dies bei Teilschritt T4-6a/b von Fig. 3d dargestellt ist, können die beschichteten Fensterbauelemente 8' so ausgebildet sein, dass die Schicht 11 aus dem Halbleitermaterial, z.B. Silizium, auf unterschiedlichen Seitenflächen des Fensterbauelemente 8' eine unterschiedliche Dicke und/oder Flächenausdehnung aufweist. So ist bei Teilschritt T4-6a/b von Fig. 3d die "obere" Beschichtung dünner und weist eine kleinere Fläche als die "untere" Beschichtung auf. Wie dies bei Teilschritt T4-6a/b von Fig. 3d ferner dargestellt ist, kann eine optionale Anschlagsstruktur 44 vorhanden sein, die gestrichelt dargestellt ist (da die Struktur nicht in der Schnittebene des hier dargestellten Gehäuses liegt), wobei die Anschlagstruktur abschnittsweise den Si-Glas-Si-Streifen am Rand des Streifens unterstützt. Dies bezüglich wird auch auf die nachfolgende Beschreibung anhand der Figuren 4a-b verwiesen.

Wird also statt einem höher-schmelzenden Glas für das Fensterbauelement 8 (vgl. Fig. 3a) beispielsweise ein niedrigschmelzendes Glasmaterial, wie beispielsweise Borofloat®-Glas, oder ein anders Fenstermaterial eingesetzt, so kann dieses mit Siliziumauflagen 11 versehen werden, damit es beim Schritt des Temperns in dessen Form gehalten wird, wie es anhand von T4-6b veranschaulicht ist. Die Siliziumauflagen 11 können in Ausführungsformen aufgebondet sein. In einem Schritt T4-6a/b erfolgt ein Drehen der beschichteten Fensterbauelemente 8' zur Seite, beispielsweise um 90°, damit die optisch geeigneten Flächen im Hinblick auf Ebenheit und Rauheit des Fensterbauelements 8' in eine zum Abdeckungssubtrat 4 günstige Lage kommen. Ferner werden die beschichteten Fensterbauelemente 8' so ausgerichtet, dass die beidseitig auf den Fensterbauelementen 8' vorgesehenen Halbleiterschichten 11 parallel zu den Seitenflächen der seitlichen Inselbereiche 5, 6 ausgerichtet sind.

Wie dies bei Teilschritt T4-6a/b und T4-7 von Fig. 3d ferner dargestellt ist, ist die Höhe der beschichteten Fensterbauelemente 8' so gewählt, das die Höhe H größer ist als die Dicke D der Inselbereiche 5, 6, die aus dem ursprünglichen Formsubstrat 2 gebildet wurden. Die beschichteten Fensterbauelemente 8' stehen also über die Oberfläche der Inselbereiche 5, 6 hinaus.

Anschließend erfolgt das Bestücken des Abdeckungssubstrats 4. Dieses ist in dem Teilschritt T4-7 veranschaulicht, das das Einlegen der Glasstreifen aus 6b zeigt, wobei eine Nutzung der Siliziumstrukturen, also der Inselbereiche 5, 6, wie ein Steckbrett erfolgt, so dass die Fensterflächen, also die Fensterbauelemente 8, seitlich genau in die Strukturen passen und vertikal über die Oberseite der Inselbereiche 5, 6 um einen Abstand A (= H - D) hinausragen. Die seitlichen Inselbereiche 5, 6 dienen also als "Anschläge" für die Fensterbauelemente 8. Die Fensterbauelemente 8 liegen also in manchen Ausführungsformen der Erfindung nahezu bündig (bzw. nicht vollständig spaltfrei) an den Inselbereichen 5, 6 an. Zwischen den Glaseinlagen, also den Fensterbauelementen 8, und den Halbleiterstrukturen, also den ersten und zweiten Inselbereichen 5, 6, sollte nur ein kleiner Spalt verbleien, im Größenbereich von ca. 5 µm bis 50 µm. Die heiße Glasmasse ist nach wie vor sehr viskos und kann nur in geringem Maße in diese Spalten eindringen. Dennoch erleichtert ein gewisser Abstand das Einbringen der Fensterbauelemente 8 in die Halbleiterstrukturen.

In einem Schritt T4-8 erfolgt gemäß Fig. 3d ein Auflegen eines weiteren Siliziumwafers, in anderen Worten ein Auflegen eines Trägersubstrats 9. In einem Schritt T4-9 erfolgt das Umdrehen des Waferstacks, also des Stapels aus Abdeckungssubstrat 4, Trägersubstrat 9 und zwischengeordneten ersten Inselbereichen 5 und zweiten Inselbereichen 6 des Form-Substrats 2, in diesem Fall um 180°, das Auflegen eines Belastungsrings 12 auf das Abdeckungssubstrat 4, in diesem Fall auf einen Randbereich des Abdeckungssubstrats 4, und ein Evakuieren der Vertiefungen 7 zwischen dem Abdeckungssubstrat 4 und dem Trägersubstrat 9. Der Belastungsring 12 ist beschichtet, um ein Ankleben an dem Abdeckungssubstrat 4 zu vermeiden. In einem Schritt T4-10 erfolgt eine Vakuumtemperung, wobei der Wafer hermetisch dicht verschlossen wird und dann die Druckauflage, also der Belastungsring 12, entfernt wird. In einem Schritt T4-11 erfolgt eine Temperung unter Atmosphärendruck. Dabei wird die Glasmasse, also das Glasmaterial des Abdeckungssubstrats 4, in die großen Zwischenräume, die Vertiefungen 7, gepresst, nicht jedoch in schmale, wie zum Beispiel zwischen den Fensterbauelementen 8 und den ersten Inselbereichen 5 und zweiten Inselbereichen 6, die die Fensterflächen beim Glasfließen umgeben und vor Kontakt mit der Glasmasse des Glaswafers schützen. In einem Schritt T4-12 erfolgt dann das Abätzen der Siliziumstrukturen selektiv zu den Glasstrukturen, in diesem Fall mittels KOH. Bei dem Deckelsubstrat 1, das man auf diese Weise erhält, sind somit Glasmaterial des Abdeckungssubstrats 4 und Glasmaterial der Fensterbauelemente 8 einstückig verbunden, obwohl sie in der beschriebenen Ausführungsform chemisch unterschiedliche Glasmassen sind. Das verbesserte Deckelsubstrat 1 ist eine Voraussetzung für das Herstellen verbesserter gehäuster strahlungsemittierender Bauelemente.

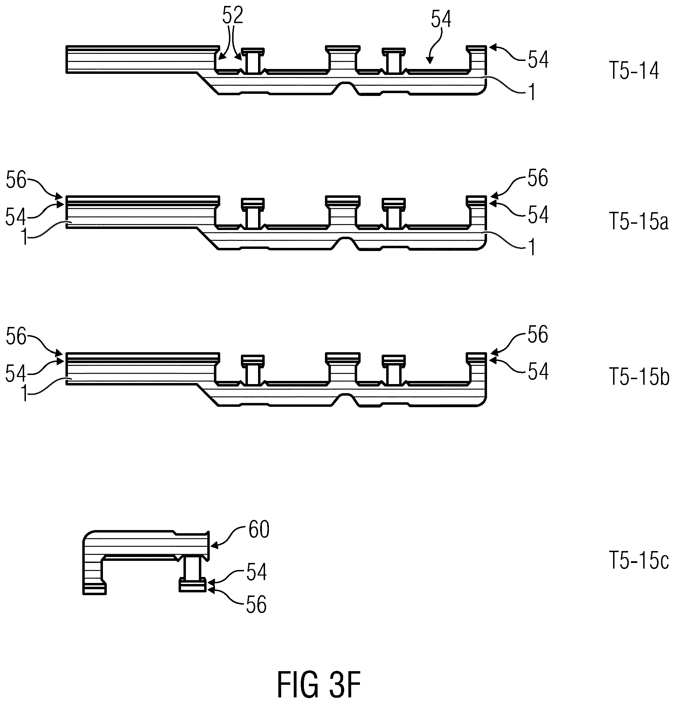

Bei Teilschritt T4-13 werden nun die einzelnen Abdeckungen vereinzelt, beispielsweise mittels Sägen, wobei bei dem in T4-13 dargestellten einzelnen Abdeckungselement deutlich wird, dass die optisch wirksame Außenfläche des Einzelgehäuses 60 gegenüber dem im Vorhergehenden dargestellten Herstellungsverfahren deutlich, d.h. um die Länge A, vergrößert ist. Da strahlungs- bzw. lichtemittierende Bauelemente, die in dem erfindungsgemäßen Gehäuse bzw. der Abdeckung 1 untergebracht werden, häufig eine relativ hohe Strahlaufweitung aufweisen, und eine Optik (z.B. Kollimationsoptik) erst nach dem Gehäuse vorgesehen werden kann, liefert die erfindungsgemäße Vorgehensweise gemäß Fig. 3f zum Herstellen vergrößerter äußerer Fensterflächen für ein Deckelsubstrat bzw. einzelne Deckelelemente eine in dem Herstellungsprozess relativ einfach zu implementierte Möglichkeit solche vergrößerten äußeren Fensterflächen zu realisieren. So können beispielsweise ohne Weiteres Gehäuse gefertigt werden, in die Laser mit einer Strahldivergenz von ± 35° gehäust werden können.

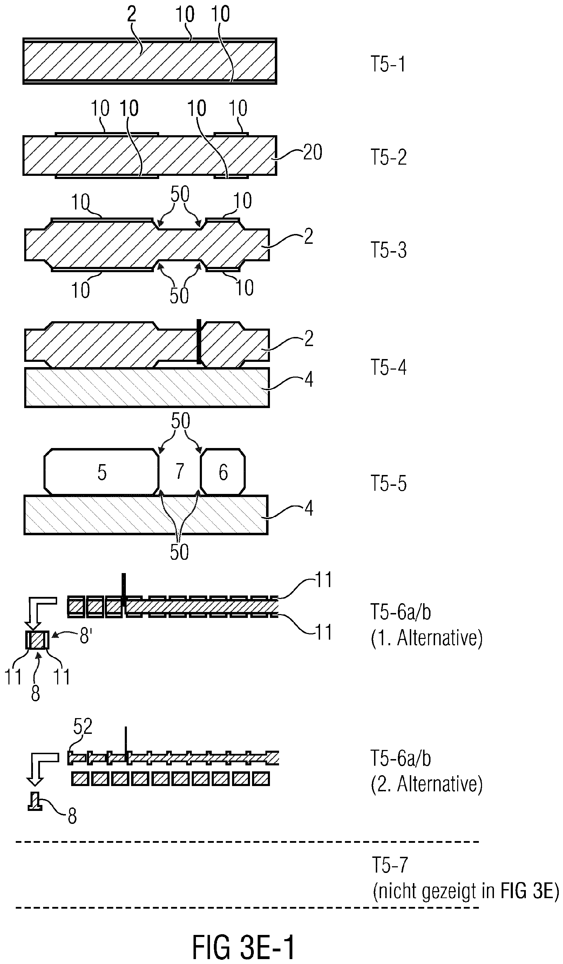

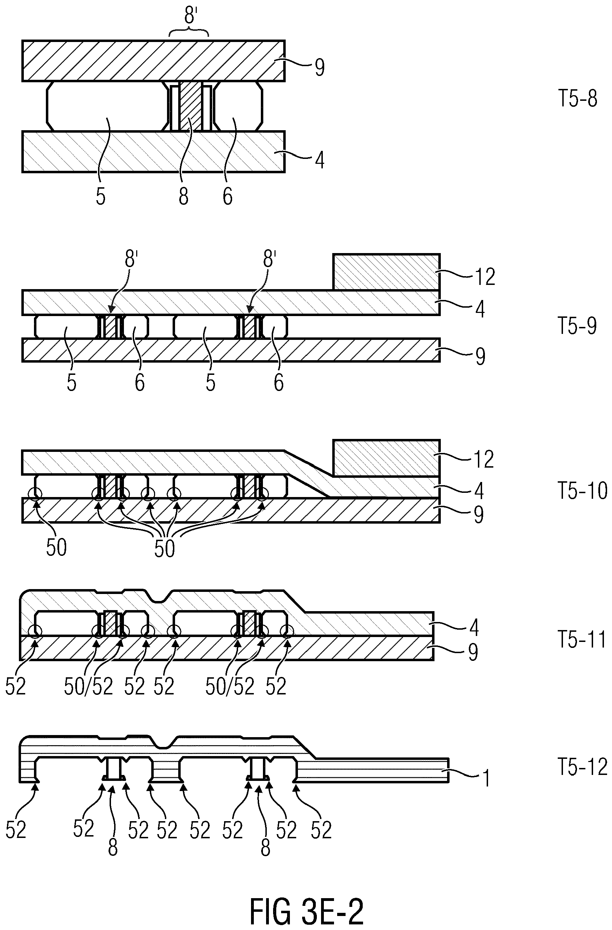

Die in Fig. 3e veranschaulichten Teilschritte T5-1 bis T5-12 stellen ein weiteres Verfahren zur Herstellung eines Deckelsubstrats anhand von Skizzen dar. Diese Teilschritte sind nur als beispielhaft zu sehen und können in anderen Ausführungen Variationen aufweisen. Es ist eine mögliche Prozessabfolge dargestellt, wie die Herstellung dieser Deckelwafer, also der Deckelsubstrate, mit integrierten vertikalen optischen Fensterelementen, wobei die dargestellte Prozessabfolge die Herstellung umlaufender geometrischer Überdeckungen (Hinterschneidungen bzw. Hinterschnitte) der Seitenwände ermöglicht. Die unterschiedlichen mit einer Metallisierung (zur elektrischen und/oder mechanischen Kontaktierung) zu versehenden Bereiche weisen als eine räumliche Begrenzung bzw. Trennung eine Hinterschnitt-Struktur (Hinterschneidung) auf. Dadurch könnten getrennte Metallsierungsbereiche gebildet werden, wobei durch die überstehenden Auflageflächen die weiteren Prozessierung vereinfachen können.

In einem Teilschritt T5-1 erfolgt ein Beschichten eines Siliziumwafers, also eines Form-Substrats 2, mit KOH-festen Passivierung 10, in diesem Fall z.B. LP-Nitrid. In einem Teilschritt T5-2 erfolgt eine Lithographie, so dass lediglich Inseln ungeätzt bleiben, und ein Öffnen der Passivierung 10 durch Plasmaätzen. In einem Teilschritt T5-3 erfolgt ein beidseitiges anisotropes nasschemisches Ätzen, in diesem Fall mit KOH, und ein Abätzen der Passivierung.

In einem Teilschritt T5-4 erfolgt ein anodisches Bonden eines Glaswafers, also eines Abdeckungssubstrats 4, mit dem Siliziumwafer 2. Das Abdeckungssubstrat 4 ist in diesem Fall aus dem Glasmaterial Pyrex gebildet. Es kann aber auch beispielsweise aus dem Glasmaterial Borofloat® 33 gebildet sein. In einem Teilschritt T5-4 erfolgt ferner ein Einsägen der Strukturen, hier mittels Cap-Dicing. In einem Teilschritt T5-5 erfolgt ein Entfernen der Streifen zwischen den Inseln 5, 6, um die Vertiefungen (Ausnehmungen) 7 zu erhalten.

Bei dem Teilschritt T5-2 erfolgt das Öffnen der Passivierung 10 an dem Formsubstrat 2 beidseitig und i.W. symmetrisch, wobei nachfolgend bei Schritt T5-3 bei dem anisotropen nasschemischen Ätzen beidseitig und i.W. symmetrisch Vertiefungen in dem Formsubstrat 2 erzeugt, die sich seitlich schräg nach oben zu der (nicht-geätzten) Oberfläche des Formsubstrats 2 erstrecken.

In dem Teilschritt T5-4 erfolgt das Einsägen der Strukturen innerhalb der Vertiefungen, so dass die Anschrägungen 50 (Anfasungen bzw. Abschrägungen) nach dem Entfernen der Streifen zwischen den Inseln 5, 6, um die Vertiefungen (Ausnehmungen) 7 zu erhalten, in Schritt T5-5 an den Inselbereichen erhalten bleiben. Diese Anfasungen 50 der Kanten der Inselbereiche 5, 6 sind in den Teilschritten T5-3, T5-4 und T5-5 explizit dargestellt.

Hinsichtlich des in Fig. 3e dargestellten Herstellungsverfahrens wird darauf hingewiesen, dass die dargestellten Teilschritte T5-1 bis T5-12 im Wesentlichen den Teilschritten T1-1 bis T1-12 von Fig. 3a bzw. den Teilschritten T2-1 bis T2-12 der Fig. 3b als auch den Teilschritten T3-1 bis T3-12 der Fig. 3e entsprechen, wobei die dortige Beschreibung gleichermaßen auf die anhand von Fig. 3e dargestellten Teilschritte T5-1 bis T5-12 anwendbar sind.

Im Folgenden wird nun lediglich auf die Änderungen bzw. Abwandlungen zu den im Vorhergehenden anhand der Fig. 3a-d dargestellten Herstellungsverfahren eingegangen, wobei, wie oben angegeben, die restlichen technischen Details der Fig. 3a-d gleichermaßen bei dem Verfahren von Fig. 3e anwendbar sind

In einem Teilschritt T5-6a/b (erste und zweite Alternative) erfolgt ein Zuschneiden, hier Zusägen, von Streifen des eigentlichen Fenstermaterials, also der Fensterbauelemente 8 bzw. der beschichteten Fensterbauelemente 8'.

Wie bei der ersten Alternative von Schritt T5-6a/b dargestellt ist, kann ein Substrat aus dem Fenstermaterial beispielsweise zweiseitig mit einer Schicht 11 aus einem Halbleitermaterial, z.B. Silizium, versehen sein. Durch das Zuschneiden, z.B. Sägen, werden dann die (zweiseitig) beschichteten Streifen 8' des eigentlichen Fenstermaterials erhalten, die an zwei gegenüberliegenden Seitenflächen mit der Schicht 11 aus dem Halbleitermaterial, z.B. Silizium, versehen sind und so einen sog. Fensterstack (Fensterstapel) bilden.

Wie nun bei Teilschritt T5-6a/b (erste Alternative) von Fig. 3e dargestellt ist, können die beschichteten Fensterbauelemente 8' so ausgebildet sein, dass die Schicht 11 (Beschichtung) aus dem Halbleitermaterial, wie z.B. Silizium, auf unterschiedlichen gegenüberliegenden Seitenflächen der Fensterbauelemente 8' angeordnet sind und eine im Wesentlichen gleiche Dicke und/oder Flächenausdehnung aufweisen.

Wird also statt einem höher-schmelzenden Glas für das Fensterbauelement 8 (vgl. Fig. 3a) beispielsweise ein niedrigschmelzendes Glasmaterial, wie beispielsweise Borofloat®-Glas, oder ein anders Fenstermaterial eingesetzt, so kann dieses mit Siliziumauflagen 11 versehen werden, damit es beim Schritt des Temperns in dessen Form gehalten wird, wie es anhand von T4-6b veranschaulicht ist. Die Siliziumauflagen 11 können in Ausführungsformen aufgebondet sein.

Da die Siliziumauflagen 11 das Fensterbauelement 8 nicht vollständig auf beiden Seiten bedecken, kann bei dem nachfolgenden Tempervorgang (siehe Teilschritt T5-11) erreicht werden, dass sich die umlaufenden Hinterschneidungen 52 der Seitenwände ergeben.

In dem Teilschritt T5-6a/b (erste Alternative) werden also die Streifen des eigentlichen Fenstermaterials zugeschnitten (gesägt) in Form eines Dreifachstapels (Stacks) aus einem Si-Glas-Si-Material (Borofloat). Vor dem Vereinzeln (Zuschneiden bzw. Sägen) wurden aber die Siliziumauflagen 11 strukturiert, so dass nach dem Vereinzeln der Si-Glas-Si-Streifen die Siliziumbeschichtungen bzw. Siliziumauflagen 11 im Auflagebereich auf (angrenzend an) dem Trägersubstrat 9 (Siliziumwafer) entfernt sind (siehe auch Teilschritt T5-8).

Handelt es sich in Teilschritt T5-6a/b (2. Alternative) bei den Streifen des eigentlichen Fenstermaterials, also der Fensterbauelemente 8, um höher-schmelzendes Glas, verglichen mit dem Glasmaterial des Abdeckungssubstrats, das jedoch ähnliche, am besten identische thermische Ausdehnungskoeffizienten aufweist.

So wird das hochschmelzende Glasmaterial beidseitig eingeätzt, um angrenzend an diese weggeätzten Bereiche eine Erhöhung bzw. Verbreiterung der Fensterbauelemente 8 im Bereich der "Montagefläche" derselben zu erhalten.

Die Fensterstrukturen gemäß Teilschritt T5-6a/b (zweite Alternative) werden dann so zwischen die Inselbereiche 5, 6 in die Vertiefungen eingefügt, dass diese Verbreiterungen bzw. Randbereiche angrenzend zu dem angeordneten Trägersubstrat 9 (Siliziumwafer), z.B. in den Anfasungen 50, angeordnet sind (nicht gezeigt in Fig. 3e).

Geeignete höher-schmelzende Glasmaterialein sind beispielsweise "AF 32"® (Schott), oder, wie in diesem Beispiel, "Eagle XG"® (Corning®).

In einem Schritt T5-6a/b (erste Alternative) erfolgt ein Drehen der beschichteten Fensterbauelemente 8' zur Seite, beispielsweise um 90°, damit die optisch geeigneten Flächen im Hinblick auf Ebenheit und Rauheit des Fensterbauelements 8' in eine zum Abdeckungssubtrat 4 günstige Lage kommen. Ferner werden die beschichteten Fensterbauelemente 8' so ausgerichtet, dass die beidseitig auf den Fensterbauelementen 8' vorgesehenen Halbleiterschichten 11 parallel zu den Seitenflächen der seitlichen Inselbereiche 5, 6 ausgerichtet sind.

In einem Schritt T5-6a/b (zweite Alternative) erfolgt ein Drehen der Fensterbauelemente 8 zur Seite, beispielsweise um 90°, damit die optisch geeigneten Flächen im Hinblick auf Ebenheit und Rauheit des Fensterbauelements 8 in eine zum Abdeckungssubtrat 4 günstige Lage kommen. Ferner werden die Verbreiterungen 52 der Fensterbauelemente 8 so ausgerichtet, dass diese möglichst (bei Teilschritt T5-8) an dem angeordneten Trägersubstrat 9 (Siliziumwafer) angrenzen bzw. anliegen.

Anschließend erfolgt also das Bestücken des Abdeckungssubstrats 4 (Teilschritt T5-7 - nicht gezeigt in Fig. 3e), indem die Glasstreifen aus T5-6a/b (erste und zweite Alternative) eingelegt werden, wobei eine Nutzung der Siliziumstrukturen, also der Inselbereiche 5, 6, wie ein Steckbrett erfolgt, so dass die Fensterflächen, also die Fensterbauelemente 8, 8', seitlich genau in die Strukturen passen. Die seitlichen Inselbereiche 5, 6 dienen also als "Anschläge" für die Fensterbauelemente 8. Die Fensterbauelemente 8 liegen also in manchen Ausführungsformen der Erfindung nahezu bündig (bzw. nicht vollständig spaltfrei) an den Inselbereichen 5, 6 an. Zwischen den Glaseinlagen, also den Fensterbauelementen 8, und den Halbleiterstrukturen, also den ersten und zweiten Inselbereichen 5, 6, sollte nur ein kleiner Spalt verbleien, im Größenbereich von ca. 5 µm bis 50 µm. Die heiße Glasmasse ist nach wie vor sehr viskos und kann nur in geringem Maße in diese Spalten eindringen. Dennoch erleichtert ein gewisser Abstand das Einbringen der Fensterbauelemente 8 in die Halbleiterstrukturen.

In einem Schritt T5-8 erfolgt gemäß Fig. 3e ein Auflegen eines weiteren Siliziumwafers, in anderen Worten ein Auflegen eines Trägersubstrats 9.

Gemäß der ersten Alternative erfolgt in Teilschritt T5-6a/b t ein Drehen der beschichteten Fensterbauelemente 8' zur Seite, beispielsweise um 90°, damit die beschichteten Fensterbauelemente 8' so ausgerichtet sind, dass die beidseitig auf den Fensterbauelementen 8' vorgesehenen Halbleiterschichten 11 parallel zu den Seitenflächen der seitlichen Inselbereiche 5, 6 ausgerichtet sind.

Gemäß der zweiten Alternative von Teilschritt T5-6a/b werden die Verbreiterungen 52 der Fensterbauelemente 8 so ausgerichtet, dass diese möglichst (bei Teilschritt T5-8) an dem angeordneten Trägersubstrat 9 (Siliziumwafer) angrenzen bzw. anliegen (nicht gezeigt in Fig. 3e).

In einem Schritt T5-9 erfolgt das Umdrehen des Waferstacks, also des Stapels aus Abdeckungssubstrat 4, Trägersubstrat 9 und zwischengeordneten ersten Inselbereichen 5 und zweiten Inselbereichen 6 des Form-Substrats 2, in diesem Fall um 180°, das Auflegen eines Belastungsrings 12 auf das Abdeckungssubstrat 4, in diesem Fall auf einen Randbereich des Abdeckungssubstrats 4, und ein Evakuieren der Vertiefungen 7 zwischen dem Abdeckungssubstrat 4 und dem Trägersubstrat 9. Der Belastungsring 12 ist beschichtet, um ein Ankleben an dem Abdeckungssubstrat 4 zu vermeiden. In einem Schritt T5-10 erfolgt eine Vakuumtemperung, wobei der Wafer hermetisch dicht verschlossen wird und dann die Druckauflage, also der Belastungsring 12, entfernt wird. In einem Schritt T5-11 erfolgt eine Temperung unter Atmosphärendruck. Dabei wird die Glasmasse, also das Glasmaterial des Abdeckungssubstrats 4, in die großen Zwischenräume, die Vertiefungen 7, gepresst, nicht jedoch in schmale, wie zum Beispiel zwischen den Fensterbauelementen 8 und den ersten Inselbereichen 5 und zweiten Inselbereichen 6, die die Fensterflächen beim Glasfließen umgeben und vor Kontakt mit der Glasmasse des Glaswafers schützen.

In die im Schritt T5-11 dargestellten Anfasungen 50 der Inselbereiche 5, 6 wird bei dem Tempervorgang bei Teilschritt T5-11 das (freiliegende) (Glasmaterial des niedrigschmelzenden) Fensterbauelements 8 in diese Anfasungen zumindest teilweise hineingedrückt. Mit anderen Worten ausgedrückt heißt dies, dass das Glasmaterial der Fensterbauelemente 8, das nicht von den seitlichen Beschichtungen 11 (Si-Streifen) bedeckt ist, während des Tempervorgangs (Teilschritt T5-11) in die vorgesehenen Anfasungen 50 der Inselbereiche 5, 6 zumindest teilweise hineingedrückt wird bzw. hineinfließt.

In einem Schritt T5-12 erfolgt dann das Abätzen der Siliziumstrukturen selektiv zu den Glasstrukturen, in diesem Fall mittels KOH. Bei dem Deckelsubstrat 1, das man auf diese Weise erhält, sind somit Glasmaterial des Abdeckungssubstrats 4 und Glasmaterial der Fensterbauelemente 8 einstückig verbunden, obwohl sie in der beschriebenen Ausführungsform chemisch unterschiedliche Glasmassen sind. Das verbesserte Deckelsubstrat 1 ist eine Voraussetzung für das Herstellen verbesserter gehäuster strahlungsemittierender Bauelemente.

Das Glasmaterial, das während des Tempervorgangs (Teilschritt T5-11) zumindest teilweise in die Anfasungen 50 hineingedrückt wird bzw. fließt, bildet nun die Fortsätze 52 (Hinterschneidungen) an dem Deckelsubstrat 1.

Die im Teilschritt T5-12 erhaltene Anordnung des Deckelsubstrats 1 mit den (umlaufenden) Fortsätzen 52 kann ebenfalls erhalten werden, wenn als Fensterbauelemente die im Teilschritt T5-6a/b (zweite Alternative) dargestellten Fensterbauelemente 8 mit den Verbreiterungen 52 eingesetzt werden.

Im Folgenden wird nun anhand von Fig. 3f Ausführungsbeispiele für die weitere Prozessierung der im Teilschritt T5-12 von Fig. 3e erhaltenen Deckelsubstrat 1 beschrieben.

Wie im Teilschritt T5-14 dargestellt ist, erfolgt eine ganzflächige Metallisierung des Deckelsubstrats 1 von der Seite des Deckelsubstrats 1, die den Fensterelementen 8 zugewandt ist. Die resultierende Metallisierung 54 erfolgt ganzflächig, beispielsweise durch Aufdampfen oder Sputtern. Die an dem Deckelsubstrat 1 erhaltenen Fortsätze 52 (Hinterschneidungen) verhindern, dass sich während des Metallisierungsvorgangs (unerwünschte) Metallschichten an den (senkrechten) Seitenflächen bzw. Seitenwänden des Deckelsubstrats 1 anlagern können. Die Metallisierung 54 befindet sich somit im Wesentlichen an den horizontalten Seitenflächen (Auflageflächen für die Weiterprozessierung) des Deckelsubstrats 1 (von oben in der Darstellung von Fig. 3f - Teilschritt T5-14). Die Metallisierung 54 des Deckelsubstrats 1 befindet sich somit an Positionen, die für eine Befestigung des Deckelsubstrats 1 an einem weiteren Bauelementesubstrat (nicht gezeigt), an dem sich beispielsweise die strahlungs- bzw. lichtemittierenden Bauelemente (LEDs, Laser etc.) befinden können, vorgesehen sind.

Wie nun im Teilschritt T5-15a dargestellt ist, kann die Metallisierungsschicht 54 (d.h. die Metallisierung der Auflageflächen des Deckelsubstrats 1) ganzflächig galvanisch beschichtet werden (mittels eines Galvanisierungsvorgangs), um die zusätzliche Beschichtung 56 zu erhalten. Die zusätzliche Beschichtung 56 kann beispielsweise als ein Lötsystem (z.B. AuSn) abgeschieden sein oder kann alternativ eine zusätzliche Verstärkung mit einer Edelmetallschicht implementieren.

Bei dem im Teilschritt T5-15b dargestellten alternativen Ausführungsbeispiel, kann die zusätzliche Beschichtung 56 als eine Lötmaterialschicht (Lot) erhalten werden, indem die mit der Metallisierung 54 beschichteten (oberen) Auflageflächen in ein flüssiges Lot (Lotbad) eingetaucht werden, so dass das Lot auf die benetzbare Metallschicht 54 aufgebracht wird. Damit lässt sich äußerst einfach ein Lotmaterial 56 prozesstechnisch auf die benetzbaren Metallschichten 54 aufbringen.

Bei dem in dem Teilschritt T5-15c dargestellten Ausführungsbeispiel kann die galvanische der Schicht 56 oder das Beloten mit einem flüssigen Lot auch nach dem Vereinzeln des Deckelsubstrats 1, d.h. einem Deckelsubstrat-Einzelelement 60, als Einzelchip erfolgen.

In diesem Zusammenhang wird nochmals darauf hingewiesen, dass die anhand der Fig. 3a-e dargestellten Herstellungsverfahren können entsprechend den in Fig. 1c und d dargestellten alternativen Verfahren gleichermaßen angepasst werden, indem im Prozessablauf zunächst das Formsubstrat 2 (Halbleiterwafer) mit dem Trägersubstrat 9 (Halbleiterwafer) mittels Waferbonding verbunden wird, während dann bei einem späteren Herstellungsschritt der Abdeckungswafer 4 auf die aus dem Formsubstrat 2 gebildeten Inselstrukturen 5, 6, die fest mit dem Trägersubstrat 9 verbunden sind, aufgebracht wird. Die anhand der Fig. 3a-e dargestellten Herstellungsverfahren können entsprechend angepasst bzw. umgestellt werden, um die dort dargestellte Prozessabfolge entsprechend der Vorgehensweise der Fig. 1c und d anzuwenden. Die restlichen Prozessschritte des Prozessablaufs können im Wesentlichen unverändert beibehalten werden. Aufgrund der festen Verbindung des Formsubstrats 2 und des Trägersubstrats 9, z.B. mittels Waferbonding, wird erreicht, dass auch die resultierenden Inselbereiche 5, 6 fest mit dem Trägersubstrat 9 verbunden sind, so dass während der weiteren Verfahrensschritte und insbesondere während des Temperns (Temperaturbehandlung) der verbundenen Substrate verhindert werden kann, dass sich die aus dem Formsubstrat 2 gebildeten Inselbereiche 5, 6 hinsichtlich des Abdeckungssubstrats 4 bzw. des Trägersubstrats 9 lateral bewegen bzw. leicht verschieben können. Damit können die resultierenden Fensterbauelemente mit äußerst hoher Präzision und damit sehr geringen Herstellungstoleranzen gefertigt werden.

Im Vorhergehenden wurden anhand der Fig. 3a-f unterschiedliche Ausführungsbeispiele des Herstellungsverfahrens für ein Deckelsubstrat 1 beschrieben.

Die im Vorhergehenden beschriebenen Ausführungsbeispiele waren beispielhaft darauf gerichtet, dass das Abdeckungssubstrat 1 mit einer Vielzahl von Deckelsubstrat-Einzelelementen 60 hergestellt wird und daraufhin das Deckelsubstrat mit der Vielzahl von Deckelsubstrat-Einzelelementen 60 (auf Waferebene), beispielsweise als Glasdeckelwafer für eine weitere Prozessierung bereitgestellt wird. Diesbezüglich sollte aber ferner deutlich werden, dass auch die Deckel-Einzelelemente 60 für eine "einzelne" Weiterverarbeitung bereitgestellt werden. Dabei können die Deckel-Einzelelemente 60 wiederum auf Bauelementsubstrate (z.B. auf Waferebene) oder auch zur Montage mit einzelnen Gehäusen auf einzelnen Chips oder auch Keramiksubstraten eingesetzt werden.

Bezüglich der anhand der Fig. 3a-f dargestellten Deckelsubstrate 1 wird ferner darauf hingewiesen, dass ein Deckel-Einzelelement 60 auch mehrere Fensterelemente 8, z.B. gegenüberliegende Fensterelemente 8 als Mikro-Küvette, aufweisen kann. Die Herstellung doppelseitiger Fensterflächen für ein Deckel-Einzelelement 60 kann dabei ohne Weiteres durch die spezielle Ausgestaltung und Bearbeitung des Form-Substrats 2 bzw. der resultierenden Inselbereich 5 und 6 und der dazwischenliegenden Vertiefung 7 erhalten werden. Um eine doppelseitige Fensterfläche zu erhalten, ist es lediglich erforderlich, anstelle der in den oben dargestellten Fig. 3a-f vorgesehenen einen Vertiefung 7 zwei gegenüberliegende Vertiefungen 7 vorzusehen.

Fig. 4 zeigt einen Glasdeckelwafer 1, der mit einem Form-Substrat 2 verbunden ist, wobei der Glasdeckelwafer 1 eingelassene Fensterbauelemente 8 aufweist. Es handelt sich hierbei um eine schematische Ansicht eines Glasdeckelwafers aus Borofloat®-Glas mit eingelassenen Glasfenstern (gemäß Fig. 3a-e, T#-11). Ein einzelnes Gehäuse ist umrandet gezeichnet. Die ersten und zweiten Inselbereiche 5, 6 bestehen aus einem Halbleitermaterial, in diesem Fall Silizium, und werden im Fortgang des Herstellungsprozesses beispielsweise durch nasschemisches Ätzen entfernt. Zwischen den ersten Inselbereichen 5 und den zugeordneten, benachbarten zweiten Inselbereichen 6 sind jeweils Fensterbauelemente 8 angeordnet.

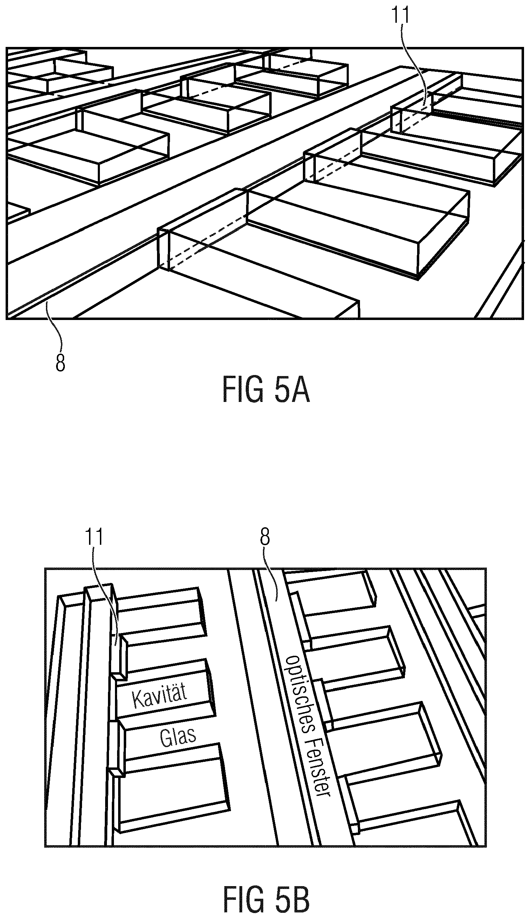

Fig. 5a und 5b zeigen Detailausschnitte eines Glasdeckelwafers 1. Wenn Glas-Siliziumelemente für die Fensterflächen eingesetzt werden sollen, so sollte der Silizium der der Innenseite der Kavitäten, also den Freiräumen, in denen später die strahlungsemittierenden Bauelemente angeordnet werden, so strukturiert werden, dass das Silizium lediglich im Bereich der Kavität (d.h. im Bereich des eigentlichen Fensters) verbleibt. Andernfalls durchschneidet ein Siliziumstreifen 11 auch die Seitenwände der einzelnen Gehäuse, wie es in den Figuren 5a und 5b gezeigt ist.

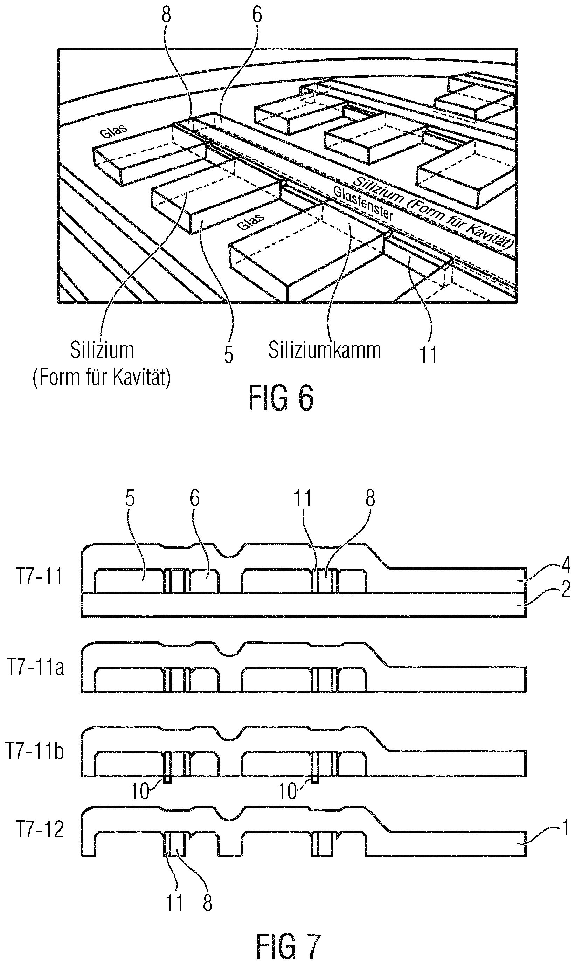

Fig. 6 zeigt einen Glasdeckelwafer 1 mit Siliziumkämmen 11. Es ist die Situation vor dem Abätzen des Siliziums gezeigt. Das Siliziumsubstrat, also das Form-Substrat 2, wurde in dieser Darstellung weggelassen. Dargestellt sind die ersten Inselbereiche 5 und die zweiten Inselbereiche 6, also die Siliziuminselstrukturen, und das Silizium, das die Fensterflächen definiert. Während im Bereich der späteren optischen Aperturen, also der optischen Auskoppelfenster, das Silizium sich bis zur Oberfläche erstreckt, werden die Siliziumstrukturen 11 im Bereich der Gehäusewandung etwas tiefer angeordnet und treten an keiner Stelle mit dem Siliziumwafer, also dem Form-Substrat 2, in direkten Kontakt, bzw. sind an der Oberfläche (nach Entfernen des Si-Wafers) von Glas bedeckt.

Fig. 7 veranschaulicht eine Prozessvariante, bei der Siliziumstrukturen 11 in einer Gehäusewand des Deckelsubstrats 1 verbleiben. Es findet also ein lokales Passivieren von Siliziumstrukturen 11 statt, die in der Gehäusewand verbleiben. In einem Teilschritt T7-11 findet eine Temperung unter Atmosphärendruck statt, wobei die Glasmasse, also das Glasmaterial des Abdeckungssubstrats 4, in die großen Zwischenräume, also die Vertiefungen 7, gepresst wird. In einem Teilschritt T7-11a findet ein Grinden statt. In einem Teilschritt T77-11b findet ein Aufbringen der Passivierung 10 und ein Strukturieren der Passivierung 10 statt. In einem Teilschritt T7-12 findet ein Abätzen der Siliziumstrukturen selektiv zu den Glasstrukturen und der Passivierung auf Si-Areal mittels KOH statt.

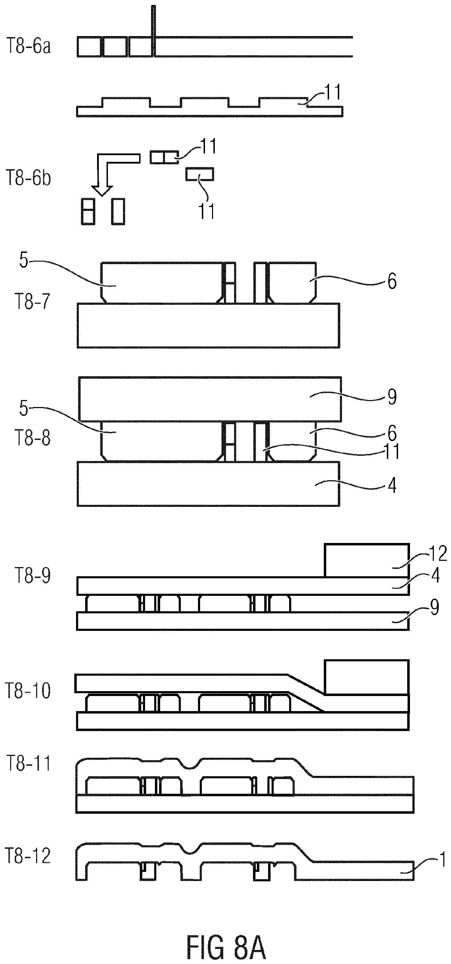

Fig. 8a zeigt eine Prozessvariante gemäß dem dritten Verfahren, bei der zwei parallele Siliziumstreifen 11 zur Definition von Fensterflächen verwendet werden. Wenn schon Siliziumstreifen gebondet auf einem Borofloat®-Glasstreifen verwendet werden können, um die optischen Fensterflächen zu definieren, ist es auch möglich, einfach zwei parallele Siliziumstreifen so zu platzieren, dass ein Zwischenraum zwischen denselben entsteht, in dem die einfließende Glasmasse das Fenster später im Prozess selbst ausbildet. In diesem Fall besteht die gesamte Form mit Ausnahme des Glaswafers komplett aus Silizium. Es liegt auf der Hand, dass hier ganz ähnliche Probleme auftreten wie zuvor bei der Verwendung von Siliziumglas-Siliziumelementen. In diesem Fall ist vor allem die Vorgehensweise besonders vorteilhaft, bei der das Silizium in Form einer Kammstruktur ausgebildet wird, die direkt an den Kavitäten anschließt. In einem Teilschritt T8-6a erfolgt ein Zuschneiden (Sägen) von Streifen aus Silizium, die "Außenseite" ist ein einfacher Si-Streifen, während der "innen" Streifen aus einem Wafer mit Öffnungen gefertigt wird, so dass eine kammförmige Abfolge von Siliziumflächen entsteht. Gemäß T8-6b erfolgt dann ein Drehen und Bestücken, wobei zusätzliche Justagestrukturen in Ausführungsformen das präzise Bestücken erleichtern und die Strukturen während des Prozesses gegen Verrutschen und Umfallen sichern. In Teilschritt T8-7 erfolgt das Einlegen der Si-Streifen aus T8-6b, wobei die Siliziumstrukturen, also die ersten und zweiten Inselbereiche 5,6, wie ein Steckbrett genutzt werden, so dass die Fensterflächen später genau in die Strukturen passen. Die seitlichen Inseln 5, 6 dienen also als "Anschläge". In Teilschritt T8-8 erfolgt das Auflegen eines weiteren Siliziumwafers 9. In Teilschritt T8-9 erfolgt ein Umdrehen des Waferstacks, das Auflegen eines Belastungsrings 12, der beschichtet ist, um ein Ankleben an Glas zu vermeiden, und ein Evakuieren. In Teilschritt T8-10 erfolgt eine Vakuumtemperung, der Wafer wird hermetisch dicht verschlossen und die Druckauflage entfernt. In Teilschritt T8-11 erfolgt eine Temperung unter Atmosphärendruck, wobei die Glasmasse, also das Glasmaterial des Abdeckungssubstrats 4, in die großen Zwischenräume, also die Vertiefungen 7, gepresst wird. Die Glasmasse umfließt dabei die Si-Kammstruktur 11. Bei der Prozessführung ist darauf zu achten, dass einerseits die Glasmasse die Si-Strukturen vollständig umfließt, andererseits jedoch in den Spalten zwischen den anliegenden Si-Streifen und den Inselstrukturen, also den ersten und zweiten Inselbereichen, nur im oberen Bereich eindringt. Daher sollten die Spaltmaße deutlich kleiner als 50 µm gewählt werden, beispielsweise zwischen 5 µm bis 50µm. Im Teilschritt T8-12 erfolgt dann ein Abätzen der Siliziumstrukturen selektiv zu den Glasstrukturen, in der Regel mittels KOH. Das Silizium in der Gehäusewandung wird dabei durch die untere Glasfläche geschützt.

Gemäß Figur 8a wird somit ein drittes Verfahren zur Herstellung eines Deckelsubstrats 1 mit folgenden Schritten geschaffen: Bereitstellen eines Form-Substrats 2 mit einem strukturierten Oberflächenbereich 3, Anordnen eines Abdeckungssubstrats 4 auf dem strukturierten Oberflächenbereich 3 des Form-Substrats 2, wobei das Abdeckungssubstrat 4 ein Glasmaterial aufweist, und Verbinden des Abdeckungssubstrats 4 mit dem Form-Substrat 2, wobei die strukturierte Oberfläche 3 des Form-Substrats 2 mit einer Oberfläche des Abdeckungssubstrats 4 mindestens teilweise überdeckend zusammengeführt wird, Bilden von ersten Inselbereichen 5 und jeweils zugeordneten, benachbarten zweiten Inselbereichen 6 aus dem Form-Substrat 2, wobei zwischen den ersten Inselbereichen 5 und den jeweils zugeordneten, benachbarten zweiten Inselbereichen 6 eine Vertiefung 7 vorgesehen ist, Anordnen von Halbleiterstreifen 11 jeweils in der Vertiefung 7 zwischen einem ersten Inselbereich 5 und dem zugeordneten, benachbarten zweiten Inselbereich 6, so dass die Halbleiterstreifen 11 mit einer ihrer Oberflächen jeweils seitliche Oberflächen der Inselbereiche 5, 6 senkrecht zum Abdeckungssubstrat 4 mindestens teilweise abdecken, und Halbleiterstreifen 11 sich hinsichtlich der Vertiefung gegenüberliegen und zwischen den Halbleiterstreifen 11 ein Abstand ausgebildet ist, der einer verbleibenden Vertiefung 7 entspricht, Anordnen eines Trägersubstrats 9 auf den ersten Inselbereichen 5 und den zweiten Inselbereichen 6, die aus dem Form-Substrat 2 gebildet sind, so dass die ersten Inselbereiche 5 und die zweiten Inselbereiche 6 sich zwischen dem Trägersubstrat 9 und dem Abdeckungssubstrat 4 befinden, Tempern der verbundenen Substrate derart, dass ein Hineinfließen des Glasmaterials des Abdeckungssubstrats 4 in die verbleibenden Vertiefungen 7 zwischen den Inselbereichen 5, 6 bewirkt wird, und Entfernen des Abdeckungssubstrats 4 von dem Form-Substrat 2 und dem Trägersubstrat 9, um das strukturierte Deckelsubstrat 1 zu erhalten.

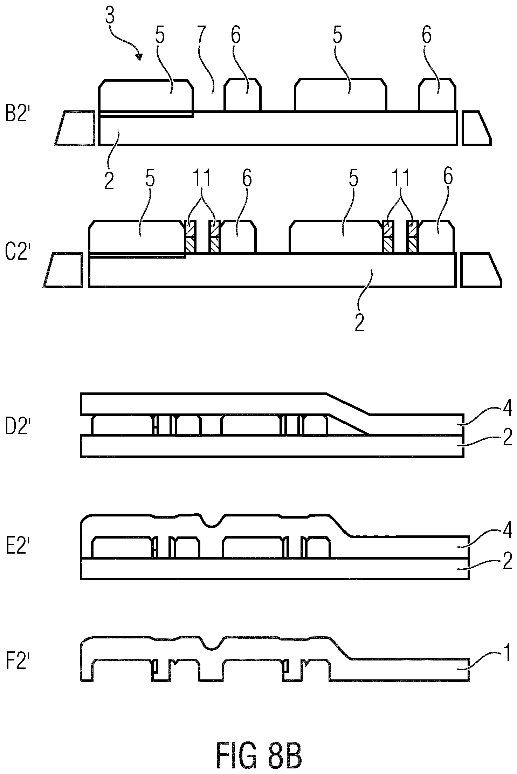

Fig. 8b zeigt nun eine Prozessvariante gemäß dem zweiten Verfahren zur Herstellung eines Deckelsubstrats unter Verwendung eines wiederverwendbaren Werkzeugs, bei der zwei parallele Siliziumstreifen 11 zur Definition von Fensterflächen (anstelle des Anordnens eines Fensterbauelements 8 auf dem wiederverwendbaren Werkzeug) verwendet werden. Die im Vorhergehenden anhand von Fig. 8a dargestellte Prozessvariante ist also entsprechend auf das anhand von Fig. 2 a - b dargestellte zweite Verfahren zur Herstellung eines Deckelsubstrats unter Verwendung eines wiederverwendbaren Werkzeugs anwendbar. Die obigen Ausführungen anhand von Fig. 2a-b und Fig. 8a sind also auch auf den nachfolgend anhand von Fig. 8b dargestellten Prozessablauf entsprechend anwendbar, wobei lediglich zu berücksichtigen ist, dass anstelle des Anordnens eines Fensterbauelements 8 auf dem wiederverwendbaren Werkzeug (vgl. Fig. 2a-b) bei dem Prozess von Fig. 8b zur Definition von Fensterflächen zwei parallele Siliziumstreifen 11 verwendet werden.

Das Verfahren zur Herstellung des Deckelsubstrats 1 unter Verwendung eines wiederverwendbaren Werkzeugs umfasst folgende Schritte.

Zunächst wird ein wiederverwendbares Werkzeugs als Form-Substrat 2 bereitgestellt (Schritt B2'), wobei erste Inselbereiche 5 und jeweils zugeordnete, benachbarte zweite Inselbereichen 6 an einer Oberfläche 3 des wiederverwendbaren Werkzeugs gebildet sind. Das Form-Substrat 2 ist als Negativ-Struktur für eine Deckelstruktur wirksam ist, wobei zwischen den ersten Inselbereichen 5 und den jeweils zugeordneten, benachbarten zweiten Inselbereichen 6 eine Vertiefung in dem wiederverwendbaren Wafer vorgesehen ist. Daraufhin werden Halbleiterstreifen 11 jeweils in der Vertiefung 7 zwischen einem ersten Inselbereich 5 und dem zugeordneten, benachbarten zweiten Inselbereich 6 angeordnet (Schritt C2'), so dass die Halbleiterstreifen 11 mit einer ihrer Oberflächen jeweils seitliche Oberflächen der Inselbereiche 5, 6 senkrecht zum Abdeckungssubstrat 4 mindestens teilweise abdecken, und Halbleiterstreifen 11 sich hinsichtlich der Vertiefung 7 gegenüberliegen und zwischen den Halbleiterstreifen 11 ein Abstand ausgebildet ist, der einer verbleibenden Vertiefung 7 entspricht.

Ferner wird ein Abdeckungssubstrat 4 auf den Inselbereichen 5, 6 des wiederverwendbaren Werkzeugs 2 angeordnet (Schritt D2'), wobei das Abdeckungssubstrat 4 ein Glasmaterial aufweist. Dabei wird die Oberfläche 3 des wiederverwendbaren Werkzeugs mit einer Oberfläche des Abdeckungssubstrats mindestens teilweise überdeckend zusammengeführt wird.

Die verbundenen Substrate werden derart getempert (Schritt E2'), dass ein Hineinfließen des Glasmaterials des Abdeckungssubstrats 4 in die Vertiefungen 7 zwischen den Inselbereichen 5, 6 bewirkt wird. Das Abdeckungssubstrats 4 wird von dem Form-Substrat 2 getrennt bzw. entfernt, um das strukturierte Deckelsubstrat 1 zu erhalten.

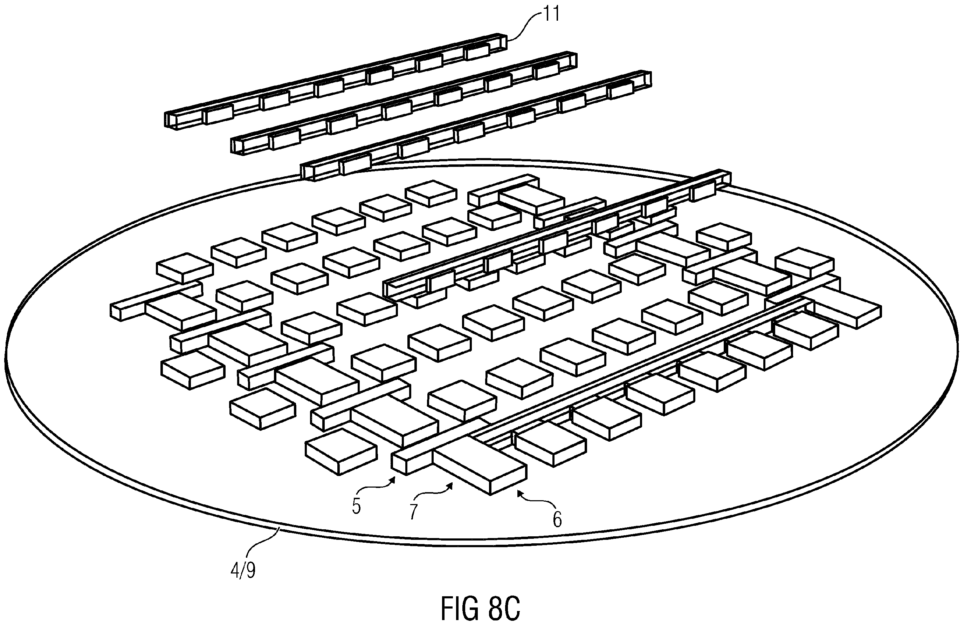

Fig. 8c zeigt nun das Einlegen der Streifen 11, d.h. das Anordnen von Halbleiterstreifen 11 jeweils in der Vertiefung 7 zwischen einem ersten Inselbereich 5 und dem zugeordneten, benachbarten zweiten Inselbereich 6 an dem Abdeckungssubstrat 4 bzw. Trägersubstrat 9.

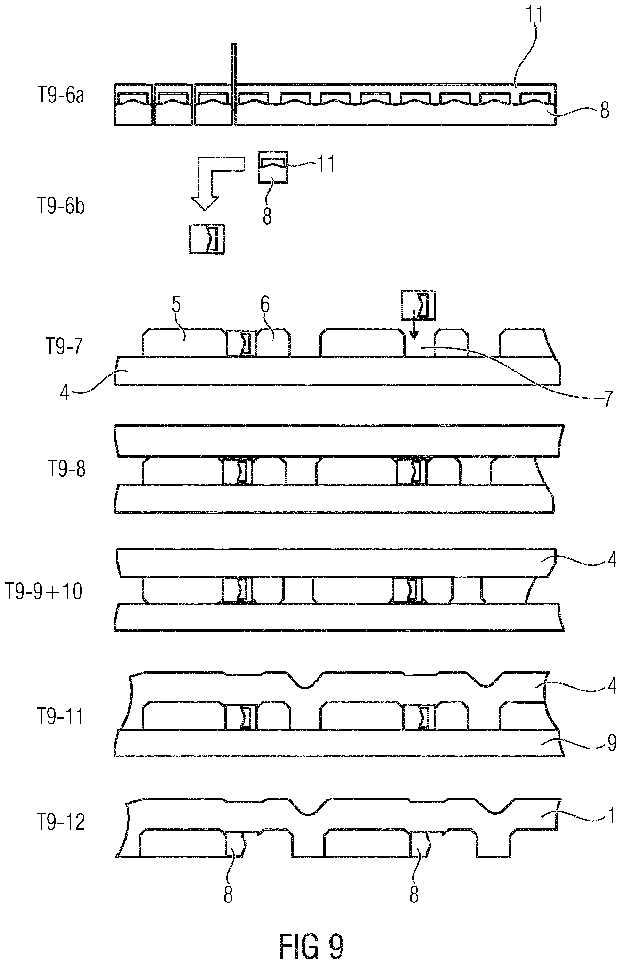

Fig. 9 zeigt eine Prozessvariante, bei der optische Linsen aus Glas anstelle eines ebenen Fensterbauelements 8 eingebaut werden. Diese Prozessvariante ist sowohl für das erste Verfahren wie auch für das zweite Verfahren möglich. Das Anordnen des Fensterbauelements umfasst dann in Ausführungsformen den Schritt: Zuschneiden jeweils von streifenförmigen Fensterbauelementen aus einem Linsenarray. Grundsätzlich lässt sich anstelle eines einfachen ebenen Fensters auch ein Linsenelement in das Glas des Gehäuses einbetten. Diese Linsenfunktion kann beispielsweise entweder aus einer Reihe von Linsen (d.h. lineares Linsenarray) oder einer einzelnen Zylinderlinse bestehen, wenn diese parallel zur Ausrichtung des Glasstreifens orientiert ist. Im Unterschied zu den ebenen Glaselementen, die für die Herstellung der ebenen Glasfenster eingesetzt werden, ist es allerdings erforderlich, zusätzlich die nicht planen Seiten der Linsen durch ein zusätzliches Schutzelement 13 aus einem Halbleitermaterial, beispielsweise Silizium, gegen den direkten Kontakt mit der Glasmasse, also dem Glasmaterial des Abdeckungssubstrats 4, zu schützen. Diese Schutzstruktur 13 überbrückt auf der einen Seite die Linsenoberfläche und sorgt auf der anderen Seite für eine möglichst gute Passung mit den auf dem Glaswafer platzierten Siliziumstrukturen, um auch hier ein unkontrolliertes Hineinfließen des Glases in diesen Spalt zu vermeiden. Am einfachsten lassen sich solche Linsenarray-Siliziumelemente durch die bereits angesprochene Technik des Glasfließens ausformen, wenn ein höherschmelzendes Glas, wie z.B. "AF 32"® oder "Eagle XG"®, mit einem an Silizium bzw. Borofloat®-Glas angepassten thermischen Ausdehnungskoeffizienten verwendet wird. Grundsätzlich ist diese Technik auf unter der Verwendung von bikonvexen oder bikonkaven Linsen möglich. In diese Fall werden beide Seiten der Linsen durch entsprechende Siliziumstrukturen 13 gegen den direkten Kontakt mit dem Glas geschützt. Gemäß Teilschritt T9-6a erfolgt ein Zuschneiden, hier Sägen, von Streifen aus einem Linsenarray, das auf Siliziumstrukturen gebondet ist, die die inneren Linsenflächen überspannen. Teilschritt T9-6b zeigt, dass ein Drehen zur Seite um 90° entlang der Längsachse des Streifens und Bestücken erfolgt, wobei zusätzliche Justagestrukturen das präzise Bestücken erleichtern können und die Strukturen während des Prozesses gegen Verrutschen und Umfallen sichern können.

Gemäß Teilschritt T9-7 erfolgt ein Einlegen der Linsenstreifen aus T9-6b, wobei die Siliziumstrukturen wie ein Steckbrett genutzt werden, so dass die Fensterflächen genau in die Strukturen passen. Die seitlichen Inseln dienen also als "Anschläge". Gemäß Teilschritt T9-7 erfolgt ein Auflegen eines weiteren Halbleiterwafers, also eines Trägerwafers, bei dem es sich in diesem Fall um einen Siliziumwafer handelt. Der weitere Halbleiterwafer wird auf die ersten Inselbereiche und die zweiten Inselbereiche aufgelegt, so dass er die Vertiefungen 7, in denen die Linsenstreifen, also die Fensterbauelemente, angeordnet sind, abdeckt. In den Teilschritten T9-9 und T9-10 erfolgt ein Umdrehen des Waferstacks, ein Auflegen eines Belastungsrings 12, eine Vakuumtemperung, bei der der Wafer hermetisch dicht verschlossen wird, und ein Entfernen der Druckauflage 12. Gemäß dem Teilschritt T9-11 erfolgt dann im Weiteren eine Temperung unter Atmosphärendruck, wodurch die Glasmasse in die großen Zwischenräume einfließt. Schließlich erfolgt im Teilschritt T9-12 ein Abätzen der Siliziumstrukturen selektiv zu den Glasstrukturen, in der Regel, so wie auch in diesem konkreten Ausführungsbeispiel, mittels KOH.

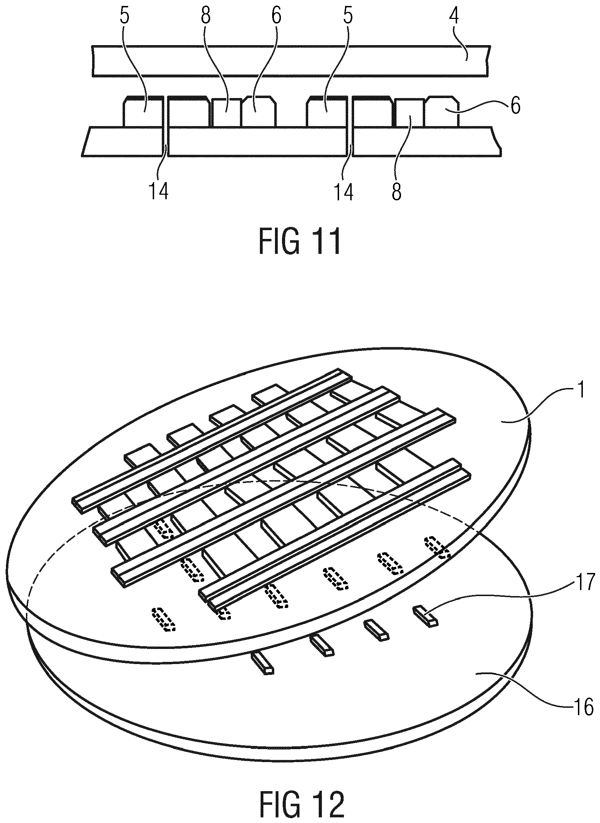

Im Folgenden wird nun genauer auf das zweite Verfahren gemäß Fig. 2a und 2b eingegangen. Das oben im Detail beschriebene erste Verfahren nutzt letztendlich Halbleiterstrukturen, beispielsweise Siliziumstrukturen, als verlorene Form, um das Glas zu formen. Grundsätzlich lassen sich, wie beim zweiten Verfahren, jedoch auch Formen so herstellen, die viele Male genutzt werden können, um den Deckelwafer zu prozessieren. Hierzu kommen natürlich lediglich Materialien oder Beschichtungen in Frage, die, wie bereits erwähnt, nicht mit dem Glas eine innige Verbindung eingehen und die sich leicht wieder vom Glas trennen lassen. Dazu kann eine Grundform 2, beispielsweise aus Graphit, hergestellt, also mit ersten und zweiten Inselbereichen versehen werden, und ganz analog zum ersten Verfahren nach Fig. 1 um 90° gedrehte Glasstreifen 8 in die Strukturen eingelegt werden. Anschließend wird ein Glaswafer, also ein Abdeckungssubstrat 4, aufgelegt, der ganze Aufbau erhitzt und schließlich mittels beispielsweise von Unterdruck in die wiederverwendbare Form, beispielsweise die Graphitform, gezogen. Entsprechend kann das Verfahren beim Tempern den folgenden Schritt umfassen: Anlegen eines Unterdrucks an die verbundenen Substrate, um das Glasmaterial in die verbleibenden Vertiefungen zwischen den Inselbereichen hineinzuziehen. Dazu werden in der wiederverwendbaren Form 2, beispielsweise der Graphitform, zuvor geeignete Zugänge und Kanäle geschaffen, die ein vollständiges Entfernen der Luft zwischen Glaswafer und Form sicherstellen. Beispielsweise sind die wiederverwendbaren Formen 2, die in den Fig. 10 und 11 gezeigt sind, entsprechend eingerichtet. Anschließend wird der Glaswafer 1 mit den eingebetteten Glasstreifen, also den Fensterbauelementen 8, von der Form 2 abgehoben und getrennt.

Es ist klar ersichtlich, dass die gleichen Prozessvarianten wie im ersten Verfahren auch hier abgeleitet werden können, d.h. anstelle der Glasstreifen aus höherschmelzenden Gläsern kommen auch hier wieder Si-Glas-Si-Streifen oder auch nur zwei parallele Siliziumstreifen in Betracht. Auch hier ist es erforderlich, die kavitätsseitig eingesetzten Siliziumstreifen oder Auflagen zuvor ganz analog zum ersten Verfahren so zu strukturieren, dass die die Gehäusewandung durchziehenden Siliziumstrukturen beim abschließenden Ätzen des Siliziums keine Löcher in den gehäusewänden oder tiefe Gräben im Bereich der Bondrahmen hervorrufen (d.h. beispielsweise Kammstrukturen bei Verwendung der Si-Streifen, Kammstrukturen und Streifen im Falle der Si-Glas-Si-Elemente).

Im Unterschied zum oben beschriebenen Prozess mit eingebetteten Glasstreifen wird bei der Verwendung von Siliziumstrukturen der Glaswafer nochmals geätzt, um das Silizium im Bereich der Fensterfläche zu beseitigen (Prozess mit teilweise verlorener Form). Dabei sollte jedoch die Prozesszeit beim Ätzen so angepasst werden, dass das Silizium im Bereich der Gehäusewandungen nicht entfernt wird.

Alternativ zu einer Form 2, die vollständig aus Graphit besteht, kommen auch andere Materialien für die Herstellung einer solchen Form für das zweite Verfahren prinzipiell in Frage, unter anderem temperaturfeste Stähle und Keramiken (beispielsweise SiC, Glaskohlenstoff), insbesondere dann, wenn diese Formen zusätzlich mit einer Beschichtung versehen werden, die ein Ankleben der Glasmasse verhindert (z.B. Graphit oder besser noch Bornitrid (BN)). Durch das Aufbringen einer solchen Glas abweisenden Schutzschicht kann, wie bereits erwähnt, grundsätzlich auch eine solche Form aus Silizium gefertigt werden.

Fig. 10 veranschaulicht Teilschritte des zweiten Verfahrens zur Herstellung eines Deckelsubstrats anhand von Skizzen. Gemäß Teilschritt T10-1 erfolgt ein Bereitstellen der Form, hier als Beispiel eine Form gefertigt aus Graphit. Gemäß Teilschritt T10-1a erfolgt ein Zuschneiden (Sägen) von Streifen des eigentlichen Fenstermaterials 8 (höherschmelzendes Glas, ideal Material mit identischem thermischen Ausdehnungskoeffizienten wie "AF 32"® (Schott) oder "Eagle XG"® (Corning®). Gemäß Teilschritt T10-1b erfolgt ein Drehen zur Seite und Bestücken. In T10-b II kann anstelle eines höherschmelzenden Glasmaterials auch Borofloat®-Glas (niedrigschmelzendes Glas) eingesetzt werden, das durch zwei Siliziumauflagen in dessen Form gehalten wird. Gemäß Teilschritt T10-2 erfolgt ein Einlegen der Glasstreifen aus T10-1, wobei die Strukturen wie ein Steckbrett genutzt werden, so dass die Fensterflächen genau in die Strukturen passen (seitliche Inseln als Anschläge). Gemäß Teilschritt T10-3 erfolgt ein Auflegen eines Glaswafers, also eines Abdeckungssubstrats. Es besteht in diesem Ausführungsbeispiel aus Borofloat®-Glas. Gemäß Teilschritt T10-4 erfolgt ein Erhitzen, also Tempern, bis zum Erweichen des Glases, der Aufbau eines Unterdrucks, das hineinziehen des Glases in die Strukturen, und somit das Einbetten der Glasstreifen in die Glasmatrix des Borofloat®-Glases des Abdeckungssubstrats 4. Gemäß Teilschritt T10-5 erfolgt dann ein Entstücken der Form, also die Entnahme des Deckelwafers 1 mit integrierten Fensterflächen 8, also optischen Auskoppelfenstern. Gemäß einem nicht gezeigten Teilschritt T10-6 kann noch gegebenenfalls eine Nachbearbeitung erfolgen, wenn Siliziumstrukturen zum Einsatz kamen, insbesondere auf Flächen der Fensterbauelementen, d.h. Abätzen des Siliziums im Bereich der Fensterflächen.

Das zweite Verfahren kann dementsprechend beispielsweise die Merkmale haben:
1. Verwendung einer Form für das Tiefziehen von Glas, die inselartige Strukturen trägt, die als Steckbrett dienen und Vakuumzugänge und Vakuumkanäle beinhaltet.
2. Die Form besteht aus einem hochtemperaturfesten Material, das entweder selbst keinen Kontakt mit dem heißen Glas eingeht (z.B. Graphit, Glaskohlenstoff, SiC, BN, Keramiken) oder mit einem solchen Material beschichtet wurde.
3. Das Einsetzen streifenförmig angeordneter Glas- oder Glassiliziumstrukturen (siehe T10-1b II in diese Strukturen.
4. Das Drehen dieser Glas- oder Glassiliziumstrukturen um beispielsweise 90° beim Einsetzen, um die "guten" optischen Flächen vertikal auszurichten.
5. Die Verwendung dieser Strukturen als Schutzstrukturen, um einen direkten Kontakt an den optischen Flächen mit der Glasmasse des Glaswafers, also dem Glasmaterial der Abdeckungsschicht, zu vermeiden, was entsprechend kleine Spaltmaße voraussetzt (ca. 50 µm und kleiner, beispielsweise 20 µm bis 50 µm, streng genommen sind die Aspektverhältnisse ausschlaggebend, die Glasmasse braucht sehr lange, um sehr kleine Spalten füllen zu können, erfahrungsgemäß lassen sich Kanäle mit nur einigen wenigen 10 µm Breite nicht mehr auffüllen. Abstände von 10 µm sollten daher nur in sehr geringem Maße durch das Glas erreicht werden können.).
6. Das Hineinziehen der Glasmasse durch Anlegen eines Unterdrucks auf Seiten der Form
7. oder alternativ das Einwirken eines pneumatischen oder mechanischen Drucks auf Seiten der aufliegenden Glasplatte, respektive des Glaswafers, also des Abdeckungssubtrats.

Fig. 11 zeigt unter anderem ein wiederverwendbares Form-Substrat 2, das Vakuumkanäle 14 aufweist, für das zweite Verfahren. Idealerweise sollten die Vakuumanschlüsse und Kanäle so angeordnet werden, dass das Glas, dass, wenn auch oberflächlich in diese Strukturen hineinfließt, die Gehäuse in deren Funktion nicht beeinträchtigt. So sollte insbesondere vermieden werden, dass sich Erhebungen im Bereich eines Bondrahmens 15 bilden. Deswegen bietet es sich an, die Vakuumzuführungen 14 in die Inselstrukturen 5, 6 zu integrieren, und um eine bessere Absaugung der verbliebenen Gaseinschlüsse zu erleichtern, zusätzlich schmale Kanäle in die Oberfläche dieser Inselstrukturen einzubringen. Das heißt, dass Vakuumzuführungen 14 und Kanäle in unkritischen Bereichen angeordnet werden sollten. Insbesondere sollte das Entstehen von unerwünschten Erhebungen, etwa durch das Eindringen der Glasmasse in Vakuumöffnungen, unbedingt vermieden werden. Vakuumzuführungen 14 und Kanäle sollten daher in die Inseln integriert werden, wie es in Fig. 11 veranschaulicht ist, da deren Oberflächen später im Gehäuse keine kritische Funktion mehr zukommt.

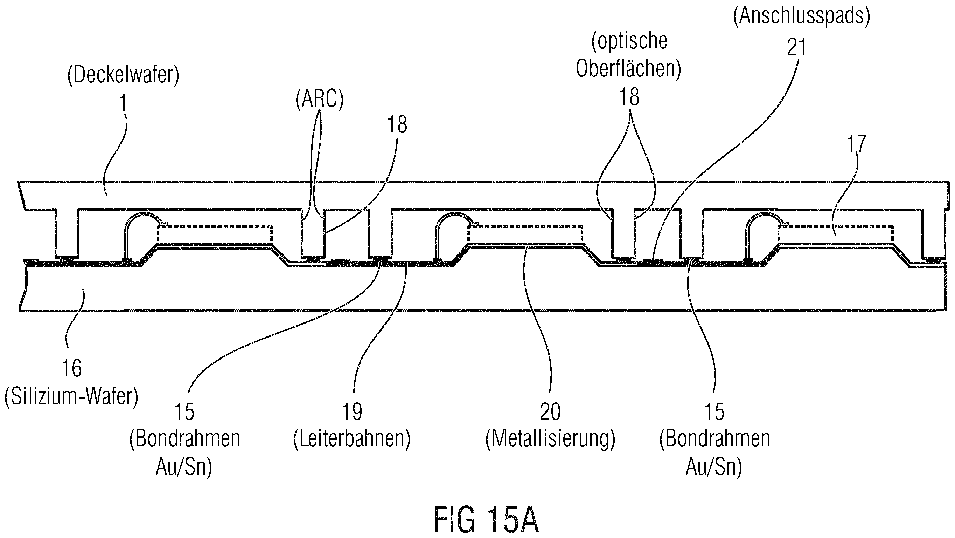

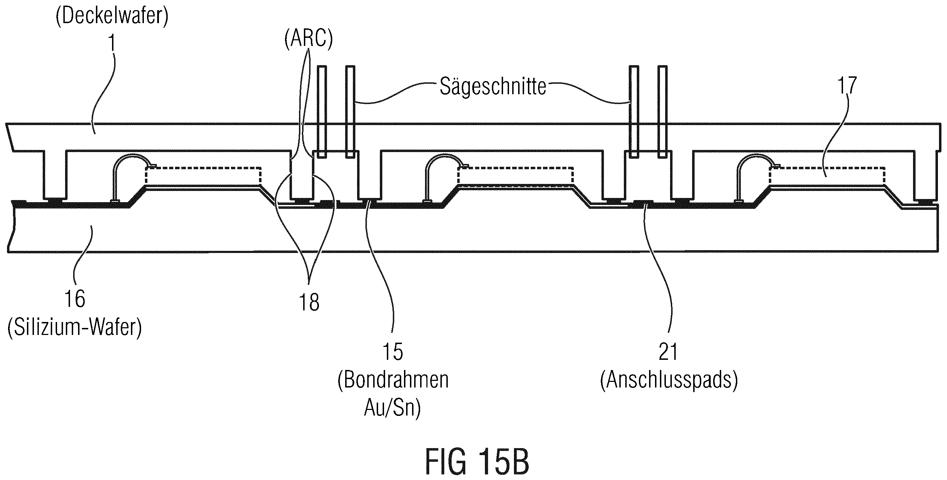

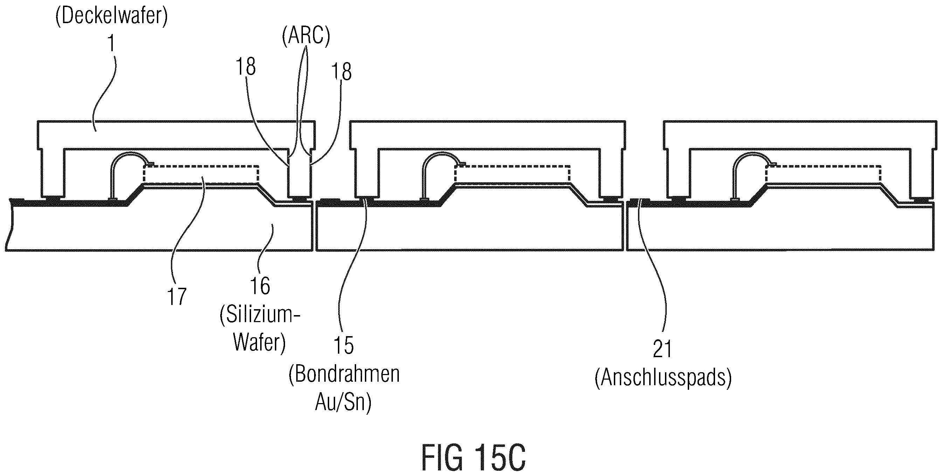

Schließlich wird das Deckelsubstrat 1 zur weiteren Verwendung noch geeignet aufgebaut, was ein Freilegen des optischen Zugangs bzw. optischen Auskoppelfensters einschließt. Nach der eigentlichen Herstellung des Deckelwafers gemäß dem ersten Verfahren oder dem zweiten Verfahren oder ihren Variationen kann noch eine Entspiegelungsschicht, auch ARC-Schicht (anti-reflective coating) genannt, aufgebracht werden. Da die relevanten optischen Flächen vertikal angeordnet sind, können dafür beispielsweise CVD (Chemical Vapor Deposition) Prozesse eingesetzt werden, da PVD (Physical Vapor Deposition, Aufdampfen oder Sputtern) Prozesse in der Regel vertikale Flächen nur sehr unvollkommen beschichten können. CVD Prozesse erlauben hingegen die konforme Abscheidung der dazu nötigen Schichtfolgen. Derart beschichtete optische Flächen sind beispielhaft in den Figuren 15, 16 und 19 gezeigt.

Der Deckelwafer 1 wird schließlich im Bereich der Gehäuseauflagen, an denen er mit einem Bauelementesubstrat 16 verbunden werden soll, mit dem Bondrahmen 15 versehen. Dieser Rahmen 15 besteht in der Regel aus einem lötfähigen Material, also beispielsweise entweder aus einem niedrigschmelzenden Glaslot oder einem metallischen Lot, jedoch mindestens einer lötfähigen Metallisierung. Die hermetische Verkappung sollte dabei vorzugsweise mit einem metallischen Bondsystem bei Temperaturen unterhalb 300° C durchgeführt werden, um die Bauteillage bereits vorhandener Bauelemente unterhalb des Deckels nicht zu verändern.

Auf einem Halbleitersubstrat, das als Bauelementesubstrat 16 dient, das über entsprechende Lotflächen, Leiterbahnen, Anschlusspads und Bondrahmen verfügt, beispielsweise einem Siliziumsubstrat, werden strahlungsemittierende Bauelemente, beispielsweise Laserdioden mitsamt Submounts (Unterbau, der als Abstandshalter und Wärmesenke dient) auf die vorbereiteten Lotflächen aufgelötet. Das Bauelementesubstrat 16 soll vorzugsweise aus Silizium bestehen, um eine gute Wärmeableitung und geringe thermische Dehnung zu gewährleisten.

Dabei werden strahlungsemittierende Bauelemente 17, beispielsweise grüne oder blaue Laserdioden, so auf den Wafer 16 orientiert, dass deren Austrittsflächen den optischen Fenstern des Deckelwafers, also des Deckelsubstrats 1, gegenüberliegen werden. Anschließend werden die Kontakte mittels Drahtbonden sowohl auf die Laserdiode als auch auf deren Submount gesetzt und mit den dazu passenden Leiterbahnen verbunden.

Nach vollständiger Bestückung des Bauelementesubstrats 16 kann der Wafer anschließend noch auf Waferebene mit dem Deckelwafer, also dem Deckelsubstrat 1, gebondet werden. Damit wird ein hermetisch dichtes Verschließen aller Gehäuse auf dem Wafer in einem einzigen Prozess erreicht. Um eine kontrollierte Innenatmosphäre in den einzelnen Gehäusen zu gewährleisten, findet der Bondprozess in Ausführungsformen unter einer definierten Atmosphäre in einem speziellen Waferbonder statt.

Nach dem hermetischen Verschluss aller Gehäuse ist es erforderlich, die Fensterflächen erst wieder zugänglich zu machen. Dies geschieht am zweckmäßigsten durch Einsägen in die Vertiefung des Glaswafers außerhalb der Gehäusekavitäten. Dazu werden in Ausführungsformen zwei parallele Schnitte so gesetzt, dass das dadurch entstehende streifenförmige Glaselement einfach herausfällt, was man als "Cap Dicing" bezeichnet. Dabei können auch die Bondpads des nächsten Chips freigelegt werden. Nach Entfernen dieser Glaselemente kann daher der gesamte Wafer elektrischen Tests unterzogen werden, was besonders vorteilhaft ist, da hierfür geeignete Wafertester kommerziell erhältlich sind (bessere Logistik durch Testbarkeit auf Waferebene, was eine automatisierte elektrische Vermessung deutlich vereinfacht). Ganz zum Schluss erfolgt das komplette Vereinzeln des Wafers auf der Wafersäge.

Aus dem vorstehend beschriebenen folgt somit ein Verfahren zur Herstellung eines gehäusten strahlungsemittierenden Bauelements 17 auf Waferebene, mit folgenden Schritten: Herstellen eines Deckelsubstrats 1, Bereitstellen eines Bauelementesubstrats 16 in Form eines Wafers mit einer Vielzahl von strahlungsemittierenden Bauelementen 17, Anordnen der Substrate aufeinander, so dass die Substrate entlang eines zwischengeschalteten Verbindungsrahmens 16 verbunden werden, und Vereinzeln der gehäusten strahlungsemittierenden Bauelemente 17. Zudem kann das Verfahren folgende Schritte umfassen: Herstellen des Deckelsubstrats 1 gemäß des eben beschriebenen ersten Verfahrens oder des zweiten Verfahrens und Vereinzeln der gehäusten strahlungsemittierenden Bauelemente, wobei durch die zweiten Inselbereiche 6 in dem Deckelsubstrat 1 eine Vereinzelungsstraße gebildet worden ist. Außerdem kann das Verfahren zur Herstellung eines gehäusten strahlungsemittierenden Bauelements auf Waferebene, derart ablaufen, dass das Anordnen der Substrate unter einer vorgegebenen Atmosphäre erfolgt. Das Verfahren zur Herstellung eines gehäusten strahlungsemittierenden Bauelements auf Waferebene wird anschaulicher unter Betrachtung von Fig. 12.

Fig. 12 zeigt eine Skizze, die einen Teilschritt aus einem Verfahren zur Herstellung eines gehäusten strahlungsemittierenden Bauelements auf Waferebene veranschaulicht. Der fertige Glasdeckel 1 wird für die Verkappung der aufgebauten Laserdioden so in Position gebracht, dass die Laserdioden samt deren Unterbau in die Kavitäten des Deckelwafers, also des Deckelsubstrats 1, eintauchen. Nicht eingezeichnet sind in Fig. 12 die Bondframes 15 um die einzelnen Ränder der Kavitäten, die erst eine hermetisch dichte Versiegelung der Gehäuse garantieren. Zur Vereinfachung werden auch die Verdrahtungen der Laserdioden und die Anschlusspads nicht gezeigt.

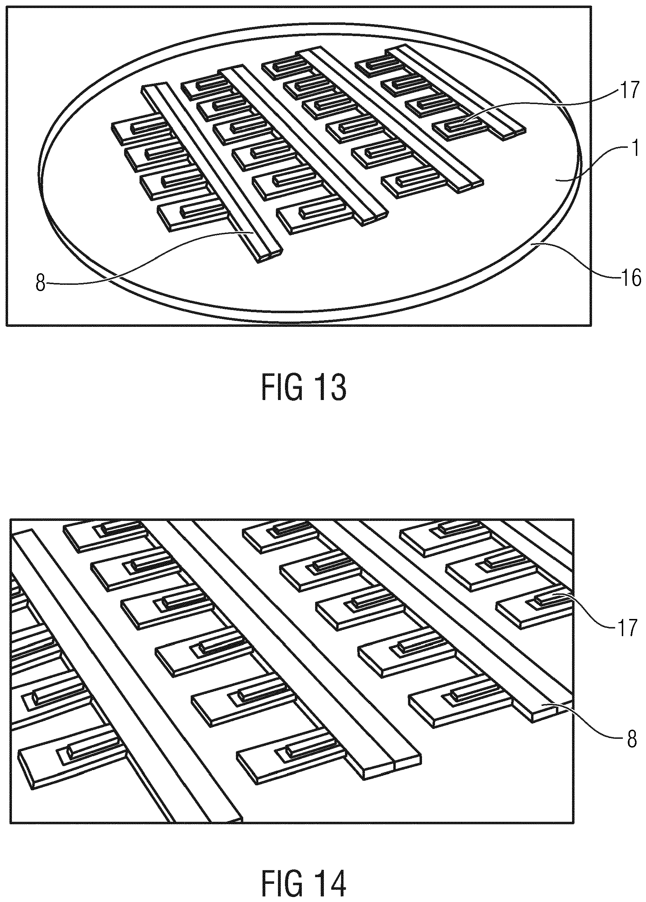

Fig. 13, zeigt einen Wafer mit einer Vielzahl von eingehäusten strahlungsemittierenden Bauelementen. Der Aufbau umfasst ein Deckelsubstrat 1 und ein Bauelementesubstrat 16. Fig. 14 zeigt einen Ausschnitt des Wafers aus Fig. 13. Die optischen Austrittsflächen der Laserdioden 17, die auf dem Bauelementesubstrat angeordnet sind, sind, wie man hier besser erkennen kann, auf das optische Auskoppelfenster 8 gerichtet.

Fig. 15a bis 15c veranschaulichen ein Vereinzelungsverfahren für einen Wafer gemäß Fig. 13. Fig. 15a zeigt einen Querschnitt durch einen fertig aufgebauten und gebondeten Wafer. Gezeigt sind optische Oberflächen 18, von denen einige entspiegelt beschichtet sind, Leiterbahnen 19, eine Metallisierung 20, ein Siliziumsubstrat als Bauelementesubstrat 16, ein Deckelwafer 1, Anschlusspads 21 und Bondrahmen 15 aus Au/Sn. Durch paralleles Einsägen können, wie in Fig. 15b gezeigt, die Bereiche über den Anschlusspads freigelegt werden. Dabei werden auch die Bereiche der äußeren Fensterflächen zugänglich gemacht. Die Streifen, die durch das Einsägen zwischen den beiden Sägeschnitten entstehen, lösen sich während des Sägens vollständig ab. In diesem Stadium können noch auch Waferebene elektrische Tests auf einem Waferprober durchgeführt werden, wie oben beschrieben. Abschließend folgt das Vereinzeln des Bauelementesubstrats 16 durch Sägen, wie in Fig. 15c zu erkennen ist. Die Erfindung stellt also eine Waferanordnung mit einer Vielzahl von gehäusten strahlungsemittierenden Bauelementen 17, wie sie in Fig. 15a im Querschnitt oder auch in Fig. 13 in der Aufsicht gezeigt ist, mit folgenden Merkmalen bereit: Einem Bauelementesubstrat 16 in Form eines Wafers, der als gemeinsames Bauelementesubstrat 16 für die daran angeordneten strahlungsemittierenden Bauelemente 17 ausbildet ist und einem gemeinsamen Deckelsubstrat 1, das die Deckelsubstrate 1 für die strahlungsemittierende Bauelemente 17 aufweist, wobei die Substrate 1, 16 so aneinander geordnet sind, dass das Deckelsubstrat 1 und das Bauelementesubstrat 16 entlang eines dazwischenliegenden Bondrahmens 15 verbunden sind.

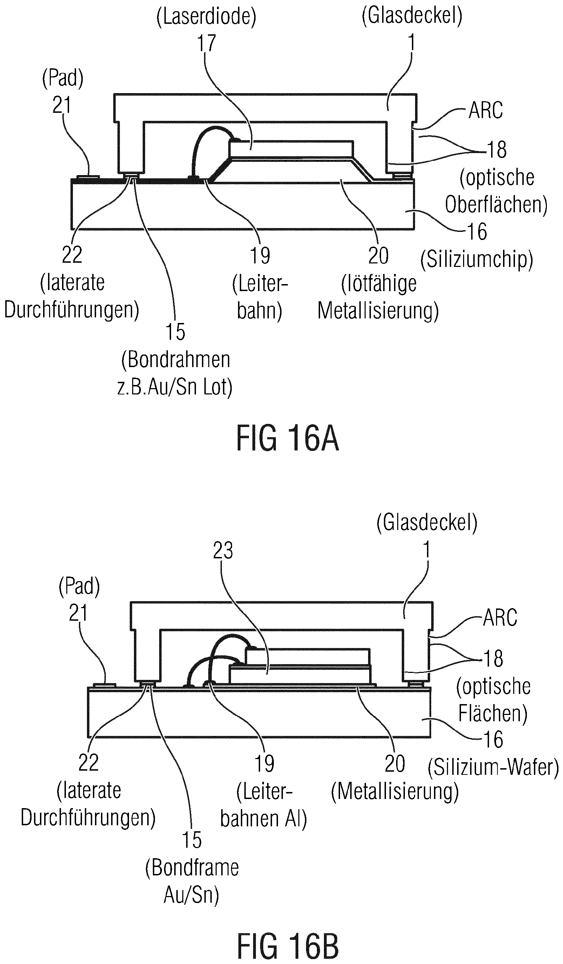

Auf diese Weise erhält man ein verbessertes gehäustes strahlungsemittierendes Bauelement, das nach dem vorgenannten Verfahren hergestellt ist. Verschiedene Ausführungsformen derartiger gehäuster Bauelemente sind in den Fig. 16 bis 18 gezeigt.

Fig. 16 a und b zeigen erste und zweite Ausführungsformen für gehäuste strahlungsemittierende Bauelemente, die mit einem erfindungsgemäßen Verfahren hergestellt worden sind. Gemäß Figur 16a ist das strahlungsemittierende Bauelement 17 mittels einer lötfähigen Metallisierung 20 unmittelbar auf dem Bauelementesubstrat 16 angeordnet. Die Metallisierung 20 ermöglicht eine verbesserte thermische Kopplung und somit eine gute Wärmeableitung auf das Bauelementesubstrat 16. Das strahlungsemittierende Bauelement 17 ist mit einer Leiterbahn 19 elektrisch verbunden. Eine laterale Durchführung 22 verbinden die Leiterbahn 19 mit einem Anschlusspad 21 außerhalb der Kavität, in der das strahlungsemittierende Bauelement 17 angeordnet ist. Die laterale Durchführung 22 ist zwischen dem Deckelsubstrat und dem Bauelementesubstrat 17 im Bereich des Bondrahmens 15, der wiederum ein Au/Sn-Bondrahmen ist, durchgeführt. Das optische Auskoppelfenster des Glasdeckels ist mit entspiegelten optischen Oberflächen 18 versehen. Fig. 16b zeigt eine Abwandlung der Ausführungsform aus Fig. 16a, bei der ein Zwischenträger 23 zwischen dem strahlungsemittierenden Bauelement 17 und dem Bauelementesubstrat 16 angeordnet ist, was sich auf die thermische Ankopplung auswirken kann. Die Erfindung stellt also, wie beispielsweise in Fig. 16a und 16b gezeigt, ein gehäustes strahlungsemittierendes Bauelement mit folgenden Merkmalen bereit: Einem an einem Bauelementesubstrat 16 angeordneten strahlungsemittierendes Bauelement 17 und einem Deckelsubstrat 1, das eine hermetisch abgedichtete Kavität für das strahlungsemittierende Bauelement 17 bereitstellt, innerhalb welchem das strahlungsemittierende Bauelement 17 gehäust ist, wobei das Deckelsubstrat 1 in einer Seitenfläche ein optisches Auskoppelfenster aus einem für die Strahlung des strahlungsemittierenden Bauelements 17 durchlässigen Material aufweist, wobei das optische Auskoppelfenster des Deckelsubstrats 1 und das strahlungsemittierende Bauelement 17 derart zueinander angeordnet sind, dass die im Betrieb des strahlungsemittierenden Bauelements 17 emittierte Strahlung das Gehäuse in einer Abstrahlrichtung parallel zur Oberfläche des Bauelementesubstrats 16 und/oder senkrecht zu der Seitenfläche des Deckelsubstrats 1 verlässt. Das gehäuste strahlungsemittierende Bauelement ist in diesem Ausführungsbeispiel derart ausgeführt, dass das Bauelementesubstrat 16 als ein Gehäusesockel und als eine Lagerfläche für das strahlungsemittierende Bauelement 17 dient, wobei das Deckelsubstrat 1 mit dem Gehäusesockel zusammenwirkt, um die Kavität des Gehäuses hermetisch abzudichten. In diesem Ausführungsbeispiel nach Fig. 16a und Fig. 16b ist das gehäuste strahlungsemittierende Bauelement zudem derart ausgeführt, dass der Gehäusesockel aus einem Sockelwafer, der mehrere Gehäusesockel umfasst, gebildet wurde und das Deckelsubstrat 1 aus einem Deckelwafer, der mehrere Deckelsubstrate 1 umfasst, gebildet wurde. Es wurde nämlich aus einem Waferstapel gemäß Fig. 13 vereinzelt. Zudem ist das gehäuste strahlungsemittierende Bauelement derart ausgeführt, dass das Deckelsubstrat 1 einen oder mehrere ebene Wandabschnitte als Seitenfläche aufweist, so dass entweder ein ebener Wandabschnitt das optische Auskoppelfenster aufweist oder aber das optische Auskoppelfenster einen ebenen Wandabschnitt des Deckelsubstrats 1 bildet. Letzteres ist in den Fig. 16a und 16b anhand der ebenen optischen Flächen 18 zu erkennen. Außerdem ist das gehäuste strahlungsemittierende Bauelement derart ausgeführt, dass das optische Auskoppelfenster mit dem Deckelsubstrat 1 stoffschlüssig verbunden ist. Dies folgt daraus, dass das Fensterbauelement 8 entsprechend mit dem Abdeckungssubstrat 4 verbunden wurde.

In Figur 16b ist das gehäuste strahlungsemittierende Bauelement zudem derart ausgeführt, dass zwischen dem Bauelementesubstrat 16 und dem strahlungsemittierenden Bauelement 17 ein Zwischenträger 24 für das strahlungsemittierende Bauelement 17 angeordnet ist, so dass das Bauelementesubstrat 16 das strahlungsemittierende Bauelement 17 mittelbar trägt. Das gehäuste strahlungsemittierende Bauelement 17 ist außerdem derart ausgeführt, dass das Bauelementesubstrat 16 und das Deckelsubstrat 1 mittels eines Bondrahmens 15, der ein metallisches Lotmaterial, in diesem Fall Au/Sn, aufweist, aneinander befestigt sind. Weiterhin ist das gehäuste strahlungsemittierende Bauelement derart ausgeführt, dass das optische Auskoppelfenster aus einem ersten Glasmaterial gebildet ist und das Deckelsubstrat 1 aus einem zweiten Glasmaterial gebildet ist, wobei das zweite Glasmaterial eine niedrigere Viskosität aufweist als das erste Glasmaterial. Außerdem ist in den Ausführungsformen gemäß den Figuren 16a und 16b das gehäuste strahlungsemittierende Bauelement 17 derart ausgeführt, dass eine Leiterbahn 19 zum elektrischen Anbinden des strahlungsemittierenden Bauelements 17 seitens des Bauelementesubstrats 16 angeordnet ist und die Leiterbahn 19 zwischen dem Deckelsubstrat 1 und dem Bauelementesubstrat 16 aus der Kavität herausgeführt ist. Das gehäuste strahlungsemittierende Bauelement ist in Fig. 16a und 16b also somit derart ausgeführt, dass die Kavität eine inerte Atmosphäre aufweist und die Kavität ausschließlich anorganische Substanzen enthält.

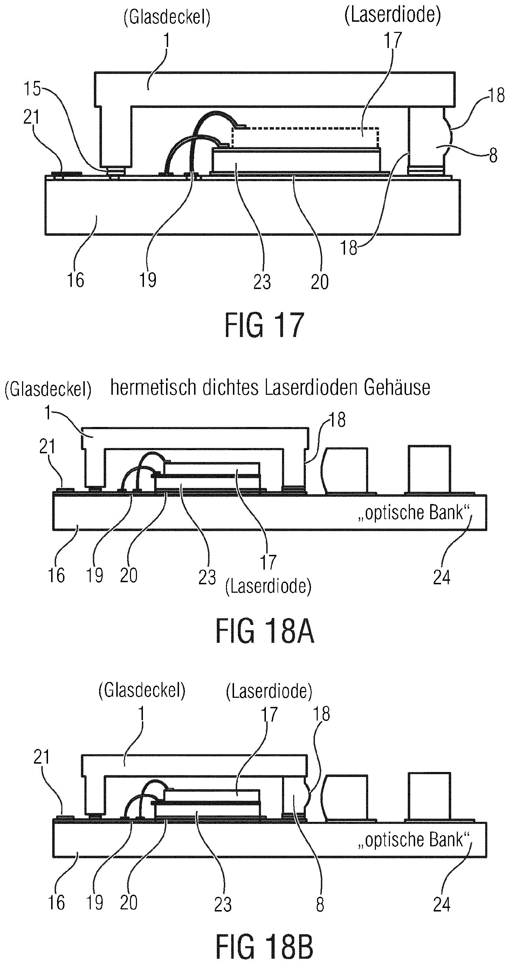

Fig. 17 zeigt eine dritte Ausführungsform für gehäuste strahlungsemittierende Bauelemente, die mit einem erfindungsgemäßen Verfahren hergestellt worden ist. Bei ihr handelt es sich um ein hermetisches Lasergehäuse mit integrierter Linse als optische Oberfläche 18. Erneut ist ein strahlungsemittierendes Bauelement 17 über einen Zwischenträger 23 mit einem Bauelementesubstrat 16 mechanisch verbunden und über Leiterbahnen 19 mit einem Anschlusspad 21 außerhalb der Kavität verbunden.

Wie bereits oben ausgeführt bezieht sich die Erfindung auf eine Aufbautechnik und ein hermetisches Verkappungskonzept für strahlungsemittierende Bauelemente, beispielsweise LD und Laserdioden. Die Neuartigkeit liegt dabei insbesondere, wie beschrieben, auf der Integration eines vertikalen optischen Fensters, das integraler Bestandteil der Kappe ist und eine laterale Strahlauskopplung erlaubt. Ein weiterer sehr wichtiger Aspekt ist das parallele und gleichzeitige Verschließen einer Vielzahl von Gehäusen bei einem einmaligen Waferbondprozess, was auch nur einen einmaligen Justagevorgang benötigt.

Durch die parallele Herstellung und die gleichzeitige Bearbeitung vieler Gehäuse auf einem Wafer lassen sich erhebliche Kostenvorteile gegenüber den etablierten TO38-Gehäusen erzielen. Das strahlungsemittierende Bauelement 17, zum Beispiel eine Laserdiode, wird auf einem Bauelementesubstrat 16, beispielsweise einem Halbleitersubstrat wie einem Siliziumwafer, entweder direkt (Fig. 16a) oder über einen Zwischenträger (Fig. 16b), dem sogenannten Submount, der für eine möglichst gute Wärmeverteilung sorgt und auf dem Halbleitersubstrat aufgelötet ist, aufgelötet und wird mit der Laseraustrittsfläche dem optischen Fenster gegenüber platziert, wie in den Fig. 16 - 18 zu sehen ist. Der Kontakt der Laserdiode mit dem Bauelementesubstrat 16, also beispielsweise dem Siliziumsubstrat oder Siliziumchip, sorgt für eine optimale Entwärmung der Chips. Die Montage auf dem Siliziumsubstrat garantiert eine möglichst gute Wärmeankopplung.

Durch das Aufbonden des Glasdeckels 1 auf dem Bondrahmen 15 entsteht eine hermetisch dichte Kavität über den zuvor aufgebauten Laserdioden. Dieser Bondframe 15 besteht in der Regel aus einem metallischen Lot, hier im Beispiel eine Gold-Zinn-Legierung (Au/Sn). Zusätzliche metallische Schichten unter- bzw. oberhalb der Rahmenstruktur sowohl auf dem Bauelementeträger als auch auf dem Deckelsubstrat können für eine gute Benetzung des Lotes sorgen, was eine entscheidende Voraussetzung für einen dauerhaften hermetischen Verschluss des Gehäuses sein kann. Innerhalb des Gehäuses verlaufen metallische Leiterbahnen für die elektrischen Anschlüsse der Laserdiode zu den elektrischen Anschlusspads außerhalb des Gehäuses. Um Kurzschlüsse zu vermeiden, werden diese Leiterbahnen zumindest unterhalb des Bondrahmens mit geeigneten dielektrischen Passivierungen, wie z.B. PECVD SiO2 (Plasma Enhanced Chemical Vapor Deposition) abgedeckt (= laterale Durchführung).

Ein Aspekt bei diesem Aufbaukonzept ist, dass alle Komponenten und Materialien innerhalb des Gehäuses völlig frei von organischen Substanzen sein können, die durch ein eventuelles späteres Ausgasen ansonsten die strahlungsemittierenden Bauteile, beispielsweise Laserdioden, in deren Lebensdauer beeinträchtigen könnten. In der Kavität befindet sich vorzugsweise trockene Luft, Stickstoff oder eine andere inerte Atmosphäre. Aber auch ein Unterdruck oder gar ein vollständiges Vakuum kann prinzipiell eingestellt werden und zusätzlich durch Einbringen besonderer Getterschichten auch über lange Zeiträume erhalten werden.

Optional kann das Bauelementesubstrat 16 auch mit einer Verlängerung außerhalb der Kavität ausgestattet werden, die später als optische Bank für den Aufbau von optischen Komponenten außerhalb des hermetisch dichten Gehäuses dienen kann. Besonders vorteilhaft kann an dieser Anordnung sein, dass alle optischen Komponenten außerhalb des hermetisch dichten Gehäuses platziert sein können, einer Verwendung organischer Werkstoffe, wie z.B. Polymerlinsen oder Polymer-on-Glass Linsen, oder Klebeverbindungen demnach nichts mehr entgegen steht. Damit kann eine vollständige Trennung der optischen Funktionalität von der hermetischen Dichtigkeit des Gehäuses vorliegen. Fig. 18a und 18b zeigen eine vierte und eine fünfte Ausführungsform für gehäuste strahlungsemittierende Bauelemente, die mit einem erfindungsgemäßen Verfahren hergestellt worden sind und eine solche optische Bank 24 aufweisen. Die optische Bank 24 ist als Verlängerung des Bauelementesubstrats 16 gebildet, so dass der optischen Oberfläche 18 außerhalb der Kavität, in der das strahlungsemittierende Bauelement angeordnet ist, weitere optisch wirksame Elemente vorgelagert werden können. Gemäß Figur 18b ist als optische Oberfläche 18 im Deckelsubstrat 1 wieder eine integrierte Linse vorgesehen, während die optische Oberfläche 18 gemäß Fig. 18b eine optische Oberfläche 18 aufweist, die aus einem einfachen streifenförmigen Fensterbauelement ohne Linsenfunktion hergestellt wurde. Fig. 18b zeigt also eine Ausführungsform, bei der das optische Auskoppelfenster eine optische Linse umfasst. Grundsätzlich kann, wie weiter oben beschrieben, auch ein Teil der optischen Funktionen in das Fenster integriert werden, beispielsweise durch Integration einer Zylinderlinse anstelle eines einfachen Fensters. Diese Zylinderlinse kann auch als sogenannter fast axis collimator (FAC) dienen, d.h. den Strahl der Laserdiode der in beiden Achsen unterschiedlich divergent ist, in der stark divergenten Achse - der schnellen Achse- zu parallelisieren. Im hier aufgezeigten Fall gemäß Fig. 18b ist die Funktion des FAC allerdings sowohl auf die Zylinderlinse im Fenster als auch auf eine weitere Zylinderlinse außerhalb des Gehäuses aufgeteilt. Das hat den Vorteil, dass die zweite Linse durch eine Justage es erlaubt, etwaige Fehler in der genauen Platzierung der Linse relativ zur Laserdiode ausgleichen zu können. Zwei weitere optisch wirksame Elemente sind dementsprechend sowohl gemäß Fig. 18a als auch Fig. 18b jeweils auf der optischen Bank 24 der optischen Oberfläche 18 vorgelagert.

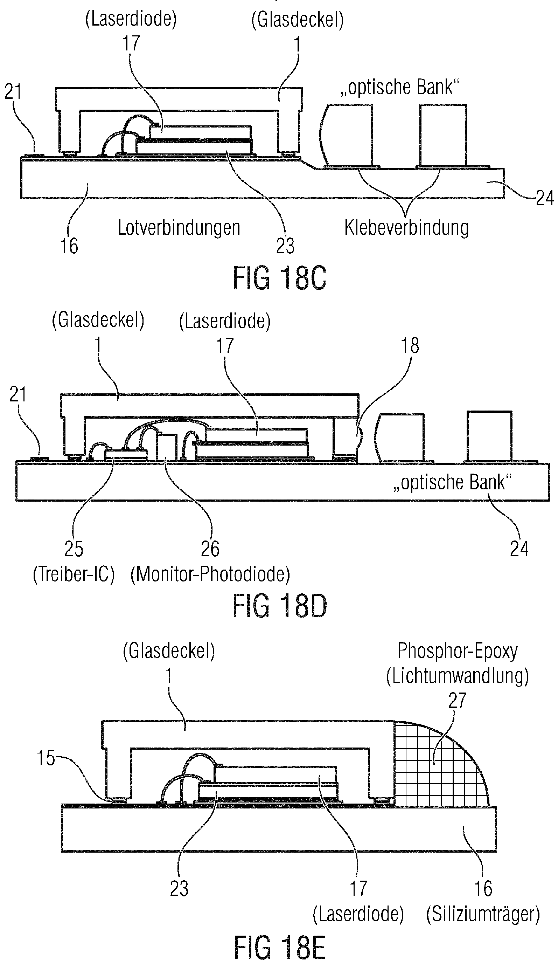

Fig. 18c zeigt ein weiteres hermetisch dichtes Lasergehäuse mit angeschlossener optischen Bank 24. Das Halbleitersubstrat, also beispielsweise Siliziumsubstrat, wird so angelegt, dass durch das Cap-Dicing ein zusätzlicher Absatz entsteht, der wie eben beschrieben als Montagefläche für optische Komponenten genutzt werden kann. Fig. 18c zeigt also eine Ausführungsform, bei der das Bauelementesubstrat 16, in diesem Fall ein Siliziumträgerchip, im Bereich der Optiken durch Ätzen abgesenkt wurde, um dadurch mehr vertikalen Bauraum für die Optiken zu schaffen. Dabei sind die Optiken mittels Klebeverbindungen auf der optischen Bank angeordnet. Fig. 18d zeigt eine Ausführungsform, bei der weitere elektronische Komponenten in das Lasergehäuse, also in die Kavität, integriert sind, was für manche Applikationen Vorteilhaft ist. Konkret können dies beispielsweise zusätzliche Photodioden zur Überwachung der Leistung des strahlungsemittierenden Bauelements 17, beispielsweise des Lasers, oder Treiberschaltungen für die Laserdiode sein. In der Figur sind in der Kavität ein Treiber-IC 25 und eine solche MonitorPhotodiode 26 gezeigt. Fig. 18d zeigt also eine Ausführungsform, bei der in der Kavität eine elektronische Treiberschaltung angeordnet ist. Fig. 18e zeigt eine Ausführungsform mit einem Konversionsmedium, das bei der Verwendung einer kurzwelligen Laserdiode als strahlungsemittierendes Bauelement 17 in der Kavität, die von dem Deckelsubstrat 1 und dem Bauelementesubstrat 16 gebildet ist, angebracht sein kann. Es kann, so wie in diesem Fall, außerhalb des hermetisch dichten Lasergehäuses ein zusätzliches Epoxydharz 27, das entsprechende Phosphore beinhaltet, aufgebracht sein. Das gehäuste strahlungsemittierende Bauelement nach Fig. 18c ist somit derart ausgeführt, dass es ein für eine Lichtfarbenumwandlung des emittierten Lichts wirksames Element 27 aufweist, so dass das optische Auskoppelfenster zwischen dem wirksamen Element 27 und dem strahlungsemittierende Bauelement 17 angeordnet ist. Das gehäuste strahlungsemittierende Bauelement ist also, wie in den Figuren 18a - 18e zu erkennen ist, derart ausgeführt, dass dem optischen Auskoppelfenster seitens des Bauelementesubstrats 16 eine optische Bank 24 vorgelagert ist, so dass das optische Auskoppelfenster zwischen der optischen Bank 24 und dem strahlungsemittierendem Bauelement 17 angeordnet ist. In den gezeigten Ausführungsformen ist das gehäuste strahlungsemittierende Bauelement derart ausgeführt, dass die optische Bank 24 auf dem Bauelementesubstrat 16 angeordnet ist und sich in der Abstrahlrichtung des strahlungsemittierenden Bauelements 17 befindet. Gemäß Fig. 18b und 18d ist das gehäuste strahlungsemittierende Bauelement derart ausgeführt, dass das optische Auskoppelfenster eine optische Linse umfasst.

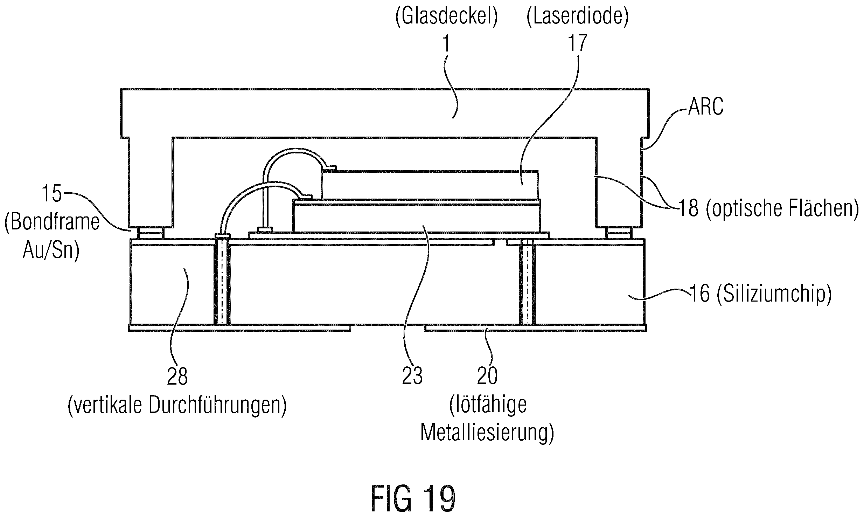

Fig. 19 zeigt eine Ausführungsform mit besonders vorteilhafter elektrische Kontaktierung. Für einen besonders kompakten Aufbau des Laserdiodengehäuses, also des gehäusten strahlungsemittierenden Bauelements, ist es vorteilhaft, die elektrischen Anschlüsse in Form vertikaler Durchführungen 28 durch das Bauelementesubstrat 16 zu führen. Auf der Rückseite können die notwendigen Anschlusspads, wie in der Fig. 19 gezeigt, mit einer lötfähigen Metallisierung 20 versehen werden. Wenn diese Anschlussbereiche besonders flächenintensiv ausgeführt werden, so eignen diese Areale sich auch dazu, die Entwärmung des Gehäuses sicherzustellen. Ansonsten sind in dem Ausführungsbeispiel nach Fig. 19 das Deckelsubstrat 1, also der Glasdeckel, und das Bauelementesubstrat 16, in diesem Fall ein Siliziumchip, wieder mittels eines Bondrahmens 16 miteinander verbunden, so dass eine hermetische Kavität für ein strahlungsemittierendes Bauelement 17, in diesem Fall eine Laserdiode, bereitgestellt ist. Die optischen Flächen 18 sind wieder mit einer Entspiegelung versehen (ARC=Anti Reflex Coating).

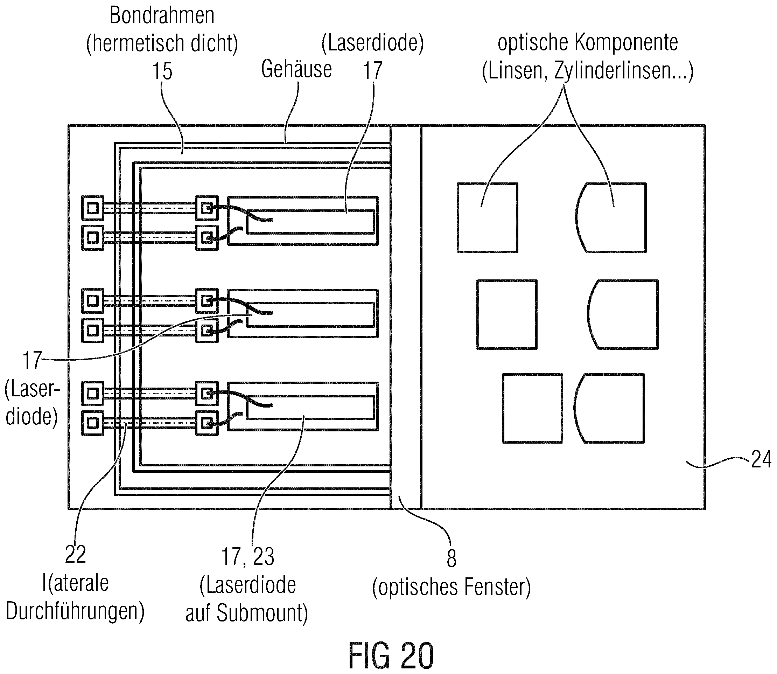

Fig. 20 zeigt eine Ausführungsform mit mehreren strahlungsemittierenden Bauelementen 17 im selben Gehäuse. Dies ist ein Beispiel einer Ausführung für die Montage mehrerer Laserdioden in einem Gehäuse, z.B. einer RGB-Laserquelle. Über Zwischenträger 23 sind die drei strahlungsemittierenden Bauelemente 17 jeweils mit dem Bauelementesubstrat 16 mechanisch verbunden. So wird eine günstige Wärmeableitung erreicht. Die strahlungsemittierenden Bauelemente 17 sind jeweils mittels Leiterbahnen 19 und lateraler Durchführungen 22, die durch einen hermetisch dichten Bondrahmen 15 hindurch aus der Kavität herausgeführt sind, elektrisch angebunden. Vorteilhaft kann es sein, die jeweiligen optischen Komponenten für die Strahlaufbereitung außerhalb des hermetisch dichten Gehäuses und dem optischen Fenster, also den optischen Flächen 18, vorgelagert zu platzieren, wie hier gezeigt. Dies können beispielsweise Zylinderlinsen oder andere Arten von Linsen sein. Dann können diese optischen Komponenten auch Substanzen umfassen, die in der hermetisch abgedichteten Kavität unerwünscht sind, wie beispielsweise organische Substanzen.

Den voranstehenden Ausführungen entsprechend ermöglicht die Erfindung verschiedene Ausführungsformen der Vorrichtung, beispielsweise:
1. Verkappung von einzelnen Laserdioden auf Submount in einem hermetisch dichten Gehäuse, geschaffen durch Aufbonden eines Deckels mit integrierten vertikalen optischen Fensterflächen (Fig. 16b).
2. Verkappung von einzelnen Laserdioden direkt auf Substrat in einem hermetisch dichten Gehäuse geschaffen durch Aufbonden eines Deckels mit integrierten vertikalen optischen Fensterflächen (Fig. 16a).
3. Verkappung von einzelnen Laserdioden in einem hermetisch dichten Gehäuse geschaffen durch Aufbonden eines Deckels mit integrierten vertikalen optischen Aperturen, die eine Linsenfunktion beinhalten (Fig. 17).
4. Verkappung von einzelnen Laserdioden in einem hermetisch dichten Gehäuse geschaffen durch Aufbonden eines Deckels mit integrierten vertikalen optischen Fenstern oder Aperturen, die eine Linsenfunktion beinhalten (Fig. 17).
5. Verkappung von einer oder mehreren Laserdioden mit fast focus collimation durch optisches Austrittsfenster, das als eine gemeinsame Zylinderlinse ausgearbeitet ist, optional mit jeweils einer weiteren Linse oder einer gemeinsamen Zylinderlinse zur slow axis collimation außerhalb der hermetischen Gehäusung (Fig. 18b).
6. Verkappung von Laserdioden auf Submount mit elektronischer Treiberschaltung innerhalb der hermetischen Gehäusung (Fig 18d).
7. Verkappung von einer oder mehreren Laserdioden mit fast focus collimation durch einzelne Linsen pro Strahlengang, optional mit jeweils einer weiteren Linse oder einer gemeinsamen Zylinderlinse zur slow axis collimation außerhalb des hermetischen Gehäuses (Fig. 20)
8. Verkappung von einer oder mehreren Laserdioden mit oder ohne fast axis collimation und einer Lichtfarbenumwandlung durch einen außen angeordneten Phosphorkörper, der als Formkörper fixiert oder als in einer Epoxy oder Silikonmatrix gebundener Phosphor aufdispenst und ausgehärtet wird (Fig 18e).
9. Die außen angeordneten optisch aktiven Bauelemente können gelötet oder durch eine Klebung fixiert werden, weil organische Ausgasungen keine Eintrübungen im Strahlaustritt erzeugen (Fig. 18c)
10. Die in der Kavität angeordneten Bauelemente und die Verkappung selbst werden vorzugsweise durch metallische Fügeverfahren wie Löten, eutektisch AuSn Löten, etc. gefügt, um organische Ausgasungen im Gehäuse zu vermeiden. Flussmittel werden nicht verwendet (Fig 18d).

Gemäß einem ersten Aspekt kann ein Verfahren zur Herstellung eines Deckelsubstrats 1 folgende Schritte aufweisen: Bereitstellen eines Form-Substrats 2 mit einem strukturierten Oberflächenbereich 3; Anordnen eines Abdeckungssubstrats 4 auf dem strukturierten Oberflächenbereich 3 des Form-Substrats 2, wobei das Abdeckungssubstrat 4 ein Glasmaterial aufweist, und Verbinden des Abdeckungssubstrats 4 mit dem Form-Substrat 2, wobei die strukturierte Oberfläche 3 des Form-Substrats 2 mit einer Oberfläche des Abdeckungssubstrats 4 mindestens teilweise überdeckend zusammengeführt wird; Bilden von ersten Inselbereichen 5 und jeweils zugeordneten, benachbarten zweiten Inselbereichen 6 aus dem Form-Substrat 2, wobei zwischen den ersten Inselbereichen 5 und den jeweils zugeordneten, benachbarten zweiten Inselbereichen 6 eine Vertiefung 7 vorgesehen Ist; Anordnen eines Fensterbauelements 8; 8' in der Vertiefung 7 zwischen einem ersten Inselbereich 5 und dem zugeordneten, benachbarten zweiten Inselbereich 6; Anordnen eines Trägersubstrats 9 auf den ersten Inselbereichen 5 und den zweiten Inselbereichen 6, die aus dem Form-Substrat 2 gebildet sind, so dass die ersten Inselbereiche 5 und die zweiten Inselbereiche 6 sich zwischen dem Trägersubstrat 9 und dem Abdeckungssubstrat 4 befinden; Tempern der verbundenen Substrate derart, dass ein Hineinfließen des Glasmaterials des Abdeckungssubstrats 4 in die verbleibenden Vertiefungen 7 zwischen den Inselbereichen bewirkt wird; und Entfernen des Abdeckungssubstrats 4 von dem Form-Substrat 2 und dem Trägersubstrat 9, um das strukturierte Deckelsubstrat 1 zu erhalten.

Gemäß einem zweiten Aspekt unter Rückbezug auf den ersten Aspekt kann das Bereitstellen des Form-Substrats 2 folgende Schritte umfassen: Bereitstellen eines Halbleiterwafers 2 mit einer Passivierungsschicht 10 auf einer Oberfläche 3; Lithografieren der Passivierungsschicht 10, so dass die Passivierungsschicht 10 dort auf der Oberfläche 3 verbleibt, wo die ersten Inselbereiche 5 und die zweiten Inselbereiche 6 vorgesehen sind; Ätzen der Oberfläche 3 des Halbleiterwafers 2 hinsichtlich der lithographierten Bereiche, so dass eine Dicke des Halbleiterwafers 2 senkrecht zu den lithographierten Bereichen der Oberfläche verringert wird, um den Oberflächenbereich 3 zu strukturieren und somit Positionen für die ersten Inselbereiche 5 und die zweiten Inselbereiche 6 vorzugeben; und Vollständiges Entfernen der Passivierungsschicht 10.

Gemäß einem dritten Aspekt unter Rückbezug auf zumindest einen des ersten bis zweiten Aspekts kann das Anordnen und Verbinden des Abdeckungssubstrats 4 folgenden Schritt umfassen: bereichsweises anodisches Bonden des strukturierten Oberflächenbereichs 3 des Form-Substrats 2 mit einem Oberflächenbereich des Abdeckungssubstrats 4.

Gemäß einem vierten Aspekt unter Rückbezug auf den dritten Aspekt kann das Bilden von Inselbereichen 5, 6 aus dem Form-Substrat 2 folgende Schritte umfassen: Einsägen der ersten Inselbereiche 5 und zweiten Inselbereiche 6 in dem Form-Substrat 2 nach dem bereichsweisen anodischen Bonden; und Entfernen jener Abschnitte des Form-Substrats 2, die nach dem Sägen von den gebondeten Bereichen 5, 6 getrennt sind.

Gemäß einem fünften Aspekt kann ein Verfahren zur Herstellung eines Deckelsubstrats 1 folgende Schritte aufweisen: Bereitstellen eines Form-Substrats 2 mit einem strukturierten Oberflächenbereich 3; Anordnen eines Trägersubstrats 9 auf dem strukturierten Oberflächenbereich 3 des Form-Substrats 2, und Verbinden des Trägersubstrats 9 mit dem Form-Substrat 2, wobei die strukturierte Oberfläche 3 des Form-Substrats 2 mit einer Oberfläche des Trägersubstrats 9 mindestens teilweise überdeckend zusammengeführt wird; Bilden von ersten Inselbereichen 5 und jeweils zugeordneten, benachbarten zweiten Inselbereichen 6 aus dem Form-Substrat 2, wobei zwischen den ersten Inselbereichen 5 und den jeweils zugeordneten, benachbarten zweiten Inselbereichen 6 eine Vertiefung 7 vorgesehen ist; Anordnen eines Fensterbauelements 8; 8' in der Vertiefung 7 zwischen einem ersten Inselbereich 5 und dem zugeordneten, benachbarten zweiten Inselbereich 6; Anordnen eines Abdeckungssubstrats 4 auf den ersten Inselbereichen 5 und den zweiten Inselbereichen 6, die aus dem Form-Substrat 2 gebildet sind, so dass die ersten Inselbereiche 5 und die zweiten Inselbereiche 6 sich zwischen dem Trägersubstrat 9 und dem Abdeckungssubstrat 4 befinden, wobei das Abdeckungssubstrat 4 ein Glasmaterial aufweist; Tempern der verbundenen Substrate derart, dass ein Hineinfließen des Glasmaterials des Abdeckungssubstrats 4 in die verbleibenden Vertiefungen 7 zwischen den Inselbereichen bewirkt wird; und Entfernen des Abdeckungssubstrats 4 von dem Form-Substrat 2 und dem Trägersubstrat 9, um das strukturierte Deckelsubstrat 1 zu erhalten. Gemäß einem sechsten Aspekt unter Rückbezug auf den fünften Aspekt kann das Bereitstellen des Form-Substrats 2 folgende Schritte umfassen: Bereitstellen eines Halbleiterwafers 2 mit einer Passivierungsschicht 10 auf einer Oberfläche 3; Lithografieren der Passivierungsschicht 10, so dass die Passivierungsschicht 10 dort auf der Oberfläche 3 verbleibt, wo die ersten Inselbereiche 5 und die zweiten Inselbereiche 6 vorgesehen sind; Ätzen der Oberfläche 3 des Halbleiterwafers 2 hinsichtlich der lithographierten Bereiche, so dass eine Dicke des Halbleiterwafers 2 senkrecht zu den lithographierten Bereichen der Oberfläche verringert wird, um den Oberflächenbereich 3 zu strukturieren und somit Positionen für die ersten Inselbereiche 5 und die zweiten Inselbereiche 6 vorzugeben; und vollständiges Entfernen der Passivierungsschicht 10.

Gemäß einem siebten Aspekt unter Rückbezug auf zumindest einen des fünften bis sechsten Aspekts kann das Anordnen und Verbinden des Abdeckungssubstrats 4 folgenden Schritt umfassen: Bereichsweises Verbinden des strukturierten Oberflächenbereichs 3 des Form-Substrats 2 mit einem Oberflächenbereich des Trägersubstrats 9, wobei das Form-Substrat 2 und das Trägersubstrat 9 ein Halbleitermaterial aufweisen.

Gemäß einem achten Aspekt unter Rückbezug auf den siebten Aspekt kann das Bilden von Inselbereichen 5, 6 aus dem Form-Substrat 2 folgende Schritte umfassen: Einsägen der ersten Inselbereiche 5 und zweiten Inselbereiche 6 in dem Form-Substrat 2 nach dem bereichsweisen anodischen Bonden; und Entfernen jener Abschnitte des Form-Substrats 2, die nach dem Sägen von den gebondeten Bereichen 5, 6 getrennt sind.

Gemäß einem neunten Aspekt kann ein Verfahren zur Herstellung eines Deckelsubstrats 1 folgende Schritte aufweisen: Bereitstellen eines wiederverwendbaren Werkzeugs als Form-Substrat 2, wobei erste Inselbereiche 5 und jeweils zugeordnete, benachbarte zweite Inselbereichen 6 an einer Oberfläche 3 des wiederverwendbaren Werkzeugs gebildet sind, das als Negativ-Struktur für eine Deckelstruktur wirksam ist, wobei zwischen den ersten Inselbereichen 5 und den jeweils zugeordneten, benachbarten zweiten Inselbereichen 6 eine Vertiefung in dem wiederverwendbaren Wafer vorgesehen ist; Anordnen eines Fensterbauelements 8 auf dem wiederverwendbaren Werkzeug jeweils in der Vertiefung 7 zwischen einem ersten Inselbereich 5 und dem zugeordneten, benachbarten zweiten Inselbereich 6; Anordnen eines Abdeckungssubstrats 4 auf den Inselbereichen 5, 6 des wiederverwendbaren Werkzeugs, wobei das Abdeckungssubstrat 4 ein Glasmaterial aufweist; wobei die Oberfläche 3 des wiederverwendbaren Werkzeugs mit einer Oberfläche des Abdeckungssubstrats mindestens teilweise überdeckend zusammengeführt wird; Tempern der verbundenen Substrate derart, dass ein Hineinfließen des Glasmaterials des Abdeckungssubstrats 4 in die Vertiefungen 7 zwischen den Inselbereichen 5, 6 bewirkt wird; und Trennen des Abdeckungssubstrats 4 von dem Form-Substrat 2, um das strukturierte Deckelsubstrat 1 zu erhalten.

Gemäß einem zehnten Aspekt unter Rückbezug auf zumindest einen des ersten bis neunten Aspekts kann das Anordnen jeweils des Fensterbauelements 8 folgende Schritte umfassen: Bereitstellen mehrerer streifenförmiger Fensterbauelemente 8; und Einlegen der streifenförmigen Fensterbauelemente 8 in die Vertiefungen 7 zwischen den ersten Inselbereichen 5 und den zweiten Inselbereichen 6, so dass Oberflächen der Fensterbauelemente 8, die als Oberflächen von optischen Auskoppelfenstern vorgesehen sind, Oberflächen der Inselbereiche 5, 6, die aus dem Form-Substrat 2 gebildet sind, gegenüberliegen.

Gemäß einem elften Aspekt unter Rückbezug auf den zehnten Aspekt kann das Bereitstellen von streifenförmigen Fensterbauelementen 8 folgende Schritte umfassen: Bereitstellen eines Fensterbauelementwafers; und Zuschneiden der streifenförmigen Fensterbauelemente 8 aus dem Fensterbauelementwafer

Gemäß einem zwölften Aspekt unter Rückbezug auf zumindest einen des ersten bis elften Aspekts kann das Anordnen des jeweiligen Fensterbauelements 8 folgenden Schritt umfassen: Einlegen von Halbleiterstreifen 11 in die Vertiefungen 7 vor dem Einlegen der streifenförmigen Fensterbauelemente 8 in die Vertiefungen, so dass die Halbleiterstreifen 11 zwischen Oberflächen der Fensterbauelemente 8, die als Oberflächen von optischen Auskoppelfenstern vorgesehen sind, und Flächen der Inselbereiche 5, 6, die aus dem Form-Substrat 2 gebildet sind, angeordnet sind.

Gemäß einem dreizehnten Aspekt unter Rückbezug auf zumindest einen des ersten bis zwölften Aspekts kann das Anordnen des jeweiligen Fensterbauelements 8 folgenden Schritt umfassen: Bereitstellen von einem oder mehreren mit Halbleitermaterial 11 beschichteten streifenförmigen Fensterelementen.

Gemäß einem vierzehnten Aspekt unter Rückbezug auf den dreizehnten Aspekt kann das Bereitstellen von einem mit Halbleitermaterial beschichteten Fensterelement folgenden Schritt umfassen: Beschichten von Oberflächen des Fensterbauelements 8 durch Aufbonden von Halbleiterstreifen 11.

Gemäß einem fünfzehnten Aspekt unter Rückbezug auf zumindest einen des ersten bis vierzehnten Aspekts kann das Anordnen des Fensterbauelements 8 folgenden Schritt umfassen: Zuschneiden jeweils von streifenförmigen Fensterbauelementen 8 aus einem Linsenarray.

Gemäß einem sechzehnten Aspekt unter Rückbezug auf zumindest einen des neunten bis fünfzehnten Aspekts kann das Tempern folgenden Schritt umfassen: Anlegen eines Unterdrucks an die verbundenen Substrate, um das Glasmaterial in die verbleibenden Vertiefungen 7 zwischen den Inselbereichen hineinzuziehen.

Gemäß einem siebzehnten Aspekt unter Rückbezug auf zumindest einen des ersten bis sechzehnten Aspekts können die ersten und zweiten Inselbereiche 5, 6 Kantenanfasungen 50 in einem Bereich angrenzend an das Trägersubstrat 9 aufweisen, wobei bei dem Schritt des Temperns das Glasmaterial des Fensterbauelements 8, 8' in dem Bereich zwischen den Anfasungen 50 und dem Trägersubstrat 9 hineinfließt, um einen umlaufenden Fortsatz 52 aus dem Glasmaterial zu bilden.

Gemäß einem achtzehnten Aspekt unter Rückbezug auf zumindest einen des ersten bis siebzehnten Aspekts kann das Bereitstellen des Form-Substrats 2 ferner folgende Schritte umfassen: wobei bei dem Lithographieren der Passivierungsschicht 10 die Passivierungsschicht 10 ferner dort von der Oberfläche 3 entfernt wird, wo Kanalstrukturen 40 innerhalb der ersten und zweiten Inselbereiche 5, 6 vorgesehen sind, wobei bei dem Ätzen der Oberfläche 3 des Halbleiterwafers 2 hinsichtlich der lithographischen Bereiche ferner Kanäle 42 in das Form-Substrat 2 innerhalb der ersten und zweiten Inselbereiche 5, 6 geätzt werden.

Gemäß einem neunzehnten Aspekt kann ein Verfahren zur Herstellung eines Deckelsubstrats 1 folgende Schritte aufweisen: Bereitstellen eines Form-Substrats 2 mit einem strukturierten Oberflächenbereich 3; Anordnen eines Abdeckungssubstrats 4 auf dem strukturierten Oberflächenbereich 3 des Form-Substrats 2, wobei das Abdeckungssubstrat 4 ein Glasmaterial aufweist, und Verbinden des Abdeckungssubstrats 4 mit dem Form-Substrat 2, wobei die strukturierte Oberfläche 3 des Form-Substrats 2 mit einer Oberfläche des Abdeckungssubstrats 4 mindestens teilweise überdeckend zusammengeführt wird; Bilden von ersten Inselbereichen 5 und jeweils zugeordneten, benachbarten zweiten Inselbereichen 6 aus dem Form-Substrat 2, wobei zwischen den ersten Inselbereichen 5 und den jeweils zugeordneten, benachbarten zweiten Inselbereichen 6 eine Vertiefung 7 vorgesehen ist; Anordnen von Halbleiterstreifen 11 jeweils in der Vertiefung 7 zwischen einem ersten Inselbereich 5 und dem zugeordneten, benachbarten zweiten Inselbereich 6, so dass die Halbleiterstreifen 11 mit einer ihrer Oberflächen jeweils seitliche Oberflächen der Inselbereiche 5, 6 senkrecht zum Abdeckungssubstrat 4 mindestens teilweise abdecken, und Halbleiterstreifen 11 sich hinsichtlich der Vertiefung 7 gegenüberliegen und zwischen den Halbleiterstreifen 11 ein Abstand ausgebildet ist, der einer verbleibenden Vertiefung 7 entspricht; Anordnen eines Trägersubstrats 9 auf den ersten Inselbereichen 5 und den zweiten Inselbereichen 6, die aus dem Form-Substrat 2 gebildet sind, so dass die ersten Inselbereiche 5 und die zweiten Inselbereiche 6 sich zwischen dem Trägersubstrat 9 und dem Abdeckungssubstrat 4 befinden; Tempern der verbundenen Substrate derart, dass ein Hineinfließen des Glasmaterials des Abdeckungssubstrats 4 in die verbleibenden Vertiefungen 7 zwischen den Inselbereichen bewirkt wird; und Entfernen des Abdeckungssubstrats 4 von dem Form-Substrat 2 und dem Trägersubstrat 9, um das strukturierte Deckelsubstrat 1 zu erhalten.

Gemäß einem zwanzigsten Aspekt kann ein Verfahren zur Herstellung eines Deckelsubstrats 1 folgende Schritte aufweisen: Bereitstellen eines wiederverwendbaren Werkzeugs als Form-Substrat 2, wobei erste Inselbereiche 5 und jeweils zugeordnete, benachbarte zweite Inselbereichen 6 an einer Oberfläche 3 des wiederverwendbaren Werkzeugs gebildet sind, das als Negativ-Struktur für eine Deckelstruktur wirksam ist, wobei zwischen den ersten Inselbereichen 5 und den jeweils zugeordneten, benachbarten zweiten Inselbereichen 6 eine Vertiefung in dem wiederverwendbaren Wafer vorgesehen ist; Anordnen von Halbleiterstreifen 11 jeweils in der Vertiefung 7 zwischen einem ersten Inselbereich 5 und dem zugeordneten, benachbarten zweiten Inselbereich 6, so dass die Halbleiterstreifen 11 mit einer ihrer Oberflächen jeweils seitliche Oberflächen der Inselbereiche 5, 6 senkrecht zum Abdeckungssubstrat 4 mindestens teilweise abdecken, und Halbleiterstreifen 11 sich hinsichtlich der Vertiefung 7 gegenüberliegen und zwischen den Halbleiterstreifen 11 ein Abstand ausgebildet ist, der einer verbleibenden Vertiefung 7 entspricht; Anordnen eines Abdeckungssubstrats 4 auf den Inselbereichen 5, 6 des wiederverwendbaren Werkzeugs, wobei das Abdeckungssubstrat 4 ein Glasmaterial aufweist; wobei die Oberfläche 3 des wiederverwendbaren Werkzeugs mit einer Oberfläche des Abdeckungssubstrats mindestens teilweise überdeckend zusammengeführt wird; Tempern der verbundenen Substrate derart, dass ein Hineinfließen des Glasmaterials des Abdeckungssubstrats 4 in die Vertiefungen 7 zwischen den Inselbereichen 5, 6 bewirkt wird; und Trennen des Abdeckungssubstrats 4 von dem Form-Substrat 2, um das strukturierte Deckelsubstrat 1 zu erhalten.

Gemäß einem einundzwanzigsten Aspekt kann ein Verfahren zur Herstellung eines gehäusten strahlungsemittierenden Bauelements auf Waferebene folgende Schritte aufweisen: Herstellen eines Deckelsubstrats 1; Bereitstellen eines Bauelementesubstrats 16 in Form eines Wafers mit einer Vielzahl von strahlungsemittierenden Bauelementen 17; Anordnen der Substrate aufeinander, so dass die Substrate entlang eines zwischengeschalteten Verbindungsrahmens 15 verbunden werden; und Vereinzeln der gehäusten strahlungsemittierenden Bauelemente.

Gemäß einem zweiundzwanzigsten Aspekt unter Rückbezug auf den fünfzehnten Aspekt kann das Verfahren folgende Schritte umfassen: Herstellen des Deckelsubstrats 1 gemäß des Verfahrens des ersten Aspekts oder des Verfahrens des fünften Aspekts oder des Verfahrens des dreizehnten Aspekts; und Vereinzeln der gehäusten strahlungsemittierenden Bauelemente, wobei durch die zweiten Inselbereiche 6 in dem Deckelsubstrat 1 eine Vereinzelungsstraße gebildet worden ist.

Gemäß einem dreiundzwanzigsten Aspekt unter Rückbezug auf zumindest einen des einundzwanzigsten bis zweiundzwanzigsten Aspekts kann das Anordnen der Substrate unter einer vorgegebenen Atmosphäre erfolgen.

Gemäß einem vierundzwanzigsten Aspekt kann ein gehäustes strahlungsemittierendes Bauelement nach einem Verfahren gemäß einem des einundzwanzigsten bis dreiundzwanzigsten Aspekts hergestellt sein.

Gemäß einem fünfundzwanzigsten Aspekt kann ein gehäustes strahlungsemittierendes Bauelement folgende Merkmale aufweisen: ein an einem Bauelementesubstrat 16 angeordnetes strahlungsemittierendes Bauelement 17; und ein Deckelsubstrat 1, das eine hermetisch abgedichtete Kavität für das strahlungsemittierende Bauelement 17 bereitstellt, innerhalb welchem das strahlungsemittierende Bauelement 17 gehäust ist, wobei das Deckelsubstrat 1 in einer Seitenfläche ein optisches Auskoppelfenster aus einem für die Strahlung des strahlungsemittierenden Bauelements 17 durchlässigen Material aufweist, wobei das optische Auskoppelfenster des Deckelsubstrats 1 und das strahlungsemittierende Bauelement 17 derart zueinander angeordnet sind, dass die im Betrieb des strahlungsemittierenden Bauelements 17 emittierte Strahlung das Gehäuse in einer Abstrahlrichtung parallel zur Oberfläche des Bauelementesubstrats 16 und/oder senkrecht zu der Seitenfläche des Deckelsubstrats 1 verlässt.

Gemäß einem sechsundzwanzigsten Aspekt unter Rückbezug auf den fünfundzwanzigsten Aspekt kann das Bauelementesubstrat 16 als ein Gehäusesockel und als eine Lagerfläche für das strahlungsemittierende Bauelement 17 dienen, und wobei das Deckelsubstrat 1 mit dem Gehäusesockel zusammenwirkt, um die Kavität des Gehäuses hermetisch abzudichten.

Gemäß einem siebenundzwanzigsten Aspekt unter Rückbezug auf den sechsundzwanzigsten Aspekt kann der Gehäusesockel aus einem Sockelwafer, der mehrere Gehäusesockel umfasst, gebildet sein und/oder das Deckelsubstrat 1 aus einem Deckelwafer, der mehrere Deckelsubstrate 1 umfasst, gebildet sein.

Gemäß einem achtundzwanzigsten Aspekt unter Rückbezug auf zumindest einen des sechsundzwanzigsten bis siebenundzwanzigsten Aspekts kann das Deckelsubstrat 1 einen oder mehrere ebene Wandabschnitte als Seitenfläche aufweisen, so dass entweder ein ebener Wandabschnitt das optische Auskoppelfenster aufweist oder aber das optische Auskoppelfenster einen ebenen Wandabschnitt des Deckelsubstrats 1 bildet.

Gemäß einem neunundzwanzigsten Aspekt unter Rückbezug auf zumindest einen des fünfundzwanzigsten bis achtundzwanzigsten Aspekts kann das optische Auskoppelfenster mit dem Deckelsubstrat 1 stoffschlüssig oder einstückig verbunden sein.

Gemäß einem dreißigsten Aspekt unter Rückbezug auf zumindest einen des fünfundzwanzigsten bis neunundzwanzigsten Aspekts kann zwischen dem Bauelementesubstrat 16 und dem strahlungsemittierenden Bauelement 17 ein Zwischenträger 23 für das strahlungsemittierende Bauelement 17 angeordnet sein, so dass das Bauelementesubstrat 16 das strahlungsemittierende Bauelement 17 mittelbar trägt.

Gemäß einem einunddreißigsten Aspekt unter Rückbezug auf zumindest einen des fünfundzwanzigsten bis dreißigsten Aspekts können das Bauelementesubstrat 16 und das Deckelsubstrat 1 mittels eines Bondrahmens 15, der ein metallisches Lotmaterial aufweist, aneinander befestigt sein.

Gemäß einem zweiunddreißigsten Aspekt unter Rückbezug auf zumindest einen des fünfundzwanzigsten bis einunddreißigsten Aspekts kann das optische Auskoppelfenster aus einem ersten Glasmaterial gebildet sein und das Deckelsubstrat 1 aus einem zweiten Glasmaterial gebildet sein, und wobei das zweite Glasmaterial eine niedrigere Viskosität aufweist als das erste Glasmaterial.

Gemäß einem dreiunddreißigsten Aspekt unter Rückbezug auf zumindest einen des fünfundzwanzigsten bis zweiunddreißigsten Aspekts kann eine Leiterbahn 19 zum elektrischen Anbinden des strahlungsemittierenden Bauelements 17 seitens des Bauelementesubstrats 16 angeordnet sein und die Leiterbahn 19 zwischen dem Deckelsubstrat 1 und dem Bauelementesubstrat 16 aus der Kavität herausgeführt sein.

Gemäß einem vierunddreißigsten Aspekt unter Rückbezug auf zumindest einen des fünfundzwanzigsten bis dreiunddreißigsten Aspekts kann dem optischen Auskoppelfenster seitens des Bauelementesubstrats 16 eine optische Bank 24 vorgelagert sein, so dass das optische Auskoppelfenster zwischen der optischen Bank 24 und dem strahlungsemittierendem Bauelement 17 angeordnet ist.

Gemäß einem fünfunddreißigsten Aspekt unter Rückbezug auf den vierunddreißigsten Aspekt kann die optische Bank 24 auf dem Bauelementesubstrat 16 angeordnet sein und sich in der Abstrahlrichtung des strahlungsemittierenden Bauelements 17 befinden.

Gemäß einem sechsunddreißigsten Aspekt unter Rückbezug auf zumindest einen des fünfundzwanzigsten bis fünfunddreißigsten Aspekts kann das optische Auskoppelfenster eine optische Linse umfassen.

Gemäß einem siebenunddreißigsten Aspekt unter Rückbezug auf zumindest einen des fünfundzwanzigsten bis sechsunddreißigsten Aspekts kann das gehäuste strahlungsemittierende Bauelement ferner ein für eine Lichtfarbenumwandlung des emittierten Lichts wirksames Element 27 aufweisen, so dass das optische Auskoppelfenster zwischen dem wirksamen Element 27 und dem strahlungsemittierende Bauelement 17 angeordnet ist.

Gemäß einem achtunddreißigsten Aspekt unter Rückbezug auf zumindest einen des fünfundzwanzigsten bis siebenunddreißigsten Aspekts kann die Kavität eine inerte Atmosphäre aufweisen und/oder die Kavität ausschließlich anorganische Substanzen enthalten. Gemäß einem neununddreißigsten Aspekt unter Rückbezug auf zumindest einen des fünfundzwanzigsten bis achtunddreißigsten Aspekts kann in der Kavität eine elektronische Treiberschaltung angeordnet sein.

Gemäß einem vierzigsten Aspekt kann eine Waferanordnung mit einer Vielzahl von gehäusten strahlungsemittierenden Bauelementen gemäß einem des fündundzwanzigsten bis neununddreißigsten Aspekts folgende Merkmale aufweisen: ein Bauelementesubstrat 16 in Form eines Wafers, der als gemeinsames Bauelementesubstrat 16 für die daran angeordneten strahlungsemittierenden Bauelemente 17 ausbildet ist, ein gemeinsames Deckelsubstrat 1, das die Deckelsubstrate 1 für die strahlungsemittierende Bauelemente 17 aufweist, wobei die Substrate 1, 16 so aneinander geordnet sind, dass das Deckelsubstrat 1 und das Bauelementesubstrat 16 entlang eines dazwischenliegenden Bondrahmens 15 verbunden sind.

### Bezugszeichenliste

- A1, A2: erster Schritt des Verfahrens
- B1, B2: zweiter Schritt des Verfahrens
- C1, C2: dritter Schritt des Verfahrens
- D1, D2: vierter Schritt des Verfahrens
- E1, E2: fünfter Schritt des Verfahrens
- F1, F2: sechster Schritt des Verfahrens
- G1: siebter Schritt des Verfahrens

- 1: Deckelsubstrat
- 2: Form-Substrat
- 3: Oberflächenbereich
- 4: Abdeckungssubstrat
- 5: Erster Inselbereich
- 6: Zweiter Inselbereich
- 7: Vertiefung
- 8, 8': Fensterbauelement
- 9: Trägersubstrat
- 10: Passivierung
- 11: Siliziumauflage / Halbleiterstreifen / Siliziumkamm
- 12: Belastungsring
- 13: Schutzelement
- 14: Vakuumkanal
- 15: Bondrahmen
- 16: Bauelementesubstrat
- 17: Strahlungsemittierendes Bauelement
- 18: Optische Oberfläche
- 19: Leiterbahn
- 20: Metallisierung
- 21: Anschlusspad
- 22: Laterale Durchführung
- 23: Zwischenträger
- 24: Optische Bank
- 25: Treiber-IC
- 26: Monitorphotodiode
- 27: Epoxydharz
- 28: Vertikale Durchführung
- 40: Kanalstrukturen
- 42: Kanäle
- 44: Anschlagsstruktur
- 50: Anfasung
- 52: Fortsatz/Hinterschneidung
- 54: Metallisierung
- 56: Beschichtung
- 60: Deckeleinzelelement

### Literaturliste

[1] DE 199 56 654 A1
[2] DE 199 56 654 B4
[3] DE 101 18 529 C1
[4] DE 102 41 390 B3
[5] DE 102 59 890 A1
[6] DE 103 13 889 B3
[7] DE 10 2008 012 384 A1

## Patentansprüche

1. Verfahren zur Herstellung eines strukturierten Deckelsubstrats (1), mit folgenden Schritten:
- Bereitstellen eines Form-Substrats (2) mit einem strukturierten Oberflächenbereich (3);
- Anordnen eines Abdeckungssubstrats (4) auf dem strukturierten Oberflächenbereich (3) des Form-Substrats (2), wobei das Abdeckungssubstrat (4) ein Glasmaterial aufweist, und Verbinden des Abdeckungssubstrats (4) mit dem Form-Substrat (2),
wobei die strukturierte Oberfläche (3) des Form-Substrats (2) mit einer Oberfläche des Abdeckungssubstrats (4) mindestens teilweise überdeckend zusammengeführt wird;
- Bilden von ersten Inselbereichen (5) und jeweils zugeordneten, benachbarten zweiten Inselbereichen (6) aus dem Form-Substrat (2), wobei zwischen den ersten Inselbereichen (5) und den jeweils zugeordneten, benachbarten zweiten Inselbereichen (6) eine Vertiefung (7) vorgesehen ist;
- Anordnen eines Fensterbauelements (8; 8') in der Vertiefung (7) zwischen einem ersten Inselbereich (5) und dem zugeordneten, benachbarten zweiten Inselbereich (6);
- Anordnen eines Trägersubstrats (9) auf den ersten Inselbereichen (5) und den zweiten Inselbereichen (6), die aus dem Form-Substrat (2) gebildet sind, so dass die ersten Inselbereiche (5) und die zweiten Inselbereiche (6) sich zwischen dem Trägersubstrat (9) und dem Abdeckungssubstrat (4) befinden;
- Tempern der verbundenen Substrate derart, dass ein Hineinfließen des Glasmaterials des Abdeckungssubstrats (4) in die verbleibenden Vertiefungen (7) zwischen den Inselbereichen bewirkt wird; und
- Entfernen des getemperten Abdeckungssubstrats (4) von dem Form-Substrat (2) und dem Trägersubstrat (9), um das strukturierte Deckelsubstrat (1) mit dem getemperten Abdeckungssubstrat (4) und dem Fensterbauelement (8; 8')zu erhalten.

2. Verfahren nach Anspruch 1, bei dem das Bereitstellen des Form-Substrats (2) folgende Schritte umfasst:
- Bereitstellen eines Halbleiterwafers (2) mit einer Passivierungsschicht (10) auf einer Oberfläche (3);
- Lithografieren der Passivierungsschicht (10), so dass die Passivierungsschicht (10) dort auf der Oberfläche (3) verbleibt, wo die ersten Inselbereiche (5) und die zweiten Inselbereiche (6) vorgesehen sind;
- Ätzen der Oberfläche (3) des Halbleiterwafers (2) hinsichtlich der lithographierten Bereiche, so dass eine Dicke des Halbleiterwafers (2) senkrecht zu den lithographierten Bereichen der Oberfläche verringert wird, um den Oberflächenbereich (3) zu strukturieren und somit Positionen für die ersten Inselbereiche (5) und die zweiten Inselbereiche (6) vorzugeben; und
- Vollständiges Entfernen der Passivierungsschicht (10).

3. Verfahren nach Anspruch 1 oder 2, bei dem das Anordnen und Verbinden des Abdeckungssubstrats (4) folgende Schritte umfasst:
- Bereichsweises anodisches Bonden des strukturierten Oberflächenbereichs (3) des Form-Substrats (2) mit einem Oberflächenbereich des Abdeckungssubstrats (4).

4. Verfahren nach einem der vorhergehenden Ansprüche, bei dem das Anordnen jeweils des Fensterbauelements (8) folgende Schritte umfasst:
- Bereitstellen mehrerer streifenförmiger Fensterbauelemente (8); und
- Einlegen der streifenförmigen Fensterbauelemente (8) in die Vertiefungen (7) zwischen den ersten Inselbereichen (5) und den zweiten Inselbereichen (6), so dass Oberflächen der Fensterbauelemente (8), die als Oberflächen von optischen Auskoppelfenstern vorgesehen sind, Oberflächen der Inselbereiche (5, 6), die aus dem Form-Substrat (2) gebildet sind, gegenüberliegen.

5. Verfahren zur Herstellung eines strukturierten Deckelsubstrats (1), mit folgenden Schritten:
- Bereitstellen eines Form-Substrats (2) mit einem strukturierten Oberflächenbereich (3);
- Anordnen eines Trägersubstrats (9) auf dem strukturierten Oberflächenbereich (3) des Form-Substrats (2), und Verbinden des Trägersubstrats (9) mit dem Form-Substrat (2),
wobei die strukturierte Oberfläche (3) des Form-Substrats (2) mit einer Oberfläche des Trägersubstrats (9) mindestens teilweise überdeckend zusammengeführt wird;
- Bilden von ersten Inselbereichen (5) und jeweils zugeordneten, benachbarten zweiten Inselbereichen (6) aus dem Form-Substrat (2), wobei zwischen den ersten Inselbereichen (5) und den jeweils zugeordneten, benachbarten zweiten Inselbereichen (6) eine Vertiefung (7) vorgesehen ist;
- Anordnen eines Fensterbauelements (8; 8') in der Vertiefung (7) zwischen einem ersten Inselbereich (5) und dem zugeordneten, benachbarten zweiten Inselbereich (6);
- Anordnen eines Abdeckungssubstrats (4) auf den ersten Inselbereichen (5) und den zweiten Inselbereichen (6), die aus dem Form-Substrat (2) gebildet sind, so dass die ersten Inselbereiche (5) und die zweiten Inselbereiche (6) sich zwischen dem Trägersubstrat (9) und dem Abdeckungssubstrat (4) befinden, wobei das Abdeckungssubstrat (4) ein Glasmaterial aufweist;
- Tempern der verbundenen Substrate derart, dass ein Hineinfließen des Glasmaterials des Abdeckungssubstrats (4) in die verbleibenden Vertiefungen (7) zwischen den Inselbereichen bewirkt wird; und
- Entfernen des getemperten Abdeckungssubstrats (4) von dem Form-Substrat (2) und dem Trägersubstrat (9), um das strukturierte Deckelsubstrat (1) mit dem getemperten Abdeckungssubstrat (4) und dem Fensterbauelement (8; 8')zu erhalten.

6. Verfahren nach Anspruch 5, bei dem das Bereitstellen des Form-Substrats (2) folgende Schritte umfasst:
- Bereitstellen eines Halbleiterwafers (2) mit einer Passivierungsschicht (10) auf einer Oberfläche (3);
- Lithografieren der Passivierungsschicht (10), so dass die Passivierungsschicht (10) dort auf der Oberfläche (3) verbleibt, wo die ersten Inselbereiche (5) und die zweiten Inselbereiche (6) vorgesehen sind;
- Ätzen der Oberfläche (3) des Halbleiterwafers (2) hinsichtlich der lithographierten Bereiche, so dass eine Dicke des Halbleiterwafers (2) senkrecht zu den lithographierten Bereichen der Oberfläche verringert wird, um den Oberflächenbereich (3) zu strukturieren und somit Positionen für die ersten Inselbereiche (5) und die zweiten Inselbereiche (6) vorzugeben; und
- Vollständiges Entfernen der Passivierungsschicht (10).

7. Verfahren nach einem der Ansprüche 5 oder 6, bei dem das Anordnen jeweils des Fensterbauelements (8) folgende Schritte umfasst:
- Bereitstellen mehrerer streifenförmiger Fensterbauelemente (8); und
- Einlegen der streifenförmigen Fensterbauelemente (8) in die Vertiefungen (7) zwischen den ersten Inselbereichen (5) und den zweiten Inselbereichen (6), so dass Oberflächen der Fensterbauelemente (8), die als Oberflächen von optischen Auskoppelfenstern vorgesehen sind, Oberflächen der Inselbereiche (5, 6), die aus dem Form-Substrat (2) gebildet sind, gegenüberliegen.

8. Verfahren zur Herstellung eines strukturierten Deckelsubstrats (1), mit folgenden Schritten:
- Bereitstellen eines wiederverwendbaren Werkzeugs als Form-Substrat (2), wobei erste Inselbereiche (5) und jeweils zugeordnete, benachbarte zweite Inselbereichen (6) an einer Oberfläche (3) des wiederverwendbaren Werkzeugs gebildet sind, das als Negativ-Struktur für eine Deckelstruktur wirksam ist, wobei zwischen den ersten Inselbereichen (5) und den jeweils zugeordneten, benachbarten zweiten Inselbereichen (6) eine Vertiefung in dem wiederverwendbaren Wafer vorgesehen ist;
- Anordnen eines Fensterbauelements (8) auf dem wiederverwendbaren Werkzeug jeweils in der Vertiefung (7) zwischen einem ersten Inselbereich (5) und dem zugeordneten, benachbarten zweiten Inselbereich (6);
- Anordnen eines Abdeckungssubstrats (4) auf den Inselbereichen (5, 6) des wiederverwendbaren Werkzeugs, wobei das Abdeckungssubstrat (4) ein Glasmaterial aufweist;
wobei die Oberfläche (3) des wiederverwendbaren Werkzeugs mit einer Oberfläche des Abdeckungssubstrats mindestens teilweise überdeckend zusammengeführt wird;
- Tempern der verbundenen Substrate derart, dass ein Hineinfließen des Glasmaterials des Abdeckungssubstrats (4) in die Vertiefungen (7) zwischen den Inselbereichen (5, 6) und ein Verbinden des Glasmaterials des Abdeckungssubstrats (4) mit dem Fensterbauelement (8; 8') bewirkt wird; und
- Trennen des getemperten Abdeckungssubstrats (4) von dem Form-Substrat (2), um das strukturierte Deckelsubstrat (1) mit dem getemperten Abdeckungssubstrat (4) und dem Fensterbauelement (8; 8')zu erhalten.

9. Verfahren nach Anspruch 8, bei dem das Anordnen jeweils des Fensterbauelements (8) folgende Schritte umfasst:
- Bereitstellen mehrerer streifenförmiger Fensterbauelemente (8); und
- Einlegen der streifenförmigen Fensterbauelemente (8) in die Vertiefungen (7) zwischen den ersten Inselbereichen (5) und den zweiten Inselbereichen (6), so dass Oberflächen der Fensterbauelemente (8), die als Oberflächen von optischen Auskoppelfenstern vorgesehen sind, Oberflächen der Inselbereiche (5, 6), die aus dem Form-Substrat (2) gebildet sind, gegenüberliegen.

10. Verfahren zur Herstellung eines strukturierten Deckelsubstrats (1), mit folgenden Schritten:
- Bereitstellen eines Form-Substrats (2) mit einem strukturierten Oberflächenbereich (3);
- Anordnen eines Abdeckungssubstrats (4) auf dem strukturierten Oberfiächenbereich (3) des Form-Substrats (2), wobei das Abdeckungssubstrat (4) ein Glasmaterial aufweist, und Verbinden des Abdeckungssubstrats (4) mit dem Form-Substrat (2),
wobei die strukturierte Oberfläche (3) des Form-Substrats (2) mit einer Oberfläche des Abdeckungssubstrats (4) mindestens teilweise überdeckend zusammengeführt wird;
- Bilden von ersten Inselbereichen (5) und jeweils zugeordneten, benachbarten zweiten Inselbereichen (6) aus dem Form-Substrat (2), wobei zwischen den ersten Inselbereichen (5) und den jeweils zugeordneten, benachbarten zweiten Inselbereichen (6) eine Vertiefung (7) vorgesehen ist;
- Anordnen von Halbleiterstreifen (11) jeweils in der Vertiefung (7) zwischen einem ersten Inselbereich (5) und dem zugeordneten, benachbarten zweiten Inselbereich (6), so dass die Halbleiterstreifen (11) mit einer ihrer Oberflächen jeweils seitliche Oberflächen der Inselbereiche (5, 6) senkrecht zum Abdeckungssubstrat (4) mindestens teilweise abdecken, und Halbleiterstreifen (11) sich hinsichtlich der Vertiefung (7) gegenüberliegen und zwischen den Halbleiterstreifen (11) ein Abstand ausgebildet ist, der einer verbleibenden Vertiefung (7) entspricht;
- Anordnen eines Trägersubstrats (9) auf den ersten Inselbereichen (5) und den zweiten Inselbereichen (6), die aus dem Form-Substrat (2) gebildet sind, so dass die ersten Inselbereiche (5) und die zweiten Inselbereiche (6) sich zwischen dem Trägersubstrat (9) und dem Abdeckungssubstrat (4) befinden;
- Tempern der verbundenen Substrate derart, dass ein Hineinfließen des Glasmaterials des Abdeckungssubstrats (4) in die verbleibenden Vertiefungen (7) zwischen den Inselbereichen bewirkt wird; und
- Entfernen des getemperten Abdeckungssubstrats (4) von dem Form-Substrat (2) und dem Trägersubstrat (9), und Entfernen der Halbleitersteifen (11), um das strukturierte Deckelsubstrat (1) mit dem getemperten Abdeckungssubstrat (4) und einem Fensterbauelement (8) zu erhalten.

11. Verfahren zur Herstellung eines strukturierten Deckelsubstrats (1), mit folgenden Schritten:
- Bereitstellen eines wiederverwendbaren Werkzeugs als Form-Substrat (2), wobei erste Inselbereiche (5) und jeweils zugeordnete, benachbarte zweite Inselbereichen (6) an einer Oberfläche (3) des wiederverwendbaren Werkzeugs gebildet sind, das als Negativ-Struktur für eine Deckelstruktur wirksam ist, wobei zwischen den ersten Inselbereichen (5) und den jeweils zugeordneten, benachbarten zweiten Inselbereichen (6) eine Vertiefung in dem wiederverwendbaren Wafer vorgesehen ist;
- Anordnen von Halbleiterstreifen (11) jeweils in der Vertiefung (7) zwischen einem ersten Inselbereich (5) und dem zugeordneten, benachbarten zweiten Inselbereich (6), so dass die Halbleiterstreifen (11) mit einer ihrer Oberflächen jeweils seitliche Oberflächen der Inselbereiche (5, 6) senkrecht zum Abdeckungssubstrat (4) mindestens teilweise abdecken, und Halbleiterstreifen (11) sich hinsichtlich der Vertiefung (7) gegenüberliegen und zwischen den Halbleiterstreifen (11) ein Abstand ausgebildet ist, der einer verbleibenden Vertiefung (7) entspricht;
- Anordnen eines Abdeckungssubstrats (4) auf den Inselbereichen (5, 6) des wiederverwendbaren Werkzeugs, wobei das Abdeckungssubstrat (4) ein Glasmaterial aufweist;
wobei die Oberfläche (3) des wiederverwendbaren Werkzeugs mit einer Oberfläche des Abdeckungssubstrats mindestens teilweise überdeckend zusammengeführt wird;
- Tempern der verbundenen Substrate derart, dass ein Hineinfließen des Glasmaterials des Abdeckungssubstrats (4) in die Vertiefungen (7) zwischen den Inselbereichen (5, 6) bewirkt wird; und
- Trennen des getemperten Abdeckungssubstrats (4) von dem Form-Substrat (2) und Entfernen der Halbleitersteifen (11), um das strukturierte Deckelsubstrat (1) mit dem getemperten Abdeckungssubstrat (4) und einem Fensterbauelement (8) zu erhalten.

12. Verfahren zur Herstellung eines gehäusten strahlungsemittierenden Bauelements auf Waferebene, mit folgenden Schritten:
- Herstellen eines strukturierten Deckelsubstrats (1) gemäß des Verfahrens nach Anspruch 1 oder des Verfahrens nach Anspruch 5 oder des Verfahrens nach Anspruch 11;
- Bereitstellen eines Bauelementesubstrats (16) in Form eines Wafers mit einer Vielzahl von strahlungsemittierenden Bauelementen (17);
- Anordnen der Substrate aufeinander, so dass die Substrate entlang eines zwischengeschalteten Verbindungsrahmens (15) verbunden werden; und
- Vereinzeln der gehäusten strahlungsemittierenden Bauelemente, wobei durch die zweiten Inselbereiche (6) in dem strukturierten Deckelsubstrat (1) eine Vereinzelungsstraße gebildet worden ist.

13. Gehäustes strahlungsemittierendes Bauelement, mit folgenden Merkmalen:
- einem an einem Bauelementesubstrat (16) angeordneten strahlungsemittierenden Bauelement (17); und
- einem Deckelsubstrat (1), das eine hermetisch abgedichtete Kavität für das strahlungsemittierende Bauelement (17) bereitstellt, innerhalb welchem das strahlungsemittierende Bauelement (17) gehäust ist, wobei das Deckelsubstrat (1) in einer Seitenfläche ein optisches Auskoppelfenster aus einem für die Strahlung des strahlungsemittierenden Bauelements (17) durchlässigen Material aufweist, wobei das optische Auskoppelfenster des Deckelsubstrats (1) und das strahlungsemittierende Bauelement (17) derart zueinander angeordnet sind, dass die im Betrieb des strahlungsemittierenden Bauelements (17) emittierte Strahlung das Gehäuse in einer Abstrahlrichtung parallel zur Oberfläche des Bauelementesubstrats (16) und/oder senkrecht zu der Seitenfläche des Deckelsubstrats (1) verlässt,
**dadurch gekennzeichnet, dass** das optische Auskoppelfenster (8) aus einem ersten Glasmaterial gebildet ist und das Deckelsubstrat (1) aus einem zweiten Glasmaterial gebildet ist, und wobei das zweite Glasmaterial eine niedrigere Viskosität aufweist als das erste Glasmaterial, und wobei das Glasmaterial des Deckelsubstrats (1) und Glasmaterial der Fensterbauelemente (8) einstückig verbunden sind.

14. Gehäustes strahlungsemittierendes Bauelement nach Anspruch 13, wobei das Deckelsubstrat (1) einen oder mehrere ebene Wandabschnitte als Seitenfläche aufweist, so dass entweder ein ebener Wandabschnitt das optische Auskoppelfenster aufweist oder aber das optische Auskoppelfenster einen ebenen Wandabschnitt des Deckelsubstrats (1) bildet.

15. Gehäustes strahlungsemittierendes Bauelement nach einem der Ansprüche 13 oder 14, wobei dem optischen Auskoppelfenster seitens des Bauelementesubstrats (16) eine optische Bank (24) vorgelagert ist, so dass das optische Auskoppelfenster zwischen der optischen Bank (24) und dem strahlungsemittierendem Bauelement (17) angeordnet ist.

## Claims

1. Method of producing a structured cap substrate (1), comprising:
- providing a mold substrate (2) comprising a structured surface region (3);
- arranging a cover substrate (4) on the structured surface region (3) of the mold substrate (2), the cover substrate (4) comprising a glass material, and bonding the cover substrate (4) to the mold substrate (2),
the structured surface (3) of the mold substrate (2) being brought into contact with a surface of the cover substrate (4) in such a way that they at least partially overlap;
- forming first island regions (5) and respectively associated adjacent second island regions (6) from the mold substrate (2), a recess (7) being provided between the first island regions (5) and the respectively associated adjacent second island regions (6);
- arranging a window component (8; 8') within the recess (7) located between a first island region (5) and the associated adjacent second island region (6);
- arranging a carrier substrate (9) on the first island regions (5) and on the second island regions (6), which are formed from the mold substrate (2), so that the first island regions (5) and the second island regions (6) are located between the carrier substrate (9) and the cover substrate (4);
- tempering the bonded substrates such that the glass material of the cover substrate (4) is caused to flow into the remaining recesses (7) located between the island regions; and
- removing the tempered cover substrate (4) from the mold substrate (2) and the carrier substrate (9) so as to obtain the structured cap substrate (1) having the tempered cover substrate (4) and the window component (8, 8').

2. Method as claimed in claim 1, wherein said providing of the mold substrate (2) includes the following steps:
- providing a semiconductor wafer (2) comprising a passivation layer (10) on a surface (3);
- lithographing the passivation layer (10) so that the passivation layer (10) will remain on the surface (3) where the first island regions (5) and the second island regions (6) are provided;
- etching the surface (3) of the semiconductor wafer (2) with regard to the lithographed regions, so that a thickness of the semiconductor wafer (2) is reduced perpendicularly to the lithographed regions of the surface so as to structure the surface region (3) and to thus specify positions for the first island regions (5) and the second island regions (6); and
- completely removing the passivation layer (10).

3. Method as claimed in claim 1 or 2, wherein said arranging and bonding of the cover substrate (4) includes the following steps:
- anodically bonding, region by region, the structured surface region (3) of the mold substrate (2) with a surface region of the cover substrate (4).

4. Method as claimed in any of the previous claims, wherein said arranging of the window component (8) in each case includes the following steps:
- providing several strip-shaped window components (8); and
- inserting the strip-shaped window components (8) into the recesses (7) located between the first island regions (5) and the second island regions (6), so that surfaces of the window components (8) that are provided as surfaces of optical output windows are located opposite surfaces of the island regions (5, 6) that are formed from the mold substrate (2).

5. Method of producing a structured cap substrate (1), comprising:
- providing a mold substrate (2) comprising a structured surface region (3);
- arranging a carrier substrate (9) on the structured surface region (3) of the mold substrate (2) and bonding the carrier substrate (9) to the mold substrate (2),
the structured surface (3) of the mold substrate (2) being brought into contact with a surface of the carrier substrate (9) in such a way that they at least partially overlap;
- forming first island regions (5) and respectively associated adjacent second island regions (6) from the mold substrate (2), a recess (7) being provided between the first island regions (5) and the respectively associated adjacent second island regions (6);
- arranging a window component (8; 8') within the recess (7) located between a first island region (5) and the associated adjacent second island region (6);
- arranging a cover substrate (4) on the first island regions (5) and on the second island regions (6), which are formed from the mold substrate (2), so that the first island regions (5) and the second island regions (6) are located between the carrier substrate (9) and the cover substrate (4), the cover substrate (4) comprising a glass material;
- tempering the bonded substrates such that the glass material of the cover substrate (4) is caused to flow into the remaining recesses (7) located between the island regions; and
- removing the tempered cover substrate (4) from the mold substrate (2) and the carrier substrate (9) so as to obtain the structured cap substrate (1) having the tempered cover substrate (4) and the window component (8, 8').

6. Method as claimed in claim 5, wherein said providing of the mold substrate (2) includes the following steps:
- providing a semiconductor wafer (2) comprising a passivation layer (10) on a surface (3);
- lithographing the passivation layer (10) so that the passivation layer (10) will remain on the surface (3) where the first island regions (5) and the second island regions (6) are provided;
- etching the surface (3) of the semiconductor wafer (2) with regard to the lithographed regions, so that a thickness of the semiconductor wafer (2) is reduced perpendicularly to the lithographed regions of the surface so as to structure the surface region (3) and to thus specify positions for the first island regions (5) and the second island regions (6); and
- completely removing the passivation layer (10).

7. Method as claimed in claim 5 or 6, wherein said arranging of the respective window component (8) includes the following steps:
- providing several strip-shaped window components (8); and
- inserting the strip-shaped window components (8) into the recesses (7) located between the first island regions (5) and the second island regions (6), so that surfaces of the window components (8) that are provided as surfaces of optical output windows are located opposite surfaces of the island regions (5, 6) that are formed from the mold substrate (2).

8. Method of producing a structured cap substrate (1), comprising:
- providing a reusable tool as the mold substrate (2), first island regions (5) and respectively associated adjacent second island regions (6) being formed on a surface (3) of the reusable tool, which is effective as a negative structure for a cap structure, a recess being provided, in the reusable wafer, between the first island regions (5) and the respectively associated adjacent second island regions (6);
- arranging a window component (8) on the reusable tool in the recess (7), respectively, located between a first island region (5) and the associated adjacent second island region (6);
- arranging a cover substrate (4) on the island regions (5, 6) of the reusable tool, the cover substrate (4) comprising a glass material;
wherein the surface (3) of the reusable tool is brought into contact with a surface of the cover substrate in such a way that they at least partially overlap;
- tempering the bonded substrates such that the glass material of the cover substrate (4) is caused to flow into the recesses (7) located between the island regions (5, 6) and the glass material of the cover substrate (4) is bonded to the window component (8; 8');
- separating the tempered cover substrate (4) from the mold substrate (2) so as to obtain the structured cap substrate (1) having the tempered cover substrate (4) and the window component (8, 8').

9. Method as claimed in claim 8, wherein said arranging of the respective window component (8) includes the following steps:
- providing several strip-shaped window components (8); and
- inserting the strip-shaped window components (8) into the recesses (7) located between the first island regions (5) and the second island regions (6), so that surfaces of the window components (8) that are provided as surfaces of optical output windows are located opposite surfaces of the island regions (5, 6) that are formed from the mold substrate (2).

10. Method of producing a structured cap substrate (1), comprising:
- providing a mold substrate (2) comprising a structured surface region (3);
- arranging a cover substrate (4) on the structured surface region (3) of the mold substrate (2), the cover substrate (4) comprising a glass material, and bonding the cover substrate (4) to the mold substrate (2),
the structured surface (3) of the mold substrate (2) being brought into contact with a surface of the cover substrate (4) in such a way that they at least partially overlap;
- forming first island regions (5) and respectively associated adjacent second island regions (6) from the mold substrate (2), a recess (7) being provided between the first island regions (5) and the respectively associated adjacent second island regions (6);
- arranging semiconductor strips (11) in the recess (7), respectively, located between a first island region (5) and the associated adjacent second island region (6), so that the semiconductor strips (11) with one of their surfaces at least partially overlap respective lateral surfaces of the island regions (5, 6) perpendicularly to the cover substrate (4), and so that semiconductor strips (11) are located opposite one another with regard to the recess (7) and that a distance, which corresponds to a remaining recess (7), is formed between the semiconductor strips (11);
- arranging a carrier substrate (9) on the first island regions (5) and on the second island regions (6), which are formed from the mold substrate (2), so that the first island regions (5) and the second island regions (6) are located between the carrier substrate (9) and the cover substrate (4);
- tempering the bonded substrates such that the glass material of the cover substrate (4) is caused to flow into the remaining recesses (7) located between the island regions; and
- removing the tempered cover substrate (4) from the mold substrate (2) and the carrier substrate (9), and removing the semiconductor strips (11) so as to obtain the structured cap substrate (1) having the tempered cover substrate (4) and a window component (8).

11. Method of producing a structured cap substrate (1), comprising:
- providing a reusable tool as the mold substrate (2), first island regions (5) and respectively associated adjacent second island regions (6) being formed on a surface (3) of the reusable tool, which is effective as a negative structure for a cap structure, a recess being provided, in the reusable wafer, between the first island regions (5) and the respectively associated adjacent second island regions (6);
- arranging semiconductor strips (11) in the recess (7), respectively, located between a first island region (5) and the associated adjacent second island region (6), so that the semiconductor strips (11) with one of their surfaces at least partially overlap respective lateral surfaces of the island regions (5, 6) perpendicularly to the cover substrate (4), and so that semiconductor strips (11) are located opposite one another with regard to the recess (7) and that a distance, which corresponds to a remaining recess (7), is formed between the semiconductor strips (11);
- arranging a cover substrate (4) on the island regions (5, 6) of the reusable tool, the cover substrate (4) comprising a glass material;
wherein the surface (3) of the reusable tool is brought into contact with a surface of the cover substrate in such a way that they at least partially overlap;
- tempering the bonded substrates such that the glass material of the cover substrate (4) is caused to flow into the recesses (7) located between the island regions; and
- separating the tempered cover substrate (4) from the mold substrate (2) and removing the semiconductor strips (11) so as to obtain the structured cap substrate (1) having the tempered cover substrate (4) and a window component (8).

12. Method of producing a packaged radiation-emitting device at wafer level, comprising:
- producing a structured cap substrate (1) in accordance with the method of claim 1 or the method of claim 5 or the method of claim 11;
- providing a device substrate (16) in the form of a wafer comprising a multitude of radiation-emitting devices (17);
- arranging the substrates one above the other, so that the substrates are bonded along an intermediate bonding frame (15); and
- dicing the packaged radiation-emitting devices, a dicing pathway having been formed through the second island regions (6) within the structured cap substrate (1).

13. Packaged radiation-emitting device, comprising:
- a radiation-emitting device (17) arranged on a device substrate (16); and
- a cap substrate (1) providing a hermetically sealed cavity for the radiation-emitting device (17) within which the radiation-emitting device (17) is packaged, said cap substrate (1) comprising, in a side face, an optical output window made of a material transparent to the radiation of the radiation-emitting device (17), said optical output window of the cap substrate (1) and the radiation-emitting device (17) being arranged in relation to each other such that the radiation emitted during operation of the radiation-emitting device (17) leaves the package in an emission direction in a manner that is parallel with the surface of the device substrate (16) and/or that is perpendicular to the side face of the cap substrate (1),
**characterized in that** the optical output window (8) is formed from a first glass material and the cap substrate (1) is formed from a second glass material and wherein the second glass material has a viscosity lower than that of the first glass material; and wherein the glass material of the cap substrate (1) and the glass material of the window components (8) are integrally bonded.

14. Packaged radiation-emitting device as claimed in claim 13, wherein the cap substrate (1) comprises one or several planar wall portions as a side face, so that either a planar wall portion comprises the optical output window or that the optical output window forms a planar wall portion of the cap substrate (1).

15. Packaged radiation-emitting device as claimed in any of claim 13 or 14, wherein the optical output window has an optical bench (24) located upstream from it on the part of the device substrate (16), so that the optical output window is arranged between the optical bench (24) and the radiation-emitting device (17).

## Revendications

1. Procédé de fabrication d'un substrat de couvercle structuré (1), aux étapes suivantes consistant à:
- prévoir un substrat de moulage (2) avec une zone de surface structurée (3);
- disposer un substrat de recouvrement (4) sur la zone de surface structurée (3) du substrat de moulage (2), le substrat de recouvrement (4) présentant un matériau de verre, et assembler le substrat de recouvrement (4) avec le substrat de moulage (2),
dans lequel la surface structurée (3) du substrat de moulage (2) est assemblée au moins partiellement en recouvrement avec une surface du substrat de recouvrement (4);
- former des premières zones d'îlot (5) et des deuxièmes zones d'îlot (6) voisines associées respectives à partir du substrat de moulage (2), où entre les premières zones d'îlot (5) et les deuxièmes zones d'îlot (6) voisines associées respectives est prévue une cavité (7);
- disposer un élément de fenêtre (8, 8') dans la cavité (7) entre une première zone d'îlot (5) et la deuxième zone d'îlot voisine associée (6);
- disposer un substrat porteur (9) sur les premières zones d'îlot (5) et les deuxièmes zones d'îlot (6) qui sont formées à partir du substrat de moulage (2), de sorte que les premières zones d'îlot (5) et les deuxièmes zones d'îlot (6) se situent entre le substrat porteur (9) et le substrat de recouvrement (4);
- recuire les substrats assemblés de sorte que soit provoquée une pénétration du matériau de verre du substrat de recouvrement (4) dans les cavités restantes (7) entre les zones d'îlot; et
- éliminer le substrat de recouvrement recuit (4) du substrat de moulage (2) et du substrat porteur (9), pour obtenir le substrat de couvercle structuré (1) avec le substrat de recouvrement recuit (4) et l'élément de fenêtre (8; 8').

2. Procédé selon la revendication 1, dans lequel la prévision du substrat de moulage (2) comporte les étapes suivantes consistant à:
- prévoir une plaquette semi-conductrice (2) avec une couche de passivation (10) sur une surface (3);
- lithographier la couche de passivation (10) de sorte que la couche de passivation (10) reste sur la surface (3) là où sont prévues les premières zones d'îlot (5) et les deuxièmes zones d'îlot (6);
- graver la surface (3) de la plaquette semi-conductrice (2) en ce qui concerne les zones lithographiées, de sorte qu'une épaisseur de la plaquette semi-conductrice (2) soit réduite perpendiculairement aux zones lithographiées de la surface, pour structurer la zone de surface (3) et prédéterminer de ce fait les positions pour les premières zones d'îlot (5) et les deuxièmes zones d'îlot (6); et
- éliminer complètement la couche de passivation (10).

3. Procédé selon la revendication 1 ou 2, dans lequel la disposition et l'assemblage du substrat de recouvrement (4) comportent les étapes suivantes consistant à:
- assembler par zones par collage anodique la zone de surface structurée (3) du substrat de moulage (2) avec une zone de surface du substrat de recouvrement (4).

4. Procédé selon l'une des revendications précédentes, dans lequel la disposition de l'élément de fenêtre (8) respectif comporte les étapes suivantes consistant à:
- prévoir plusieurs éléments de fenêtre en forme de bande (8); et
- placer les éléments de fenêtre en forme de bande (8) dans les cavités (7) entre les premières zones d'îlot (5) et les deuxièmes zones d'îlot (6), de sorte que les surfaces des éléments de fenêtre (8), qui sont prévues comme surfaces de fenêtres de désaccouplage optique, se situent face aux surfaces des zones d'îlot (5, 6) formées à partir du substrat de moulage (2).

5. Procédé de fabrication d'un substrat de couvercle structuré (1), aux étapes suivantes consistant à:
- prévoir un substrat de moulage (2) avec une zone de surface structurée (3);
- disposer un substrat porteur (9) sur la zone de surface structurée (3) du substrat de moulage (2), et assembler le substrat porteur (4) avec le substrat de moulage (2),
dans lequel la surface structurée (3) du substrat de moulage (2) est assemblée au moins partiellement en recouvrement avec une surface du substrat porteur (4);
- former des premières zones d'îlot (5) et des deuxièmes zones d'îlot (6) voisines associées respectives à partir du substrat de moulage (2), où entre les premières zones d'îlot (5) et les deuxièmes zones d'îlot (6) voisines associées respectives est prévue une cavité (7);
- disposer un élément de fenêtre (8, 8') dans la cavité (7) entre une première zone d'îlot (5) et la deuxième zone d'îlot voisine associée (6);
- disposer un substrat de recouvrement (4) sur les premières zones d'îlot (5) et les deuxièmes zones d'îlot (6) qui sont formées à partir du substrat de moulage (2), de sorte que les premières zones d'îlot (5) et les deuxièmes zones d'îlot (8) se situent entre le substrat porteur (9) et le substrat de recouvrement (4), où le substrat de recouvrement (4) présente un matériau de verre;
- recuire les substrats assemblés de sorte que soit provoquée une pénétration du matériau de verre du substrat de recouvrement (4) dans les cavités restantes (7) entre les zones d'îlot; et
- éliminer le substrat de recouvrement recuit (4) du substrat de moulage (2) et du substrat porteur (9), pour obtenir le substrat de couvercle structuré (1) avec le substrat de recouvrement recuit (4) et l'élément de fenêtre (8; 8').

6. Procédé selon la revendication 5, dans lequel la prévision du substrat de moulage (2) comporte les étapes suivantes consistant à:
- prévoir une plaquette semi-conductrice (2) avec une couche de passivation (10) sur une surface (3);
- lithographier la couche de passivation (10) de sorte que la couche de passivation (10) reste sur la surface (3) là où sont prévues les premières zones d'îlot (5) et les deuxièmes zones d'îlot (6);
- graver la surface (3) de la plaquette semi-conductrice (2) en ce qui concerne les zones lithographiées, de sorte qu'une épaisseur de la plaquette semi-conductrice (2) soit réduite perpendiculairement aux zones lithographiées de la surface, pour structurer la zone de surface (3) et prédéterminer de ce fait les positions pour les premières zones d'îlot (5) et les deuxièmes zones d'îlot (6); et
- éliminer complètement la couche de passivation (10).

7. Procédé selon l'une des revendications 5 ou 6, dans lequel la disposition de l'élément de fenêtre (8) respectif comporte les étapes suivantes consistant à:
- prévoir plusieurs éléments de fenêtre en forme de bande (8); et
- placer les éléments de fenêtre en forme de bande (8) dans les cavités (7) entre les premières zones d'îlot (5) et les deuxièmes zones d'îlot (6), de sorte que les surfaces des éléments de fenêtre (8), qui sont prévues comme surfaces de fenêtres de désaccouplage optique, se situent face aux surfaces des zones d'îlot (5, 6) formées à partir du substrat de moulage (2).

8. Procédé de fabrication d'un substrat de couvercle structuré (1), aux étapes suivantes consistant à:
- prévoir un outil réutilisable comme substrat de moulage (2), où des premières zones d'îlot (5) et des deuxièmes zones d'îlot (6) voisines associées respectives sont formées sur une surface (3) de l'outil réutilisable, qui agit comme une structure négative pour une structure de couvercle, où entre les premières zones d'îlot (5) et les deuxièmes zones d'îlot (6) voisines associées respectives est prévue une cavité dans la plaquette réutilisable;
- disposer un élément de fenêtre (8) sur l'outil réutilisable respectivement dans la cavité (7) entre une première zone d'îlot (5) et la deuxième zone d'îlot (6) voisine associée;
- disposer un substrat de recouvrement (4) sur les zones d'îlot (5, 6) de l'outil réutilisable, où le substrat de recouvrement (4) présente un matériau de verre;
dans lequel la surface (3) de l'outil réutilisable est assemblée au moins partiellement en chevauchement avec une surface du substrat de recouvrement;
- recuire les substrats assemblés de sorte que soit provoquée une pénétration du matériau de verre du substrat de recouvrement (4) dans les cavités (7) entre les zones d'îlot (5, 6) et que soit provoqué un assemblage du matériau de verre du substrat de recouvrement (4) avec l'élément de fenêtre (8, 8'); et
- séparer le substrat de recouvrement recuit (4) du substrat de moulage (2), pour obtenir le substrat de couvercle structuré (1) avec le substrat de recouvrement recuit (4) et l'élément de fenêtre (8; 8').

9. Procédé selon la revendication 8, dans lequel la disposition de l'élément de fenêtre (8) respectif comporte les étapes suivantes consistant à:
- prévoir plusieurs éléments de fenêtre en forme de bande (8); et
- placer les éléments de fenêtre en forme de bande (8) dans les cavités (7) entre les premières zones d'îlot (5) et les deuxièmes zones d'îlot (6), de sorte que les surfaces des éléments de fenêtre (8), qui sont prévues comme surfaces de fenêtres de désaccouplage optique, se situent face aux surfaces des zones d'îlot (5, 6) formées à partir du substrat de moulage (2).

10. Procédé de fabrication d'un substrat de couvercle structuré (1), aux étapes suivantes consistant à:
- prévoir un substrat de moulage (2) avec une zone de surface structurée (3);
- disposer un substrat de recouvrement (4) sur la zone de surface structurée (3) du substrat de moulage (2), où le substrat de recouvrement (4) présente un matériau de verre, et assembler le substrat de recouvrement (4) avec le substrat de moulage (2),
dans lequel la surface structurée (3) du substrat de moulage (2) est assemblée au moins partiellement en recouvrement avec une surface du substrat de recouvrement (4);
- former des premières zones d'îlot (5) et des deuxièmes zones d'îlot (6) voisines associées respectives à partir du substrat de moulage (2), où entre les premières zones d'îlot (5) et les deuxièmes zones d'îlot (6) voisines associées respectives est prévue une cavité (7);
- disposer des bandes semi-conductrice (11) respectivement dans la cavité (7) entre une première zone d'îlot (5) et la deuxième zone d'îlot voisine associée (6), de sorte que les bandes semi-conductrices (11) recouvrent par leurs surfaces au moins partiellement des faces latérales respectives des zones d'îlot (5, 6) de manière perpendiculaire au substrat de recouvrement (4), et que les bandes semi-conductrices (11) se fassent face par rapport à la cavité (7) et qu'entre les bandes semi-conductrices (11) soit formée une distance qui correspond à une cavité restante (7);
- disposer un substrat porteur (9) sur les premières zones d'îlot (5) et les deuxièmes zones d'îlot (6) qui sont formées à partir du substrat de moulage (2), de sorte que les premières zones d'îlot (5) et les deuxièmes zones d'îlot (6) se situent entre le substrat porteur (9) et le substrat de recouvrement (4);
- recuire les substrats assemblés de sorte que soit provoquée une pénétration du matériau de verre du substrat de recouvrement (4) dans les cavités restantes (7) entre les zones d'îlot; et
- éliminer le substrat de recouvrement recuit (4) du substrat de moulage (2) et du substrat porteur (9), et éliminer les bandes semi-conductrices (11), pour obtenir le substrat de couvercle structuré (1) avec le substrat de recouvrement recuit (4) et un élément de fenêtre (8).

11. Procédé de fabrication d'un substrat de couvercle structuré (1) aux étapes suivantes consistant à:
- prévoir un outil réutilisable comme substrat de moulage (2), où des premières zones d'îlot (5) et des deuxièmes zones d'îlot (6) voisines associées respectives sont formées sur une surface (3) de l'outil réutilisable, qui agit comme une structure négative pour une structure de couvercle, où entre les premières zones d'îlot (5) et les deuxièmes zones d'îlot (6) voisines associées respectives est prévue une cavité dans la plaquette réutilisable;
- disposer des bandes semi-conductrices (11) respectivement dans la cavité (7) entre une première zone d'îlot (5) et la deuxième zone d'îlot (6) voisine associée, de sorte que les bandes semi-conductrices (11) recouvrent par leurs surfaces au moins partiellement des faces latérales respectives des zones d'îlot (5, 6) de manière perpendiculaire au substrat de recouvrement (4), et que les bandes semi-conductrices (11) se fassent face par rapport à la cavité (7) et qu'entre les bandes semi-conductrices (11) soit formée une distance qui correspond à une cavité restante (7);
- disposer un substrat de recouvrement (4) sur les zones d'îlot (5, 6) de l'outil réutilisable, où le substrat de recouvrement (4) présente un matériau de verre;
dans lequel la surface (3) de l'outil réutilisable est assemblée au moins partiellement en chevauchement avec une surface du substrat de recouvrement;
- recuire les substrats assemblés de sorte que soit provoquée une pénétration du matériau de verre du substrat de recouvrement (4) dans les cavités (7) entre les zones d'îlot (5, 6); et
- séparer le substrat de recouvrement recuit (4) du substrat de moulage (2) et éliminer les bandes semi-conductrices (11), pour obtenir le substrat de couvercle structuré (1) avec le substrat de recouvrement recuit (4) et un élément de fenêtre (8).

12. Procédé de fabrication d'un composant émetteur de rayonnement encapsulé au niveau de plaquette, aux étapes suivantes consistant à:
- fabriquer un substrat de couvercle structuré (1) selon le procédé selon la revendication 1 ou le procédé selon la revendication 5 ou le procédé selon la revendication 11;
- prévoir un substrat de composant (16) sous forme d'une plaquette avec une pluralité de composants émetteurs de rayonnement (17);
- disposer les substrats l'un sur l'autre de sorte que les substrats soient assemblés le long d'un cadre d'assemblage intermédiaire (15); et
- séparer les éléments émetteurs de rayonnement encapsulés, où une ligne de séparation a été formée par les deuxièmes zones d'îlot (6) dans le substrat de recouvrement structuré (1).

13. Composant émetteur de rayonnement encapsulé, aux caractéristiques suivantes:
- un élément émetteur de rayonnement (17) disposé sur un substrat d'élément (16); et
- un substrat de couvercle (1) qui prévoit une cavité hermétiquement étanche pour le composant émetteur de rayonnement (17) à l'intérieur duquel est encapsulé le composant émetteur de rayonnement (17), où le substrat de couvercle (1) présente dans une face latérale une fenêtre de désaccouplage optique en un matériau perméable au rayonnement du composant émetteur de rayonnement (17), où la fenêtre de désaccouplage optique du substrat de couvercle (1) et le composant émetteur de rayonnement (17) sont disposés l'un par rapport à l'autre de sorte que le rayonnement émis lors du fonctionnement du composant émetteur de rayonnement (17) sorte du boîtier dans une direction de rayonnement parallèle à la surface du substrat de composant (16) et/ou perpendiculaire à la face latérale du substrat de couvercle (1),
**caractérisé par le fait que** la fenêtre de désaccouplage optique (8) est réalisée en un premier matériau de verre et que le substrat de couvercle (1) est réalisé en un deuxième matériau de verre, et le deuxième matériau de verre présentant une viscosité inférieure à celle du premier matériau de verre, et le matériau de verre du substrat de couvercle (1) et le matériau de verre des éléments de fenêtre (8) étant assemblés pour former une seule pièce.

14. Composant émetteur de rayonnement encapsulé selon la revendication 13, dans lequel le substrat de couvercle (1) présente un ou plusieurs segments de paroi plans comme face latérale, de sorte qu'un segment de paroi plan présente la fenêtre de désaccouplage optique ou que la fenêtre de désaccouplage optique forme un segment de paroi plan du substrat de couvercle (1).

15. Composant émetteur de rayonnement encapsulé selon l'une des revendications 13 ou 14, dans lequel un banc optique (24) est monté, du côté du substrat de composant (16), devant la fenêtre de désaccouplage optique, de sorte que la fenêtre de désaccouplage optique soit disposée entre le banc optique (24) et le composant émetteur de rayonnement (17).
